# EUROPEAN PATENT SPECIFICATION

(11) **EP 4 228 124 B1**
(45) Date of publication and mention of the grant of the patent: **25.11.2026**
(21) Application number: 21896391.6
(22) Date of filing: 03.08.2021
(51) Int. Cl.: H02J 50/60

(54) **WIRELESS CHARGING DEVICE, CHARGING BASE AND FOREIGN OBJECT DETECTION METHOD**
DRAHTLOSE LADEVORRICHTUNG, LADEBASIS UND FREMDKÖRPERDETEKTIONSVERFAHREN
DISPOSITIF DE CHARGE SANS FIL, BASE DE CHARGE ET PROCÉDÉ DE DÉTECTION D'OBJET ÉTRANGER

(30) Priority: 25.11.2020 CN 202011338197
(43) Date of publication of application: 16.08.2023
(73) Proprietor: Huawei Digital Power Technologies Co., Ltd., Shenzhen, Guangdong 518043 (CN)
(72) Inventor: WU, Baoshan, Shenzhen, Guangdong 518129 (CN); WU, Donghao, Shenzhen, Guangdong 518129 (CN)
(74) Representative: Pfenning, Meinig & Partner mbB
(86) International application number: PCT/CN2021/110254
(87) International publication number: WO 2022/110884

(56) References cited:
- EP-A1- 3 553 916
- WO-A1-2018/194409
- WO-A1-2020/015746
- WO-A1-2020/015749
- WO-A1-2020/101767
- CN-A- 105 334 539
- CN-A- 110 168 859
- CN-A- 111 052 541
- CN-A- 112 583 141
- US-A1- 2012 001 493
- US-A1- 2019 326 786
- US-A1- 2020 235 612
- US-B2- 9 530 558

## Description

### TECHNICAL FIELD

This application relates to the field of wireless charging technologies, and in particular, to a wireless charging device, a wireless charging cradle, and a foreign object detection method.

### BACKGROUND

In a wireless charging technology (wireless charging technology, WCT), a conduction medium such as an electric field, a magnetic field, a microwave, or a laser is used to wirelessly transmit electric energy. The wireless charging technology has advantages such as no wire restriction and no plugging, and therefore is increasingly widely used in electronic devices. Currently, an increasing quantity of electronic devices use wireless charging devices for charging. For example, the electronic device may be a mobile phone or a wearable device. The wireless charging device includes a transmitter coil, and the electronic device includes a receiver coil. Electric energy is wirelessly transmitted between the transmitter coil and the receiver coil through electromagnetic field coupling.

A principle of the wireless charging technology is to transmit electric energy through magnetic field coupling between the transmitter coil at a transmit end and the receiver coil at a receive end. For example, for wireless charging of the mobile phone, the wireless charging device is a wireless charger, and the electronic device is the mobile phone. The transmitter coil is located in the wireless charger, and the receiver coil is located inside the mobile phone. However, when there is a metal foreign object between the transmitter coil and the receiver coil, a changing magnetic field between the transmitter coil and the receiver coil generates an eddy current loss and heat in the metal foreign object, and further causes safety problems such as overheating or even fire. Therefore, foreign object detection (FOD, Foreign Object Detection) is a technical problem that needs to be considered in the wireless charging technology. Currently, widely used FOD methods include a power loss method (Ploss, Power loss method) and a Q value method. The Ploss method is a foreign object detection method defined by the Wireless Charging Consortium (WPC, Wireless Power Consortium) in the Qi protocol. When a Ploss is used to detect a foreign object, the Ploss is related to an alternating current impedance of the transmitter coil. Therefore, the Ploss is obtained based on the alternating current impedance of the transmitter coil. In addition, in the Q value method, a current Q value is obtained, and the current Q value is compared with a Q value threshold to determine whether there is a foreign object. There is a linear conversion relationship between the Q value and the alternating current impedance.

However, a current foreign object detection technology does not consider impact of a relative location between the transmit end and the receive end, and currently, no method for accurately obtaining the relative location between the transmit end and the receive end is provided.

WO 2020/015749 A1 discloses a wireless power system including a wireless power transmitter and a wireless power receiver. The wireless power transmitter has a drive circuit including an inverter that drives a transmit coil through a matching network. The wireless power transmitter may include a regulated voltage source that provides a regulated DC voltage to the inverter. The regulated voltage source produces a regulated DC output voltage in response to control stimulus from a controller. The controller is configured to measure Q-factor of the system to produce a Q-factor measurement, receive a reference Q-factor of the wireless power receiver and determine whether a foreign object is present by a comparison of the reference Q-factor and the Q-factor measurement. The matching network(s) may have one or more capacitive or inductive elements or any suitable combination of capacitive and inductive elements.

### SUMMARY

To resolve the foregoing technical problem, this application provides a wireless charging device, a charging cradle, and a foreign object detection method, to detect a foreign object and ensure accuracy of a detection result. The invention is set out in the appended set of claims.

An embodiment of this application provides a wireless charging device. An implementation type of the wireless charging device is not specifically limited. For example, the wireless charging device may be a wireless charger. The wireless charging device is configured to wirelessly charge an electronic device. The electronic device may be a device that can be wirelessly charged, such as a mobile phone, a tablet, or a watch. Generally, foreign object detection is performed by the wireless charging device. The wireless charging device includes a resonant network, an inverter circuit, and a controller. The resonant network includes a resonant capacitor and a transmitter coil. An input of the inverter circuit is configured to connect to a direct current power supply, and an output of the inverter circuit is configured to connect to the resonant network. Therefore, the controller of the wireless charging device receives an electronic device parameter sent by the electronic device. The electronic device parameter is a parameter prestored in the electronic device. The controller is configured to: fit a deviation relationship between a Q value of the wireless charging device and a location space based on a wireless charging device parameter and the electronic device parameter. The wireless device parameter herein is a parameter prestored in a wireless device. The location space is location space between the transmitter coil and a receiver coil of the electronic device. The electronic device parameter includes a Q1 value of the wireless charging device and a resonance frequency f1 of the resonant network when there is no foreign object at at least one relative location between the transmitter coil and the receiver coil. The wireless charging device parameter includes an initial Q value Q0 of the wireless charging device and an initial resonance frequency f0 of the resonant network when the wireless charging device and the electronic device are in an uncoupled state. The relative location between the transmitter coil and the receiver coil is the location deviation between the center of the transmitter coil and the center of the receiver coil, and the deviation relationship is a correspondence between the Q value and the horizontal relative location and the vertical relative location between the transmitter coil and the receiver coil. The controller is configured to perform foreign object detection based on the fitted deviation relationship. The uncoupled state herein means that there is no magnetic field coupling between the transmitter coil and the receiver coil, and no energy is transmitted between the transmitter coil and the receiver coil. In other words, the transmitter coil and the receiver coil are far away from each other.

Because a Q value threshold is related to the relative location, and different relative locations correspond to different Q value thresholds, for more accurate foreign object detection, a fixed Q value threshold cannot be used to perform foreign object detection. The wireless charging device provided in this embodiment of this application does not need to store a correspondence between the Q value and an entire location space. Similarly, the wireless charging device does not need to store a correspondence between an alternating current impedance of the transmitter coil and the entire location space either. The wireless charging device may obtain the correspondence between the Q value and the entire location space through fitting based on only a limited quantity of prestored parameters and a limited quantity of prestored parameters received from the electronic device, to obtain a corresponding Q value threshold based on an actual relative location based on the fitted deviation relationship, and perform foreign object detection based on the Q value threshold corresponding to the current relative location. In this embodiment of this application, linearization of the Q value threshold is implemented. Because the electronic device parameter is received from the electronic device during fitting the deviation relationship, different electronic devices have different fitting deviation relationships. This implements normalization of different electronic devices. Therefore, the wireless charging device provided in this embodiment of this application not only can accurately detect a foreign object, but also does not need to store a large amount of data. This reduces requirements for hardware performance and storage space. This application is applicable to a plurality of different electronic devices provided that the electronic devices support wireless charging.

In a possible implementation, the controller may perform foreign object detection before wireless charging, that is, obtain a Q value threshold based on the deviation relationship, and perform Q value foreign object detection based on the Q value threshold before the wireless charging device charges the electronic device.

The controller performs foreign object detection in a wireless charging process, to be specific, obtain the Q value threshold based on the deviation relationship, and obtain a corresponding alternating current impedance based on the Q value threshold and a correspondence between the Q value and the alternating current impedance of the transmitter coil; and perform Ploss foreign object detection based on the obtained alternating current impedance in a process in which the wireless charging device charges the electronic device. The correspondence may be a proportional relationship or a linear proportional relationship. In addition, the correspondence may be a variation of a proportional relationship. This is not limited in this embodiment of this application. Because there is a corresponding mapping relationship between the Q value and the alternating current impedance, the corresponding alternating current impedance may be obtained based on the obtained Q value threshold, and the deviation relationship between the alternating current impedance and the entire location space does not need to be fitted.

In this embodiment of this application, the wireless charging device may perform foreign object detection before charging and foreign object detection in a charging process based on the fitted deviation relationship, or may perform foreign object detection only before charging, or may perform foreign object detection only in the charging process.

In a possible implementation, the deviation relationship includes a vertical relationship between a plane on which the transmitter coil is located and a plane on which the receiver coil is located. The controller fits the vertical relationship between the Q value and the location space based on f0, Q0, the Q1 value, and f1, obtains the Q value threshold based on the vertical relationship, and obtains the corresponding alternating current impedance based on the Q value threshold and the correspondence between the Q value and the alternating current impedance of the transmitter coil. When the deviation relationship includes only the vertical relationship, this is especially applicable to a scenario in which there is no deviation between the transmitter coil and the receiver coil in a radial direction, or the deviation may be ignored. Only impact of a vertical relative location on the Q value threshold and the alternating current impedance is considered. For example, for a wireless charging device with a positive alignment function, the transmitter coil may be moved to align with the receiver coil in the radial direction.

The electronic device parameter includes the following Q1 values and f1 at at least two relative locations between the transmitter coil and the receiver coil: Q11 and f11 at a first location, and Q12 and f12 at a second location. The deviation relationship includes a radial horizontal relationship between the transmitter coil and the receiver coil and a vertical relationship between a plane on which the transmitter coil is located and a plane on which the receiver coil is located. The controller fits the horizontal relationship between the Q value and the location space based on Q11, f11, Q12, and f12; fits the vertical relationship between the Q value and the location space in any one of the following manners: fitting the vertical relationship between the Q value and the location space based on f0, Q0, Q11, and f11; fitting the vertical relationship between the Q value and the location space based on f0, Q0, Q12, and f12; or fitting the vertical relationship between the Q value and the location space based on Q0, f0, and Q and f that correspond to at least one point in the horizontal relationship; and obtains the Q value threshold based on the horizontal relationship and the vertical relationship, and obtains the corresponding alternating current impedance based on the Q value threshold and the correspondence between the Q value and the alternating current impedance of the transmitter coil.

Alternative, a prestored coupling parameter is added to the fitted deviation relationship in this embodiment. It should be understood that the prestored coupling parameter is prestored, and is not obtained through online testing in a corresponding coupled state during charging. The deviation relationship includes a radial horizontal relationship between the transmitter coil and the receiver coil and a vertical relationship between a plane on which the transmitter coil is located and a plane on which the receiver coil is located. The electronic device parameter further includes a prestored coupling parameter when there is no foreign object at the at least one relative location between the transmitter coil and the receiver coil. The prestored coupling parameter includes at least one of the following: a coupling coefficient and a mutual inductance between the transmitter coil and the receiver coil. The controller fits the vertical relationship between the Q value and the location space based on f0, Q0, and the Q value and f at the at least one relative location between the transmitter coil and the receiver coil, fits the horizontal relationship between the Q value and the location space based on the prestored coupling parameter and the Q value at the at least one relative location between the transmitter coil and the receiver coil, obtains the Q value threshold based on the vertical relationship and the horizontal relationship, and obtains the corresponding alternating current impedance based on the Q value threshold and the correspondence between the Q value and the alternating current impedance of the transmitter coil.

Alternatively, prestored coupling parameters of two relative locations are added, so that the fitted deviation relationship is more accurate. It should be understood that the prestored coupling parameter is prestored, and is not obtained through online testing in the corresponding coupled state during charging. The electronic device parameter includes the following Q1 values and f1 at at least two relative locations between the transmitter coil and the receiver coil: Q11 and f11 at a first location, and Q12 and f12 at a second location. The deviation relationship includes a radial horizontal relationship between the transmitter coil and the receiver coil and a vertical relationship between a plane on which the transmitter coil is located and a plane on which the receiver coil is located. The electronic device parameter further includes a prestored coupling parameter at the first location and a prestored coupling parameter at the second location. The prestored coupling parameter includes at least one of the following: a coupling coefficient and a mutual inductance between the transmitter coil and the receiver coil. The controller fits the horizontal relationship between the Q value and the location space based on Q11, Q12, the prestored coupling parameter at the first location, and the prestored coupling parameter at the second location; fits the vertical relationship between the Q value and the location space in any one of the following manners: fitting the vertical relationship between the Q value and the location space based on f0, Q0, Q11, and f11; fitting the vertical relationship between the Q value and the location space based on f0, Q0, Q12, and f12; or fitting the vertical relationship between the Q value and the location space based on Q0, f0, and Q and f that correspond to at least one point in the horizontal relationship; and obtains the Q value threshold based on the vertical relationship and the horizontal relationship, and obtains the corresponding alternating current impedance based on the Q value threshold and the correspondence between the Q value and the alternating current impedance of the transmitter coil.

In a possible implementation, when the deviation relationship includes only the vertical relationship, this is particularly applicable to the following technical solution. The controller obtains the Q value threshold based on the vertical relationship and a resonance frequency of the resonant network or a self-inductance of the transmitter coil at a current relative location between the wireless charging device and the electronic device, and obtains the corresponding alternating current impedance based on the Q value threshold and the correspondence between the Q value and the alternating current impedance of the transmitter coil.

The following describes a specific implementation of obtaining the Q value threshold based on the deviation relationship.

In a possible implementation, the controller obtains a coupling parameter and a self-inductance L1 of the transmitter coil when the wireless charging device and the electronic device are in a coupled state, where the coupling parameter in the coupled state includes at least one of the following: a coupling coefficient and a mutual inductance between the transmitter coil and the receiver coil; and obtains the Q value threshold based on the coupling parameter in the coupled state and L1 by using the deviation relationship, and obtains the corresponding alternating current impedance based on the Q value threshold and the correspondence between the Q value and the alternating current impedance of the transmitter coil. There is a monotonic relationship between the coupling parameter in the coupled state and the horizontal relationship. There is a monotonic relationship between L1 and the vertical relationship. It should be understood that the coupling parameter herein is a coupling parameter obtained through online testing, and is not a prestored coupling parameter.

In a possible implementation, the controller is specifically configured to: receive a self-inductance L2 that is of the receiver coil when the wireless charging device and the electronic device are in the coupled state and that is sent by the electronic device, and obtain the coupling parameter in the coupled state based on a current of the transmitter coil, the self-inductance L1 of the transmitter coil in the coupled state, L2, and a rectified voltage corresponding to the receiver coil.

In a possible implementation, the controller is specifically configured to: receive a self-inductance L20 that is of the receiver coil when the wireless charging device and the electronic device are in the uncoupled state and that is sent by the electronic device, obtain the self-inductance L2 of the receiver coil in the coupled state based on the self-inductance L1 of the transmitter coil in the coupled state, a self-inductance L10 of the transmitter coil in the uncoupled state, and L20, and obtain the coupling parameter in the coupled state based on L1, L2, and a rectified voltage corresponding to the receiver coil. Generally, there is a preset proportional relationship between the self-inductance of the transmitter coil and the self-inductance of the receiver coil. For example, a controller 32 may obtain the self-inductance L2 of the receiver coil in the coupled state based on the self-inductance L10 of the transmitter coil when the transmit end is in the uncoupled state, a self-inductance L1 of the transmitter coil in the coupled state, L20, and the preset proportional relationship. In this case, the electronic device does not need to obtain L2, and only needs to obtain L20.

In a possible implementation, the controller is further configured to: receive a self-inductance L3 that is of an auxiliary coil when the wireless charging device and the electronic device are in the coupled state and that is sent by the electronic device, and obtain the coupling parameter in the coupled state based on a current of the transmitter coil, the self-inductance L1 of the transmitter coil in the coupled state, L3, and a rectified voltage corresponding to the auxiliary coil.

In a possible implementation, the controller is further configured to: receive a self-inductance L30 that is of an auxiliary coil when the wireless charging device and the electronic device are in the uncoupled state and that is sent by the electronic device, obtain a self-inductance L3 of the auxiliary coil in the coupled state based on the self-inductance L1 of the transmitter coil in the coupled state, a self-inductance L10 of the transmitter coil in the uncoupled state, and L30, and obtain the coupling parameter in the coupled state based on L1, L3, and a rectified voltage corresponding to the auxiliary coil. Generally, there is a preset proportional relationship between the self-inductance of the transmitter coil and the self-inductance of the auxiliary coil. Therefore, the controller may obtain the self-inductance L3 of the auxiliary coil in the coupled state based on the self-inductance L10 of the transmitter coil in the uncoupled state, a self-inductance L1 of the transmitter coil in the coupled state, L30, and the preset proportional relationship. In this case, the electronic device does not need to obtain L3, and only needs to obtain L30.

In a possible implementation, the controller is further configured to obtain the coupling parameter obtained when the wireless charging device and the electronic device are in the coupled state, and is specifically configured to perform Ploss foreign object detection based on the alternating current impedance and the coupling parameter in the coupled state. After a coupling coefficient k is obtained, a power loss corresponding to the current coupling coefficient k may be accurately calculated online. Higher precision indicates higher applicable wireless charging power. Therefore, wireless charging with higher power can be supported.

In a possible implementation, the wireless charging device further includes: a current detection circuit of the transmitter coil, configured to detect a voltage difference between two ends of the resonant capacitor, and the controller, configured to obtain the current of the transmitter coil based on the voltage difference.

To obtain the current of the transmitter coil more accurately when the inverter circuit is a full bridge circuit, in a possible implementation, the current detection circuit includes a first voltage detection circuit, a second voltage detection circuit, and a differential circuit. The first voltage detection circuit is configured to detect a first voltage at a first end of the resonant capacitor, divide the first voltage, and send a divided first voltage to a first input of the differential circuit. The second voltage detection circuit is configured to detect a second voltage at a second end of the resonant capacitor, divide the second voltage, and send a divided second voltage to a second input of the differential circuit. The differential circuit is configured to obtain a differential result of the voltage input at the first input and the voltage input at the second input. The controller is configured to obtain the current of the transmitter coil based on the differential result. In other words, in this embodiment, to more accurately obtain the current of the transmitter coil connected to a full bridge inverter circuit, a sampling form of the differential circuit is used.

In a possible implementation, the controller is further configured to: determine a horizontal relative location and a vertical relative location between the transmitter coil and the receiver coil based on the self-inductance of the transmitter coil and the coupling parameter, and move the transmitter coil based on the horizontal relative location, so that the transmitter coil is aligned with the receiver coil. There is a monotonic relationship between the self-inductance of the transmitter coil and the vertical relative location. There is a monotonic relationship between the coupling parameter and the horizontal relative location.

In a possible implementation, the controller is specifically configured to: obtain two horizontal relative locations corresponding to two different relative locations between the wireless charging device and the electronic device, obtain a first circumference and a second circumference that respectively use the two horizontal relative locations as radiuses, obtain an intersection point of the first circumference and the second circumference, and control the transmitter coil to be aligned with the intersection point.

In a possible implementation, the controller is further configured to: move the transmitter coil to a third location, where the third location is different from the two different relative locations; obtain at least one of the following parameters in a movement process; and determine, based on a change trend of the at least one parameter, that the transmitter coil is aligned with the intersection point. The at least one parameter includes the coupling parameter, charging efficiency, the self-inductance of the transmitter coil, the current of the transmitter coil, and an output voltage of a receive end.

In a possible implementation, the controller is specifically configured to: control the transmitter coil to move to a fourth location, where the fourth location and the two different relative locations are not in a same straight line; obtain a self-inductance of the transmitter coil and a coupling parameter that correspond to the fourth location; determine the horizontal relative location and the vertical relative location based on the self-inductance of the transmitter coil and the coupling parameter that correspond to the fourth location; determine a third circumference based on the horizontal relative location; and control the transmitter coil to move to a common point between the third circumference and the intersection point. According to the alignment manner provided above, alignment between the transmitter coil and the receiver coil can be implemented with a small quantity of movement times. After the transmitter coil is aligned with the receiver coil, only an error caused by a vertical relative deviation needs to be considered during foreign object detection. The horizontal relative location has been eliminated.

In a possible implementation, the wireless charging device further includes an alignment mechanism. The controller is configured to control the alignment mechanism to drive the transmitter coil, so that the transmitter coil is aligned with the receiver coil. A specific implementation form of the alignment mechanism is not limited in this embodiment of this application.

In a possible implementation, after the transmitter coil is aligned with the receiver coil, the controller is further configured to: obtain the Q value threshold based on the deviation relationship and the self-inductance of the transmitter coil, and obtain the corresponding alternating current impedance based on the Q value threshold and a proportional relationship between the Q value and the alternating current impedance of the transmitter coil; and perform Q value foreign object detection based on the Q value threshold before the wireless charging device charges the electronic device or perform Ploss foreign object detection based on the alternating current impedance and the coupling parameter in the coupled state in the process in which the wireless charging device charges the electronic device.

In a possible implementation, Ploss foreign object detection is performed based on the alternating current impedance and the coupling parameter in the coupled state. A power loss of wireless charging is specifically obtained by using the following formula: ${P}_{tx loss} = f \left(Vin\right) + f \left(TxACR, k, I1\right)$ $f \left(TxACR,k,I1\right) = \left(a+TxACR∗f\left(k\right)\right) ∗ I {1}^{2} + b ∗ I 1 + c .$

Vin is a bus voltage of the inverter circuit. TxACR is the alternating current impedance ACR of the transmitter coil. I1 is the current of the transmitter coil. a. b, c, and d are known parameters of the wireless charging device. In this embodiment, a new parameter, that is, the coupling parameter in the coupled state, is introduced during Ploss foreign object detection. An accurate coefficient k may be obtained based on the coupling parameter, to obtain accurate power consumption, and further perform accurate foreign object detection. When a foreign object detection result is more accurate, foreign object detection corresponding to higher wireless charging power is applicable.

An embodiment of this application further provides a wireless charging cradle, configured to wirelessly charge an electronic device. The wireless charging cradle includes a power interface, a resonant network, an inverter circuit, a controller, and a transmitter coil chassis. The power interface is configured to connect a direct current transmitted by an adapter. The resonant network includes a resonant capacitor and a transmitter coil. The transmitter coil chassis is configured to place the transmitter coil. An input of the inverter circuit is configured to connect to the power interface, and an output of the inverter circuit is configured to connect to the resonant network. The controller is configured to: receive an electronic device parameter sent by the electronic device, and fit a deviation relationship between a Q value of the wireless charging device and a location space based on a wireless charging device parameter and the electronic device parameter. The location space is location space between the transmitter coil and a receiver coil of the electronic device. The electronic device parameter includes a Q1 value of the wireless charging device and a resonance frequency f1 of the resonant network when there is no foreign object at at least one relative location between the transmitter coil and the receiver coil. The wireless charging device parameter includes an initial Q value Q0 of the wireless charging device and an initial resonance frequency f0 of the resonant network when the wireless charging device and the electronic device are in an uncoupled state. The relative location between the transmitter coil and the receiver coil is the location deviation between the center of the transmitter coil and the center of the receiver coil, and the deviation relationship is a correspondence between the Q value and the horizontal relative location and the vertical relative location between the transmitter coil and the receiver coil. The controller is further configured to perform foreign object detection based on the deviation relationship.

For example, the wireless charging cradle is a charging disk or a three-dimensional charging cradle. A specific geometric shape of the wireless charging cradle is not specifically limited in this embodiment of this application. When the wireless charging cradle charges the electronic device, the wireless charging cradle usually may be parallel to a horizontal plane, and the electronic device is placed on the wireless charging cradle. In addition, when the wireless charging cradle is vertical to the horizontal plane, the plane on which the electronic device is located needs to be parallel to a plane on which the wireless charging cradle is located, so that the transmitter coil is better coupled to the receiver coil.

In a possible implementation, the controller is specifically configured to: obtain a Q value threshold based on the deviation relationship, and perform Q value foreign object detection based on the Q value threshold before the wireless charging device charges the electronic device.

The controller is specifically configured to: obtain the Q value threshold based on the deviation relationship, obtain a corresponding alternating current impedance based on the Q value threshold and a correspondence between the Q value and the alternating current impedance of the transmitter coil, and perform Ploss foreign object detection based on the obtained alternating current impedance in a process in which the wireless charging device charges the electronic device.

The electronic device parameter includes the following Q1 values and f1 at at least two relative locations between the transmitter coil and the receiver coil: Q11 and f11 at a first location, and Q12 and f12 at a second location. The deviation relationship includes a radial horizontal relationship between the transmitter coil and the receiver coil and a vertical relationship between a plane on which the transmitter coil is located and a plane on which the receiver coil is located. The controller is specifically configured to: fit the horizontal relationship between the Q value and the location space based on Q11, f11, Q12, and f12; fit the vertical relationship between the Q value and the location space in any one of the following manners: fitting the vertical relationship between the Q value and the location space based on f0, Q0, Q11, and f11; fitting the vertical relationship between the Q value and the location space based on f0, Q0, Q12, and f12; or fitting the vertical relationship between the Q value and the location space based on Q0, f0, and Q and f that correspond to at least one point in the horizontal relationship; and obtain the Q value threshold based on the horizontal relationship and the vertical relationship, and obtain the corresponding alternating current impedance based on the Q value threshold and the correspondence between the Q value and the alternating current impedance of the transmitter coil.

Alternatively, the electronic device parameter includes the following Q1 values and f1 at at least two relative locations between the transmitter coil and the receiver coil: Q11 and f11 at a first location, and Q12 and f12 at a second location. The deviation relationship includes a radial horizontal relationship between the transmitter coil and the receiver coil and a vertical relationship between a plane on which the transmitter coil is located and a plane on which the receiver coil is located. The electronic device parameter further includes a prestored coupling parameter at the first location and a prestored coupling parameter at the second location. The prestored coupling parameter includes at least one of the following: a coupling coefficient and a mutual inductance between the transmitter coil and the receiver coil. The controller is specifically configured to: fit the horizontal relationship between the Q value and the location space based on Q11, Q12, the prestored coupling parameter at the first location, and the prestored coupling parameter at the second location; fit the vertical relationship between the Q value and the location space in any one of the following manners: fitting the vertical relationship between the Q value and the location space based on f0, Q0, Q11, and f11; fitting the vertical relationship between the Q value and the location space based on f0, Q0, Q12, and f12; or fitting the vertical relationship between the Q value and the location space based on Q0, f0, and Q and f that correspond to at least one point in the horizontal relationship; and obtain the Q value threshold based on the vertical relationship and the horizontal relationship, and obtain the corresponding alternating current impedance based on the Q value threshold and the correspondence between the Q value and the alternating current impedance of the transmitter coil.

An embodiment of this application further provides a foreign object detection method for wireless charging, applied to a wireless charging device. The wireless charging device includes a resonant network and an inverter circuit. The resonant network includes a resonant capacitor and a transmitter coil. An input of the inverter circuit is configured to connect to a direct current power supply, and an output of the inverter circuit is configured to connect to the resonant network. The method includes: receiving an electronic device parameter sent by an electronic device; fitting a deviation relationship between a Q value of the wireless charging device and a location space based on a wireless charging device parameter and the electronic device parameter, where the location space is location space between the transmitter coil and a receiver coil of the electronic device, the electronic device parameter includes a Q1 value of the wireless charging device and a resonance frequency f1 of the resonant network when there is no foreign object at at least one relative location between the transmitter coil and the receiver coil, and the wireless charging device parameter includes an initial Q value Q0 of the wireless charging device and an initial resonance frequency f0 of the resonant network when the wireless charging device and the electronic device are in an uncoupled state, wherein the relative location between the transmitter coil and the receiver coil is the location deviation between the center of the transmitter coil and the center of the receiver coil, and the deviation relationship is a correspondence between the Q value and the horizontal relative location and the vertical relative location between the transmitter coil and the receiver coil; and performing foreign object detection based on the deviation relationship.

In a possible implementation, the performing foreign object detection based on the deviation relationship specifically includes: obtaining a Q value threshold based on the deviation relationship, and performing Q value foreign object detection based on the Q value threshold before the wireless charging device charges the electronic device.

The performing foreign object detection based on the deviation relationship specifically includes: obtaining the Q value threshold based on the deviation relationship; obtaining a corresponding alternating current impedance based on the Q value threshold and a correspondence between the Q value and the alternating current impedance of the transmitter coil; and performing Ploss foreign object detection based on the obtained alternating current impedance in a process in which the wireless charging device charges the electronic device.

The electronic device parameter includes the following Q1 values and f1 at at least two relative locations between the transmitter coil and the receiver coil: Q11 and f11 at a first location, and Q12 and f12 at a second location. The deviation relationship includes a radial horizontal relationship between the transmitter coil and the receiver coil and a vertical relationship between a plane on which the transmitter coil is located and a plane on which the receiver coil is located. The fitting a deviation relationship between a Q value of the wireless charging device and a location space based on a wireless charging device parameter and the electronic device parameter specifically includes: fitting the horizontal relationship between the Q value and the location space based on Q11, f11, Q12, and f12; and fitting the vertical relationship between the Q value and the location space in any one of the following manners: fitting the vertical relationship between the Q value and the location space based on f0, Q0, Q11, and f11; fitting the vertical relationship between the Q value and the location space based on f0, Q0, Q12, and f12; or fitting the vertical relationship between the Q value and the location space based on Q0, f0, and Q and f that correspond to at least one point in the horizontal relationship. The obtaining the Q value threshold based on the deviation relationship specifically includes: obtaining the Q value threshold based on the horizontal relationship and the vertical relationship.

Alternatively, the deviation relationship includes a radial horizontal relationship between the transmitter coil and the receiver coil and a vertical relationship between a plane on which the transmitter coil is located and a plane on which the receiver coil is located. The electronic device parameter further includes a prestored coupling parameter when there is no foreign object at the at least one relative location between the transmitter coil and the receiver coil. The prestored coupling parameter includes at least one of the following: a coupling coefficient and a mutual inductance between the transmitter coil and the receiver coil. The fitting a deviation relationship between a Q value of the wireless charging device and a location space based on a wireless charging device parameter and the electronic device parameter specifically includes: fitting the vertical relationship between the Q value and the location space based on f0, Q0, and the Q value and f at the at least one relative location between the transmitter coil and the receiver coil, and fitting the horizontal relationship between the Q value and the location space based on the prestored coupling parameter and the Q value at the at least one relative location between the transmitter coil and the receiver coil. The obtaining the Q value threshold based on the deviation relationship specifically includes: obtaining the Q value threshold based on the vertical relationship and the horizontal relationship.

Alternatively, the electronic device parameter includes the following Q1 values and f1 at at least two relative locations between the transmitter coil and the receiver coil: Q11 and f11 at a first location, and Q12 and f12 at a second location. The deviation relationship includes a radial horizontal relationship between the transmitter coil and the receiver coil and a vertical relationship between a plane on which the transmitter coil is located and a plane on which the receiver coil is located. The electronic device parameter further includes a prestored coupling parameter at the first location and a prestored coupling parameter at the second location. The prestored coupling parameter includes at least one of the following: a coupling coefficient and a mutual inductance between the transmitter coil and the receiver coil. The fitting a deviation relationship between a Q value of the wireless charging device and a location space based on a wireless charging device parameter and the electronic device parameter specifically includes: fitting the horizontal relationship between the Q value and the location space based on Q11, Q12, the prestored coupling parameter at the first location, and the prestored coupling parameter at the second location; and fitting the vertical relationship between the Q value and the location space in any one of the following manners: fitting the vertical relationship between the Q value and the location space based on f0, Q0, Q11, and f11; fitting the vertical relationship between the Q value and the location space based on f0, Q0, Q12, and f12; or fitting the vertical relationship between the Q value and the location space based on Q0, f0, and Q and f that correspond to at least one point in the horizontal relationship. The obtaining the Q value threshold based on the deviation relationship specifically includes: obtaining the Q value threshold based on the vertical relationship and the horizontal relationship.

Compared with an existing technology, the technical solutions provided in embodiments of this application have the following advantages:
Because the Q value corresponds to different Q value thresholds at different relative locations of the transmitter coil and the receiver coil, a judgment result is affected when foreign object detection is performed based on the different Q value thresholds. In this embodiment of this application, impact of the relative location on the Q value threshold is considered, and foreign object detection is performed based on the Q value threshold corresponding to the relative location, so that a foreign object detection result can be more accurate. Because there is the correspondence between the Q value and the relative location, the corresponding Q value threshold may be obtained based on the relative location of the transmitter coil and the receiver coil. However, in an actual product, to reduce requirements for storage space and hardware performance, all corresponding values between the Q value and the relative location in an entire degree of freedom space may not need to be stored. In the technical solution provided in this embodiment of this application, the deviation relationship between the Q value and the entire location space is fitted based on a limited quantity of wireless charging device parameters and electronic device parameters, that is, a correspondence represented by fitting between the Q value and the horizontal relative location and the vertical relative location. Therefore, the controller obtains the deviation relationship between the Q value and the entire location space based on the Q1 value and the resonance frequency f1 when there is no foreign object at the at least one relative location of the transmitter coil and the receiver coil, the initial Q value Q0 in the uncoupled state, and the initial resonance frequency f0. After obtaining the deviation relationship between the Q value and the entire location space, the controller may perform foreign object detection at a current location by using the deviation relationship.

### BRIEF DESCRIPTION OF DRAWINGS

FIG. 1 is a schematic diagram of a wireless charging system according to an embodiment of this application;
FIG. 2 is a schematic diagram of a structure of the electronic device in FIG. 1;
FIG. 3 is a schematic circuit diagram of a wireless charging system according to an embodiment of this application;
FIG. 4 is an equipotential diagram in which an alternating current impedance of a transmitter coil varies with a relative location according to an embodiment of this application;
FIG. 5 is an equipotential diagram in which a Q value at a transmit end varies with a relative location when there is no foreign object according to an embodiment of this application;
FIG. 6 is a schematic diagram of a wireless charging device according to an embodiment of this application;
FIG. 7 is a schematic diagram of a relationship between a self-inductance L1 of a transmitter coil and a relative location according to an embodiment of this application;
FIG. 8 is a schematic diagram of a relationship between a coupling coefficient k and a relative location according to an embodiment of this application;
FIG. 9 is a schematic diagram of a relationship between a mutual inductance M and a relative location according to an embodiment of this application;
FIG. 10 is a schematic diagram of a wireless charging system according to an embodiment of this application;
FIG. 11 is a schematic diagram of a current detection circuit of a transmitter coil according to an embodiment of this application;
FIG. 12 is a schematic diagram of another current detection circuit of a transmitter coil according to an embodiment of this application;
FIG. 13 is a schematic diagram of another wireless charging device according to an embodiment of this application;
FIG. 14 is a schematic diagram of an alignment mechanism according to an embodiment of this application;
FIG. 15 is a schematic diagram of an alignment principle of a transmitter coil according to an embodiment of this application;
FIG. 16 is a schematic diagram of a wireless charging device with mechanical latching according to an embodiment of this application;
FIG. 17 is a schematic diagram of a wireless charging device with magnetic attachment alignment according to an embodiment of this application;
FIG. 18 is a flowchart of a foreign object detection method for wireless charging according to an embodiment of this application;
FIG. 19 is a flowchart of another foreign object detection method for wireless charging according to an embodiment of this application;
FIG. 20 is a flowchart of still another foreign object detection method for wireless charging according to an embodiment of this application;
FIG. 21 is a flowchart of yet another foreign object detection method for wireless charging according to an embodiment of this application;
FIG. 22 is a flowchart of a foreign object detection method before alignment according to an embodiment of this application;
FIG. 23 is a flowchart of a foreign object detection method with alignment according to an embodiment of this application; and
FIG. 24 is a schematic diagram of a wireless charging system according to an embodiment of this application.

### DESCRIPTION OF EMBODIMENTS

The following terms "first", "second", and the like are merely intended for a purpose of description, and shall not be understood as an indication or implication of relative importance or implicit indication of a quantity of indicated technical characteristics. Therefore, a feature limited by "first" or "second" may explicitly or implicitly include one or more features. In the descriptions of this application, unless otherwise stated, "a plurality of" means two or more than two.

In addition, in this application, orientation terms such as "up" and "down" may include but are not limited to orientations of schematically placed components in relative accompanying drawings. It should be understood that these orientation terms may be relative concepts. The orientation terms are used for relative description and clarification, and may vary correspondingly based on a change in an orientation in which the component is placed in the accompanying drawings.

In this application, unless otherwise specified and limited, the term "connection" should be understood in a broad sense. For example, the "connection" may be a fixed connection, a detachable connection, an integration, a direct connection, or an indirect connection by using an intermediate medium. In addition, a term "coupling" may be a manner of implementing an electrical connection for signal transmission. The "coupling" may be a direct electrical connection, or may be an indirect electrical connection through an intermediate medium.

A type of an electronic device is not specifically limited in embodiments of this application. The electronic device may be a wireless device such as a mobile phone (mobile phone), a pad (pad), a computer with a wireless transceiver function, a smart wearable product (for example, a smart watch, a smart band, or a headset), a virtual reality (virtual reality, VR) terminal device, or an augmented reality (augmented reality, AR) terminal device. The electronic device may alternatively be an electronic product such as a wireless charging electric vehicle, a wireless charging household appliance (such as a soymilk machine or a floor sweeping robot), or an uncrewed aerial vehicle.

To enable a person skilled in the art to better understand technical solutions provided in embodiments of this application, the following first describes an application scenario of wireless charging of the electronic device. An example in which the electronic device is a mobile phone is used for description.

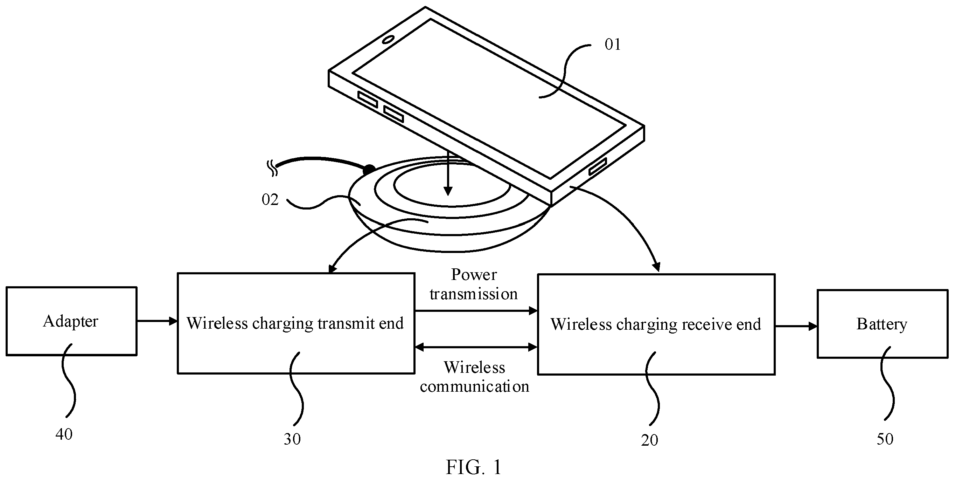

FIG. 1 is a schematic diagram of a wireless charging system according to an embodiment of this application.

When an electronic device is a mobile phone, a wireless charging device is a wireless charger 02. The wireless charger 02 is configured to wirelessly charge an electronic device 01 (namely, the mobile phone). The wireless charger 02 shown in the figure supports the electronic device 01 in being horizontally placed on the wireless charger 02. In some embodiments, the wireless charger 02 may alternatively be in another form, such as a vertical wireless charger, and is slightly inclined, so that the electronic device 01 can lean against the wireless charger 02.

The wireless charging system includes a wireless charging receive (Receive, RX) apparatus 20 disposed in the electronic device 01 and a battery 50 coupled to the wireless charging receive end 20.

The wireless charging system further includes a wireless charging transmit (transmit, TX) end 30 disposed in the wireless charger 02 and an adapter 40 coupled to the wireless charging transmit end 30. The adapter 40 is configured to provide charging electric energy.

The wireless charging transmit end 30 transmits power to the wireless charging receive end 20. A control signal or charging data may be transmitted between the wireless charging transmit end 30 and the wireless charging receive end 20. The control signal or the charging data may be transmitted through in-band communication or out-of-band communication. The wireless charging transmit end 30 and the wireless charging receive end 20 are wirelessly connected in an out-of-band communication manner such as Bluetooth (Bluetooth), Wireless-Fidelity (Wireless-Fidelity, Wi-Fi), Zigbee (Zigbee), radio frequency identification (Radio Frequency Identification, RFID), a long range (Long range, Lora) wireless technology, or near field communication (Near Field Communication, NFC), so that the wireless charging transmit end 30 and the wireless charging receive end 20 can implement wireless communication.

The charging data may indicate a charging type. In some embodiments, the charging data may be a charging protocol, for example, the wireless charging standard Qi proposed by the Wireless Power Consortium (Wireless Power Consortium, WPC), a BPP (Basic Power Profile) protocol, or an EPP (Extended Power Profile) protocol.

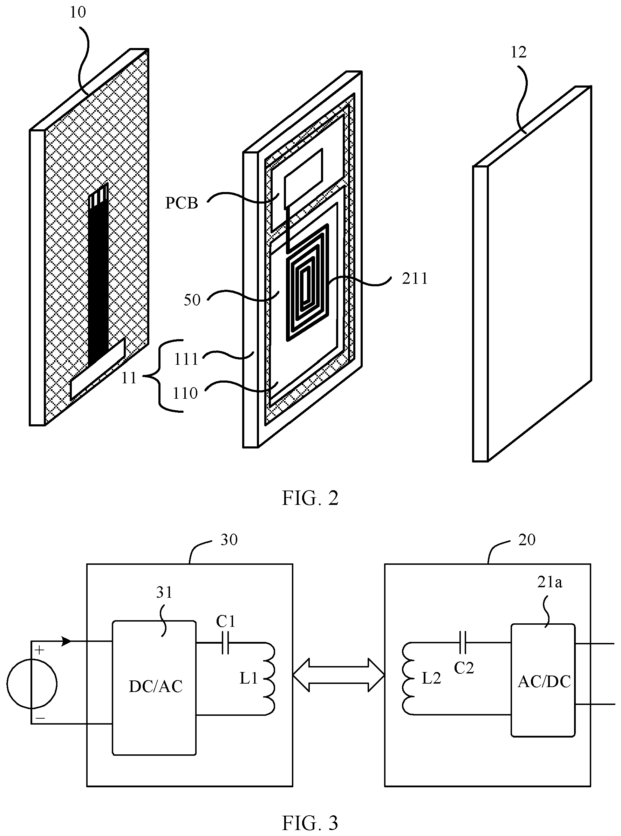

FIG. 2 is a schematic diagram of a structure of the electronic device in FIG. 1.

An example in which the electronic device 01 is a mobile phone is used, and the electronic device 01 mainly includes a display (Display Panel, DP) 10. The display 10 may be a liquid crystal display (Liquid Crystal Display, LCD), an organic light-emitting diode (Organic Light-Emitting Diode, OLED) display, or the like. When the mobile phone uses a folding screen architecture or a multi-screen architecture, the mobile phone may further include a plurality of screens. The plurality of screens may be a combination of the foregoing different types of screens. This is not limited in this application.

The electronic device 01 may further include a middle frame 11 and a housing 12. The display 10 and the housing 12 are respectively located on two sides of the middle frame 11. A back side of the display 10 faces the housing 12, and the display 10 is connected to the housing 12 through the middle frame 11. The middle frame 11 includes a bearing plate 110 and a bezel 111 surrounding the bearing plate 110. The electronic device 01 may further include a printed circuit board (Printed Circuit Board, PCB).

It should be noted that, in an actual product, a transmitter coil and a receiver coil are generally disposed in a disk shape.

The following describes a working principle of wireless charging with reference to the accompanying drawings.

FIG. 3 is a schematic circuit diagram of a wireless charging system according to an embodiment of this application.

A wireless charging transmit end 30 is configured to emit magnetic field energy. The wireless charging transmit end 30 may be located in a wireless charging device.

The wireless charging transmit end 30 includes an inverter circuit DC/AC 31. An input of the inverter circuit DC/AC 31 is configured to connect to a direct current power supply, for example, connect to a direct current output by an adapter. An output of the inverter circuit DC/AC 31 is connected to a resonant network. The resonant network includes a resonant capacitor C1 and a transmitter coil L1. An example in which the resonant capacitor C1 and the transmitter coil L1 are connected in series is used in this embodiment of this application.

A wireless charging receive end 20 is configured to receive the magnetic field energy emitted by the wireless charging transmit end 30. The wireless charging receive end 20 may be located in an electronic device.

The wireless charging receive end 20 includes a receiver coil L2, a capacitor C2, and a rectifier circuit AC/DC 21. The rectifier circuit AC/DC 21 converts an alternating current output by the receiver coil L2 into a direct current to charge a battery.

For ease of description, the wireless charging transmit end is briefly referred to as a transmit end and the wireless charging receive end is briefly referred to as a receive end in the following.

After converting input electric energy into magnetic field energy, the wireless charging device transmits the magnetic field energy through the wireless charging transmit end 30. When the electronic device is around the wireless charging device, the electronic device receives, through the wireless charging receive end 20, the magnetic field energy emitted by the wireless charging device, and converts the magnetic field energy into electric energy to charge the electronic device. In this way, wireless transmission of the electric energy from the wireless charging device to the electronic device is implemented.

When in-band communication is performed between the wireless charging device and the electronic device, a communicable area and a non-communicable area are included. When the electronic device is a mobile phone or a wearable device, the communicable area is generally that a plane location deviation between the transmitter coil and the receiver coil is within 10 mm, and a Z-direction distance is also within 10 mm. The Z-direction distance is a height distance between the wireless charging device and the electronic device. For example, when the transmitter coil is horizontally placed, and the receiver coil is horizontally placed, the Z-direction distance is a vertical distance between the transmitter coil and the receiver coil, and a Z-direction deviation is a vertical relative location. For example, when the transmitter coil is in a disk shape and the receiver coil is in a disk shape, and when the wireless charging device is horizontally placed, a plane on which the transmitter coil is located is parallel to a horizontal plane. When the mobile phone is horizontally placed on the wireless charging device, a plane on which the receiver coil is located is almost parallel to the plane on which the transmitter coil is located. Because both the transmitter coil and the receiver coil are in the disk shape, the plane location deviation between the transmitter coil and the receiver coil is a plane deviation between the center of the transmitter coil and the center of the receiver coil, namely, a radial deviation. The plane location deviation may also be referred to as a horizontal relative location.

During wireless charging, there may be a foreign object, for example, a metal foreign object, between the wireless charging device and the electronic device. A changing magnetic field generated between the transmitter coil and the receiver coil generates an eddy current loss and heat in the metal foreign object.

Therefore, FOD is a technical problem that needs to be considered in a wireless charging technology. Foreign object detection methods usually include a Ploss method and a Q value method. The Ploss method includes: obtaining an alternating current impedance of the transmitter coil based on a horizontal relative location and a vertical relative location; obtaining a power loss at the transmit end based on the alternating current impedance of the transmitter coil and a current of the transmitter coil in a charging process; obtaining transmit power based on input power at the transmit end and the power loss at the transmit end; obtaining a foreign object loss based on the transmit power and receive power at the receive end; and when the foreign object loss is greater than a power threshold, determining that there is a foreign object between the transmit end and the receive end.

During wireless charging, there is a monotonic relationship between a Q value and a location deviation, and there is also a monotonic relationship between a Ploss and the location deviation. The following provides detailed descriptions with reference to the accompanying drawings.

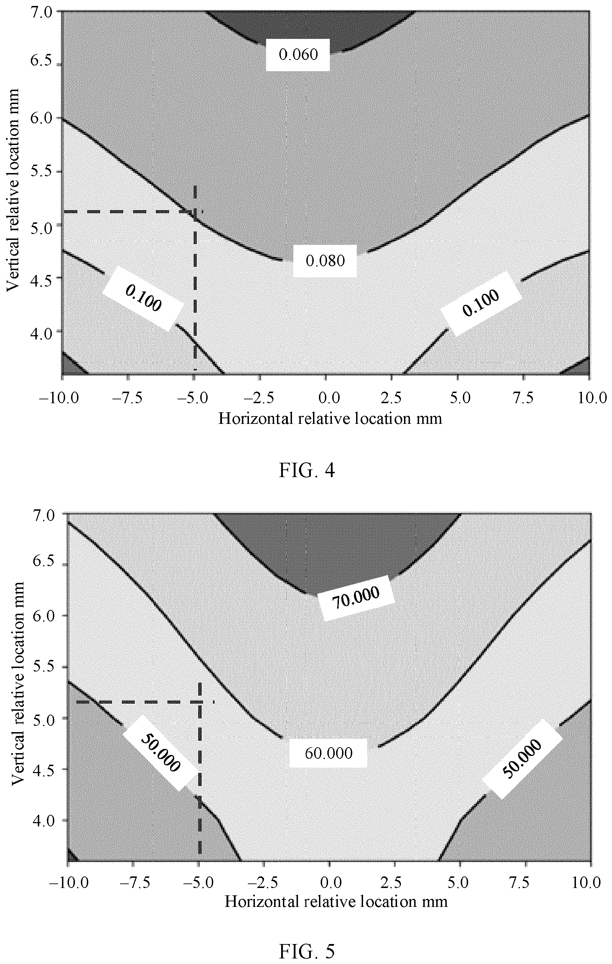

FIG. 4 is an equipotential diagram in which the alternating current impedance of the transmitter coil varies with a relative location according to an embodiment of this application.

A horizontal axis indicates a horizontal relative location (unit: millimeter), and a vertical axis indicates a vertical relative location (unit: millimeter). An intersection point of dashed lines in the figure is a known horizontal relative location and a known vertical relative location, and an alternating current impedance of the transmitter coil is determined when there is no foreign object between the transmit end and the receive end 102. It can be seen from the figure that a relative location between the transmit end and the receive end 102 affects the alternating current impedance of the transmitter coil.

FIG. 5 is an equipotential diagram in which a Q value at the transmit end varies with a relative location when there is no foreign object according to an embodiment of this application.

A horizontal axis indicates the horizontal relative location (unit: millimeter), and a vertical axis indicates the vertical relative location (unit: millimeter). An intersection point of dashed lines in the figure is a known horizontal relative location and a known vertical relative location, and the Q value at the transmit end is determined when there is no foreign object between the transmit end and the receive end. It can be seen from the figure that when there is no foreign object between the transmit end and the receive end, different relative locations correspond to different Q values at the transmit end.

It can be learned from FIG. 4 and FIG. 5 that both the Q value and the alternating current impedance have a monotonic relationship with the relative location. If the transmitter coil and the receiver coil are not aligned, in other words, the location deviation exists, standards of performing foreign object detection by using the Q value and the Ploss change. If impact caused by the location deviation is ignored, foreign object detection may be inaccurate regardless of whether the Q value or the Ploss is used for foreign object detection. Therefore, to resolve a problem of inaccurate foreign object detection caused by the location deviation, FOD needs to be performed based on a Q value threshold corresponding to a current location to accurately detect the foreign object. Similarly, the Ploss needs to be calculated based on an alternating current impedance corresponding to the current location, and FOD needs to be performed based on a unified Ploss threshold to accurately detect the foreign object.

Generally, for foreign object detection of the wireless charging system, the wireless charging device performs foreign object detection by using the Q value before charging the electronic device, and performs foreign object detection by using the Ploss in a process in which the wireless charging device charges the electronic device. There is a correspondence between the Q value and the alternating current impedance of the transmitter coil, for example, there is a proportional relationship between the Q value and the alternating current impedance. The following uses an example in which there is a linear proportional relationship between the Q value and the alternating current impedance for description. Certainly, the linear proportional relationship may alternatively be another representation form of the proportional relationship. Generally, the Q value may be first obtained, and then the alternating current impedance is obtained based on the linear proportional relationship between the Q value and the alternating current impedance of the transmitter coil. The following provides detailed descriptions with reference to a formula.

The Q value is defined in the following formula (1): $Q = \frac{2 πf \times {L}_{1}}{{R}_{tx acr}}$ where
*L*₁ is an inductance of the transmitter coil, *R_{tx acr}* is the alternating current impedance of the transmitter coil, and f is a resonance frequency of the resonant network of the wireless charging device.

It can be learned from the formula (1) that there is a conversion relationship between the Q value and the alternating current impedance of the transmitter coil. After the Q value is obtained, the alternating current impedance of the transmitter coil can be obtained according to the formula (1), and then Ploss foreign object detection is performed based on the alternating current impedance of the transmitter coil.

It should be noted that specific processes of performing foreign object detection by using the Q value and the Ploss are not described herein again. This embodiment of this application specifically describes a specific implementation of obtaining the Q value and the alternating current impedance of the transmitter coil.

It can be learned from FIG. 5 that there is a correspondence between the Q value and location space. However, during actual product implementation, generally, the correspondence between the Q value and the location space and a correspondence between the alternating current impedance of the transmitter coil and the location space are not stored in the wireless charging device in a form of a figure. For example, if a value table whose indexing value is 1 mm is used, for an electronic device of a specific model, a deviation range of a vertical relative location or a horizontal relative location is involved, and generally, hundreds of data amounts are involved. This imposes great pressure on hardware storage space and a controller processing capability. Therefore, to resolve the foregoing technical problem, an embodiment of this application provides a wireless charging device. The wireless charging device does not need to store the correspondence between the Q value and the entire location space, and similarly, does not need to store the correspondence between the alternating current impedance of the transmitter coil and the entire location space either. The wireless charging device can obtain, through fitting, the correspondence between the Q value and the entire location space only based on a limited quantity of parameters, thereby reducing requirements for hardware performance and storage space.

Embodiment 1 of the wireless charging device:

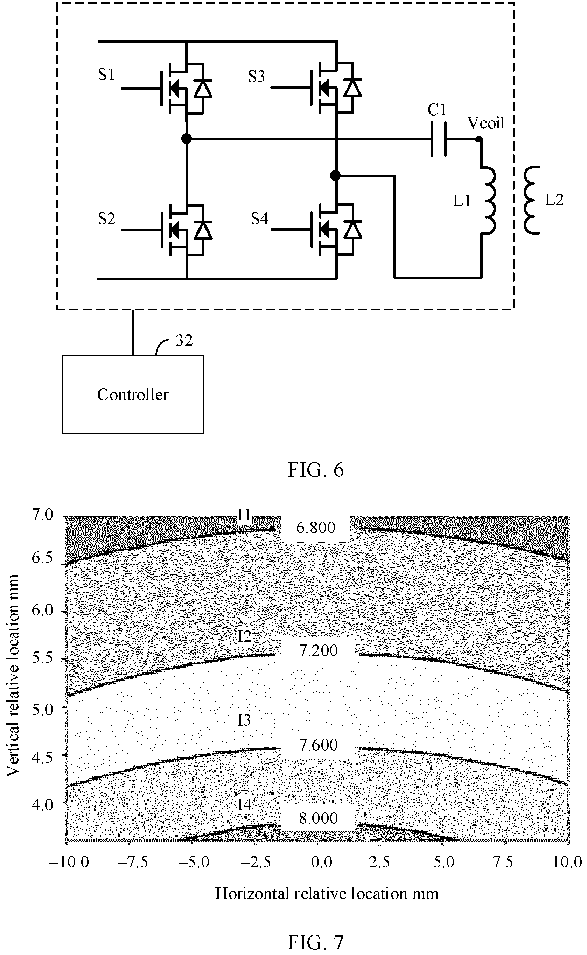

FIG. 6 is a schematic diagram of a wireless charging device according to an embodiment of this application.

The wireless charging device provided in this embodiment is configured to wirelessly charge an electronic device. The wireless charging device includes: a resonant network, an inverter circuit, and a controller 32.

The resonant network includes a resonant capacitor C1 and a transmitter coil L1. In this embodiment, an example in which the resonant capacitor C1 and the transmitter coil L1 are connected in series to form the resonant network is used for description.

An input of the inverter circuit is configured to connect to a direct current power supply, and an output of the inverter circuit is configured to connect to the resonant network.

In this embodiment, an example in which the inverter circuit is a full bridge circuit is used for description. The inverter circuit includes four controllable switch tubes, which are a first switch tube S1 to a fourth switch tube S4. As shown in FIG. 6, a first end of the first switch tube S1 is connected to a positive electrode of the direct current power supply, a second end of the first switch tube S1 is connected to a first end of the second switch tube S2, and a second end of the second switch tube S2 is connected to a negative electrode of the direct current power supply. That is, after being connected in series, S1 and S2 are connected between the positive electrode and the negative electrode of the direct current power supply. Similarly, a first end of the third switch tube S3 is connected to the positive electrode of the direct current power supply, a second end of the third switch tube S3 is connected to a first end of the fourth switch tube S4, and a second end of the fourth switch tube S4 is connected to the negative electrode of the direct current power supply. That is, after being connected in series, S3 and S4 are connected between the positive electrode and the negative electrode of the direct current power supply. The second end of S1 is connected to the second end of S3 through C1 and L1 that are connected in series.

L2 is a receiver coil of the electronic device. For example, if the electronic device is a mobile phone, the receiver coil L2 is located inside the mobile phone.

The controller 32 is configured to: receive an electronic device parameter sent by the electronic device, and fit a deviation relationship between a Q value of the wireless charging device and a location space based on a wireless charging device parameter and the electronic device parameter. The location space is location space between the transmitter coil and the receiver coil of the electronic device. The electronic device parameter includes a Q1 value of the wireless charging device and a resonance frequency f1 of the resonant network when there is no foreign object at at least one relative location between the transmitter coil and the receiver coil. The wireless charging device parameter includes an initial Q value Q0 of the wireless charging device and an initial resonance frequency f0 of the resonant network when the wireless charging device and the electronic device are in an uncoupled state.

After obtaining the deviation relationship, the controller is further configured to perform foreign object detection based on the deviation relationship.

It should be noted that the electronic device parameter is an initial parameter prestored in the electronic device. For example, if the electronic device is a mobile phone, the electronic device parameter may be a parameter prestored when the mobile phone is delivered from a factory. The electronic device parameter includes a Q value and a resonance frequency f when there is no foreign object at at least one location. The at least one location is a relative location between the wireless charging device and the electronic device. For example, the at least one location may be a corresponding parameter in one relative location, or may be a corresponding parameter in two locations, or may be a corresponding parameter in a plurality of locations. It may be understood that more relative locations correspond to more parameters, and a fitted deviation relationship is more accurate. For example, a Q value when there is no foreign object at the two relative locations is a Q value measured by the mobile phone when the mobile phone is at two different locations relative to a wireless charger, and a resonance frequency f when there is no foreign object at the two locations is a resonance frequency f of a resonant network of the wireless charger when the mobile phone is at the two different locations relative to the wireless charger.

It should be noted that the relative location between the wireless charging device and the electronic device is generally represented by a relative location between the transmitter coil and the receiver coil. The transmitter coil and the receiver coil are generally designed in a disk shape. Therefore, the relative location between the transmitter coil and the receiver coil is a location deviation between the centers of the two disks. It may be understood that when the transmitter coil and the receiver coil are in another shape, the relative location is also the location deviation between the center of the transmitter coil and the center of the receiver coil.

The wireless charging device parameter is generally a parameter prestored in the wireless charging device, for example, a parameter prestored in the wireless charger. The wireless charging device parameter includes the initial Q value Q0 and the initial resonance frequency f0 when the wireless charging device and the electronic device in the uncoupled state. The uncoupled state is a state in which the wireless charging device is far away from the electronic device, and electromagnetic coupling has not been performed. For the wireless charger, the wireless charging device parameter includes Q0 and f0 of the wireless charger when the mobile phone cannot be detected.

The controller 32 of the wireless charging device provided in this embodiment of this application fits the deviation relationship between the Q value and the entire location space based on a limited quantity of wireless charging device parameters and electronic device parameters, that is, fits a correspondence that is similar to a correspondence represented in FIG. 5 and that is between the Q value and the horizontal relative location and the vertical relative location. Therefore, the wireless charging device does not need to store all data of the Q value and the horizontal relative location and the Q value and the vertical relative location in the entire location space, thereby greatly reducing storage space. To be specific, the controller 32 obtains the deviation relationship between the Q value and the entire location space based on the Q1 value and the resonance frequency f1 when there is no foreign object at the at least one relative location, and the initial Q value Q0 and the initial resonance frequency f0 that are in the uncoupled state. After obtaining the deviation relationship between the Q value and the entire location space, the controller 32 may obtain a Q value corresponding to the current location by using the deviation relationship, to perform foreign object detection based on the Q value. Because a relationship shown in the formula (1) exists between the Q value and the alternating current impedance of the transmitter coil, the corresponding alternating current impedance may be obtained based on the Q value. In other words, a deviation relationship between the alternating current impedance and the entire location space may be omitted, and the alternating current impedance may be obtained through conversion based on the Q value, to perform Ploss foreign object detection based on the alternating current impedance.

After obtaining the deviation relationship, the controller may perform Q value foreign object detection before wireless charging, and may perform Ploss foreign object detection in a wireless charging process. Details are separately described below. It should be understood that both Q value foreign object detection and Ploss foreign object detection fall within the protection scope of this application provided that the deviation relationship provided in this embodiment of this application is used.

The controller obtains the Q value threshold based on the deviation relationship, and performs Q value foreign object detection based on the Q value threshold before the wireless charging device charges the electronic device.

The controller is specifically configured to: obtain the Q value threshold based on the deviation relationship, obtain a corresponding alternating current impedance based on the Q value threshold and a correspondence between the Q value and the alternating current impedance of the transmitter coil, and perform Ploss foreign object detection based on the obtained alternating current impedance in the process in which the wireless charging device charges the electronic device.

It can be learned from FIG. 5 that a relative location relationship between the Q value and the entire space includes the horizontal relative location and the vertical relative location. Therefore, the deviation relationship of the fitted Q value in this embodiment of this application may include a horizontal relationship and a vertical relationship. In other words, the deviation relationship includes a radial horizontal relationship between the transmitter coil and the receiver coil and a vertical relationship between a plane on which the transmitter coil is located and a plane on which the receiver coil is located. In addition, in another possible implementation, the deviation relationship of the Q value may alternatively include only the vertical relationship.

The following describes three specific implementations in which the controller fits the horizontal relationship and the vertical relationship by using the electronic device parameter and the wireless charging device parameter.

### Manner 1:

The deviation relationship includes the horizontal relationship and the vertical relationship. The electronic device parameter includes the following Q1 values and f1 at at least two relative locations between the transmitter coil and the receiver coil: Q11 and f11 at a first location, and Q12 and f12 at a second location.

The controller is specifically configured to: fit the horizontal relationship between the Q value and the location space based on Q11, f11, Q12, and f12; and
fit the vertical relationship between the Q value and the location space based on f0, Q0, Q11, and f11;
fit the vertical relationship between the Q value and the location space based on f0, Q0, Q12, and f12; or
fit the vertical relationship between the Q value and the location space based on Q0, f0, and Q and f that correspond to at least one point in the horizontal relationship. In this case, the horizontal relationship between the Q value and the location space needs to be first fitted, then a group of data of Q and f is provided based on a correspondence between Q and f in the horizontal relationship, and then the vertical relationship between the Q value and the location space can be fitted based on the group of data of Q and f and Q0 and f0; and
obtain the Q value threshold based on the horizontal relationship and the vertical relationship, and obtain the corresponding alternating current impedance based on the Q value threshold and the correspondence between the Q value and the alternating current impedance of the transmitter coil.

### Manner 2:

The deviation relationship includes the radial horizontal relationship between the transmitter coil and the receiver coil and the vertical relationship between the plane on which the transmitter coil is located and the plane on which the receiver coil is located.

The electronic device parameter further includes a prestored coupling parameter when there is no foreign object at the at least one relative location between the transmitter coil and the receiver coil. The prestored coupling parameter includes at least one of the following: a coupling coefficient and a mutual inductance between the transmitter coil and the receiver coil.

The controller is specifically configured to: fit the vertical relationship between the Q value and the location space based on f0, Q0, and the Q1 value and f1 at the at least one relative location between the transmitter coil and the receiver coil, fit the horizontal relationship between the Q value and the location space based on the prestored coupling parameter and the Q1 value at the at least one relative location between the transmitter coil and the receiver coil, obtain the Q value threshold based on the vertical relationship and the horizontal relationship, and obtain the corresponding alternating current impedance based on the Q value threshold and the correspondence between the Q value and the alternating current impedance of the transmitter coil.

A difference between the manner 2 and the manner 1 is that in the manner 2, the horizontal relationship is fitted by using the prestored coupling parameter at the receive end. In the manner 2, the horizontal relationship is fitted by using the prestored coupling parameter. Therefore, when the deviation relationship is subsequently used, a coupling parameter detected online may be used to obtain a corresponding horizontal relative location by using the deviation relationship, that is, there is a monotonic relationship between the coupling parameter and the horizontal relationship. For example, a coupling coefficient k tested online is used to obtain a corresponding horizontal relative location by using the deviation relationship. In addition, because there is a monotonic relationship between the horizontal relative location and the Q value, the corresponding Q value threshold may be obtained. In addition, the Q value threshold may alternatively be obtained directly based on the monotonic relationship between k and the horizontal relationship. Therefore, the fitted horizontal relationship is the horizontal monotonic relationship between the Q value and the space.

### Manner 3:

The deviation relationship includes the radial horizontal relationship between the transmitter coil and the receiver coil and the vertical relationship between the plane on which the transmitter coil is located and the plane on which the receiver coil is located.

The electronic device parameter includes the following Q1 values and f1 at at least two relative locations between the transmitter coil and the receiver coil: Q11 and f11 at a first location, and Q12 and f12 at a second location.

The electronic device parameter further includes a prestored coupling parameter at the first location and a prestored coupling parameter at the second location. The prestored coupling parameter includes at least one of the following: a coupling coefficient and a mutual inductance between the transmitter coil and the receiver coil.

The controller is specifically configured to: fit the horizontal relationship between the Q value and the location space based on Q11, Q12, the prestored coupling parameter at the first location, and the prestored coupling parameter at the second location; and
fit the vertical relationship between the Q value and the location space in any one of the following manners: fitting the vertical relationship between the Q value and the location space based on f0, Q0, Q11, and f11; fitting the vertical relationship between the Q value and the location space based on f0, Q0, Q12, and f12; or fitting the vertical relationship between the Q value and the location space based on Q0, f0, and Q and f that correspond to at least one point in the horizontal relationship; and obtain the Q value threshold based on the horizontal relationship and the vertical relationship, and obtain the corresponding alternating current impedance based on the Q value threshold and the correspondence between the Q value and the alternating current impedance of the transmitter coil.

The manner 3 is the same as the manner 2, that is, the horizontal relationship is fitted by using the prestored coupling parameter in the electronic device parameter. However, a difference between the manner 3 and the manner 2 lies in that in the manner 2, the electronic device parameter includes the prestored coupling parameter at the at least one location, and the horizontal relationship may alternatively be fitted by using a prestored coupling parameter at only one location. In the manner 3, the electronic device parameter includes prestored coupling parameters at the at least two locations, to be specific, the horizontal relationship is fitted by using prestored coupling parameters at two different locations and Q and f at the two different locations. Because a large quantity of parameters are used when the horizontal relationship is fitted in the manner 3, the horizontal relationship fitted in the manner 3 is more accurate.

In the manner 3, the horizontal relationship is fitted by using the prestored coupling parameter.the Therefore, when the deviation relationship is subsequently used, coupling parameter detected online may be used to obtain the corresponding horizontal relative location by using the deviation relationship, that is, there is a monotonic relationship between the coupling parameter and the horizontal relationship. For example, the coupling coefficient k tested online is used to obtain the corresponding horizontal relative location by using the deviation relationship. In addition, because there is a monotonic relationship between the horizontal relative location and the Q value, the corresponding Q value threshold may be obtained. In addition, the Q value threshold may alternatively be obtained directly based on the monotonic relationship between k and the horizontal relationship. Therefore, the fitted horizontal relationship is the horizontal monotonic relationship between the Q value and the space.

When there is no deviation at the horizontal relative location between the transmitter coil and the receiver coil, in other words, when the transmitter coil and the receiver coil are aligned, the horizontal relationship does not need to be fitted, and only the vertical relationship in the deviation relationship needs to be fitted. In this case, only a parameter of the receive end at one location is required.

The deviation relationship includes the vertical relationship between the plane on which the transmitter coil is located and the plane on which the receiver coil is located.

The controller fits the vertical relationship based on f0, Q0, and the Q1 value and f1 in the electronic device parameter, and obtains the Q value threshold and the alternating current impedance based on the vertical relationship.

The following describes a specific implementation in which the controller fits the vertical relationship based on the electronic device parameter and the wireless charging device parameter.

### Manner 4:

The deviation relationship includes the vertical relationship. The electronic device parameter includes a Q1 value and f1 of at least one of the following locations.

The controller is specifically configured to: fit the vertical relationship between the Q value and the location space based on f0, Q0, the Q1 value, and f1, obtain the Q value threshold based on the vertical relationship, and obtain the corresponding alternating current impedance based on the Q value threshold and the correspondence between the Q value and the alternating current impedance of the transmitter coil.

When the deviation relationship includes only the vertical relationship, especially for a case in which a deviation of the horizontal relative location is small, for example, when the deviation of the horizontal relative location is less than 4 mm, impact of the deviation of the horizontal relative location on precision of foreign object detection may not be concerned, and only impact of the vertical relative location on precision of foreign object detection is considered. For example, the wireless charging device has an automatic alignment function, and the controller may control the transmitter coil to move and then align with the receiver coil. After the transmitter coil is aligned with the receiver coil, when the horizontal relative location between the transmitter coil and the receiver coil can be ignored, only the deviation relationship fitted in the manner 4 is used. Subsequent foreign object detection performed by using the deviation relationship can also ensure accuracy of a foreign object detection result.

It should be noted that the foregoing process in which the wireless charging device obtains the deviation relationship is a preparation process for foreign object detection.

When foreign object detection is performed, the foregoing four fitted vertical relationships can be used. To be specific, the controller is specifically configured to obtain the Q value threshold and the alternating current impedance based on the vertical relationship and a resonance frequency or a self-inductance of the transmitter coil at the current location between the wireless charging device and the electronic device. In other words, the Q value threshold and the alternating current impedance for foreign object detection are obtained based on f or L1 and the fitted vertical relationship. Because conversion may be performed between f and L1, and a conversion relationship exists, f may also be used, and L1 may also be used.

According to the wireless charging device provided in this embodiment of this application, the deviation relationship of the entire space may be fitted based on the wireless charging device parameter and the electronic device parameter, to implement a linearization process between the Q value and the relative location of the entire space. Data corresponding to the Q value and the entire space does not need to be stored. In addition, the deviation relationship needs to use the electronic device parameter, that is, depends on a parameter sent by the electronic device. For different electronic devices, electronic device parameters sent to the wireless charging device may be different. Therefore, for different electronic devices, deviation relationships fitted by the wireless charging device may be different. Therefore, the wireless charging device provided in this embodiment of this application can implement universality for different electronic devices, that is, normalization of different electronic devices is implemented by using the fitted deviation relationships.

The wireless charging device does not need to store different parameters corresponding to different electronic devices, and directly performs fitting by using an electronic device parameter sent by a corresponding electronic device, to represent a feature of the electronic device. Therefore, the deviation relationship obtained through fitting may represent a location deviation between the wireless charging device and the electronic device. In addition, in the second fitting manner and the third fitting manner, the prestored coupling parameter in the electronic device parameter is used, and the horizontal relationship obtained through fitting by using the prestored coupling parameter is more accurate. When the Q value threshold and the alternating current impedance are obtained by using the fitted horizontal relationship, a more accurate Q value threshold and a more accurate alternating current impedance can be obtained, thereby improving accuracy of wireless charging foreign object detection.

The foregoing manners of fitting deviation relationships are applicable to various types of wireless charging devices, for example, a wireless charging device that has the automatic alignment function, a wireless charging device that has a mechanical latching function, and a wireless charging device that has a magnetic attachment alignment function.

In the foregoing embodiment, only the deviation relationship between the Q value and the entire location space is fitted based on the wireless charging device parameter and the electronic device parameter. The following describes a process of obtaining the Q value threshold based on the deviation relationship and the current location when the deviation relationship has been obtained. The current location may include the horizontal relative location and the vertical relative location. The horizontal relative location and the vertical relative location may be separately obtained based on a monotonic relationship between L1 and the vertical relative location and a monotonic relationship between the coupling parameter and the horizontal relative location. The following describes several implementations of obtaining the coupling parameter. It should be noted that the coupling parameter used for fitting the deviation relationship is included in the electronic device parameter, that is, the coupling parameter prestored in the electronic device. The following describes a coupling parameter obtained by the wireless charging device through online testing when the electronic device is in position, that is, when the wireless charging device is coupled to an electronic device.

First, a process in which the corresponding Q value threshold and the alternating current impedance are directly obtained based on the current location to perform foreign object detection without alignment is described. This embodiment is applicable to a wireless charging device that does not have the automatic alignment function, and may also be applicable to the wireless charging device that has the automatic alignment function. For example, the transmitter coil may be automatically moved, to be aligned with the receiver coil in the electronic device.

A specific foreign object detection process is described in this embodiment. After electromagnetic coupling is performed between the wireless charging device and the electronic device, a self-inductance L1 of the transmitter coil and a coupling parameter between the wireless charging device and the electronic device may be obtained online. The coupling parameter includes the coupling coefficient k and a mutual inductance M, and both k and M represent coupling relationships between the wireless charging device and the electronic device.

The controller obtains, based on f or L1 and the deviation relationship, a Q value threshold corresponding to a current relative location between the wireless charging device and the electronic device, performs Q value foreign object detection based on the Q value threshold corresponding to the current relative location, obtains an alternating current impedance at the current relative location based on the Q value threshold corresponding to the current relative location, and performs Ploss foreign object detection based on the alternating current impedance at the current relative location.

First, a process of obtaining the Q value threshold based on the vertical relationship is described.

After the vertical relationship is obtained through fitting, the Q value threshold and the alternating current impedance may be obtained based on a resonance frequency f or a self-inductance L of the transmitter coil that is obtained through online testing and the vertical relationship obtained through fitting.

Because there is a correspondence between f and the vertical relationship, the controller may obtain the Q value threshold and the alternating current impedance based on the vertical relationship and the resonance frequency f or the self-inductance L1 of the transmitter coil at the current location between the wireless charging device and the electronic device.

The following describes a process in which the wireless charging device obtains the self-inductance L1 of the transmitter coil and f.

FIG. 7 is a schematic diagram of the relationship between the self-inductance L1 of the transmitter coil and the relative location according to an embodiment of this application.

A horizontal axis indicates the horizontal relative location (unit: millimeter), and a vertical axis indicates the vertical relative location (unit: millimeter).

Curves I1 to I4 in the figure are equipotential lines obtained when self-inductances of the transmitter coil are 6.8 µH, 7.2 µH, 7.6 µH, and 8.0 µH, respectively.

It can be seen from FIG. 7 that the self-inductance of the transmitter coil varies slightly with the horizontal relative location and varies greatly with the vertical relative location. Therefore, the vertical relative location may be obtained based on the self-inductance of the transmitter coil.

The controller 32 is further configured to obtain the self-inductance of the transmitter coil based on the resonance frequency of the transmit end resonant network and a resonance capacitor of the transmit end resonant network.

The self-inductance L1 of the transmitter coil may be obtained by using the following formula: $L 1 = \frac{1}{{\left(2πfC1\right)}^{2}}$

C1 is a capacitor of the resonant network and is known. For example, C1 is prestored in the wireless charging device, L1 is the self-inductance of the transmitter coil, and f is the resonance frequency.

Still refer to FIG. 5. After determining that a full bridge inverter circuit reaches a stable state, the controller 32 turns off S1 and turns on S2. Energy stored in C1 is released in a resonant circuit formed by L1 and C1, and a loop formed by S2 and S4. A voltage oscillation curve is obtained by detecting a voltage change between C1 and L1, and the resonance frequency f may be obtained by using the voltage oscillation curve.

The vertical relative location corresponding to the self-inductance may be obtained based on the self-inductance of the transmitter coil by using the monotonic relationship corresponding to FIG. 7. Because the vertical relationship obtained through fitting represents the relationship between the Q value threshold and the vertical relative location, the vertical relative location obtained based on L1 may obtain a corresponding Q value threshold by using the vertical relationship. For simplicity, the vertical relationship may also directly include a correspondence between L1 and the Q value threshold, or directly include a correspondence between f and the Q value threshold. The corresponding Q value threshold may be obtained by directly searching a fitted vertical relationship based on f or L1 obtained through online testing, to obtain the alternating current impedance.

The foregoing describes a process of obtaining the Q value threshold based on the vertical relationship. The following describes a process of obtaining the Q value threshold when the deviation relationship includes the horizontal relationship and the vertical relationship. It should be understood that the alternating current impedance may be obtained after the Q value threshold is obtained.

The following describes four manners of obtaining the Q value threshold by using the deviation relationship that has been obtained through fitting, the coupling parameter, and L1 (where L1 may also be f, because there is a conversion relationship shown in the foregoing formula between L1 and f, and L1 is used as an example for description below). To be specific, the controller is further configured to: obtain the coupling parameter of the wireless charging device and the electronic device in a coupled state and a self-inductance L1 of the transmitter coil, where the coupling parameter in the coupled state includes at least one of the following: a coupling coefficient and a mutual inductance; and obtain the Q value threshold and the alternating current impedance based on the coupling parameter in the coupled state and L1 by using the deviation relationship. There is a monotonic relationship between the coupling parameter in the coupled state and the horizontal relationship. There is a monotonic relationship between L1 and the vertical relationship.

### Manner 1:

The controller is further configured to: receive a self-inductance L2 of the receiver coil in the coupled state that is sent by the electronic device, and obtain the coupling parameter based on a current of the transmitter coil, the self-inductance L1 of the transmitter coil in the coupled state, L2, and a rectified voltage corresponding to the receiver coil.

After obtaining the coupling parameter, the controller obtains the Q value threshold and the alternating current impedance based on the coupling parameter and L1 by using the deviation relationship.

### Manner 2:

The controller is further configured to: receive a self-inductance L20 of the receiver coil in an uncoupled state that is sent by the electronic device, obtain the self-inductance L2 of the receiver coil in the coupled state based on the self-inductance L1 of the transmitter coil in the coupled state, a self-inductance L10 of the transmitter coil in the uncoupled state, and L20, and obtain the coupling parameter based on L1, L2, and a rectified voltage corresponding to the receiver coil.

After obtaining the coupling parameter, the controller obtains the Q value threshold and the alternating current impedance based on the coupling parameter and L1 by using the deviation relationship.

For manner 1 and manner 2, the electronic device parameter may further include: the self-inductance L20 of the receiver coil in the uncoupled state or the self-inductance L2 of the receiver coil in the coupled state. When the electronic device parameter further includes L20, the controller 32 may obtain L2 based on L20. Specifically, the controller 32 is further configured to obtain the self-inductance L2 of the receiver coil in the coupled state based on L20. Generally, there is a preset proportional relationship between the self-inductance of the transmitter coil and the self-inductance of the receiver coil. For example, a controller 32 may obtain the self-inductance L2 of the receiver coil in the coupled state based on the self-inductance L10 of the transmitter coil when the transmit end is in the uncoupled state, a self-inductance L1 of the transmitter coil in the coupled state, L20, and the preset proportional relationship. In this case, the receive end does not need to obtain L2, and only needs to obtain L20.

### Manner 3:

The controller is further configured to: receive a self-inductance L3 that is of an auxiliary coil in the coupled state sent by the electronic device, and obtain the coupling parameter based on a current of the transmitter coil, the self-inductance L1 of the transmitter coil in the coupled state, L3, and a rectified voltage corresponding to the auxiliary coil.

After obtaining the coupling parameter, the controller obtains the Q value threshold and the alternating current impedance based on the coupling parameter and L1 by using the deviation relationship.

### Manner 4:

The controller is further configured to: receive a self-inductance L30 that is of an auxiliary coil in the uncoupled state that is sent by the electronic device, obtain a self-inductance L3 of the auxiliary coil in the coupled state based on the self-inductance L1 of the transmitter coil in the coupled state, a self-inductance L10 of the transmitter coil in the uncoupled state, and L30, and obtain the coupling parameter based on L1, L3, and a rectified voltage corresponding to the auxiliary coil.

After obtaining the coupling parameter, the controller obtains the Q value threshold and the alternating current impedance based on the coupling parameter and L1 by using the deviation relationship.

For manner 3, the electronic device parameter further includes the self-inductance L3 of the auxiliary coil in the coupled state. For manner 4, the electronic device parameter further includes the self-inductance L30 of the auxiliary coil in the uncoupled state. The controller is further configured to obtain the self-inductance L3 of the auxiliary coil in the coupled state based on the self-inductance of the transmitter coil and L30. Generally, there is a preset proportional relationship between a self-inductance of the transmitter coil and a self-inductance of the auxiliary coil. Therefore, the controller may obtain the self-inductance L3 of the auxiliary coil in the coupled state based on the self-inductance L10 of the transmitter coil in the uncoupled state, a self-inductance L1 of the transmitter coil in the coupled state, L30, and the preset proportional relationship. In this case, the receive end does not need to obtain L3, and only needs to obtain L30.

It should be noted that the foregoing four manners of obtaining the coupling parameter are all obtained online, and the prestored coupling parameter included in the electronic device parameter in Embodiment 1 of the wireless charging device is prestored in the electronic device, for example, prestored in the mobile phone. The foregoing describes a manner of obtaining the coupling parameter. When the electronic device includes the auxiliary coil, the coupling parameter between the transmitter coil and the auxiliary coil may be obtained, or the coupling parameter between the transmitter coil and the receiver coil may be obtained. However, when the electronic device has no auxiliary coil, only a coupling parameter between the transmitter coil and the receiver coil can be obtained.

The following specifically describes a manner of obtaining the coupling parameter between the transmitter coil and the receiver coil.

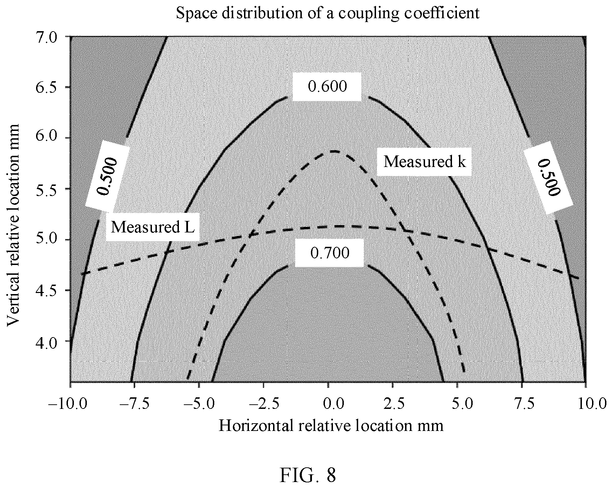

FIG. 8 is a schematic diagram of a relationship between the coupling coefficient k and the relative location according to an embodiment of this application.

A horizontal axis indicates the horizontal relative location (unit: millimeter), and a vertical axis indicates the vertical relative location (unit: millimeter). A dashed line L and a dashed line K in the figure respectively indicate a self-inductance of the transmitter coil and coupling coefficients between the transmitter coil and the receiver coil that are obtained at a same relative location.

It can be seen from FIG. 8 that the coupling coefficient between the transmitter coil and the receiver coil varies slightly with the vertical relative location, and varies greatly with the horizontal relative location. In addition, the coupling coefficient between the transmitter coil and the receiver coil is negatively correlated with the horizontal relative location. In other words a larger horizontal relative location indicates a smaller coupling coefficient between the transmitter coil and the receiver coil. Therefore, the horizontal relative location may be obtained by obtaining the coupling coefficient between the transmitter coil and the receiver coil.

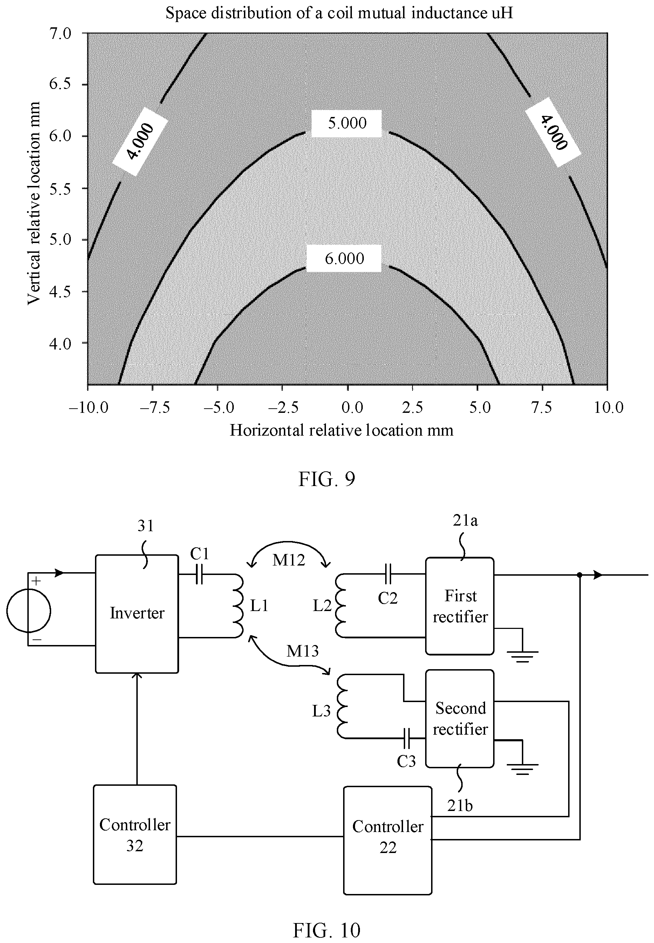

FIG. 9 is a schematic diagram of a relationship between the mutual inductance M and the relative location according to an embodiment of this application.

A horizontal axis indicates the horizontal relative location (unit: millimeter), and a vertical axis indicates the vertical relative location (unit: millimeter). It can be seen from FIG. 9 that the coil mutual inductance between the transmitter coil and the receiver coil varies slightly with the vertical relative location, and varies greatly with the horizontal relative location. The coil mutual inductance between the transmitter coil and the receiver coil is negatively correlated with the horizontal relative location. In other words, a larger horizontal relative location indicates a smaller coil mutual inductance between the transmitter coil and the receiver coil. Therefore, the horizontal relative location may be obtained by obtaining the coil mutual inductance between the transmitter coil and the receiver coil.

The vertical relative location is obtained based on L1, and the horizontal relative location is obtained based on k or M. Therefore, the corresponding Q value threshold may be obtained based on the vertical relative location and the horizontal relative location by using the deviation relationship. For example, according to FIG. 5, when the vertical relative location and the horizontal relative location are known, a corresponding Q value may be uniquely determined.

The following describes a specific process of obtaining k or M.

The coupling coefficient between the transmitter coil and the receiver coil may be obtained by using the following formula (2): $k = \frac{{V}_{rect}}{ω \sqrt{L 1 L 2} I 1} ⋅ α$ (2)

L1 is the self-inductance of the transmitter coil, L2 is the self-inductance of the receiver coil. A full bridge inverter circuit in FIG. 6 is controlled to be in an inverter working state, and ω is a working frequency and is known. The receive end of the electronic device is in a no load state. A rectified voltage Vrect and a current I1 of the transmitter coil are measured.

The mutual inductance M between the transmitter coil and the receiver coil may be obtained by using the following formula (3): $M = \frac{{V}_{rect}}{ωI 1} ⋅ α$ (3)

V_{rect} is a direct current voltage output by a rectifier circuit at the receive end, I1 is the current of the transmitter coil, ω is the working frequency and is known, and α is the coefficient and may be obtained through an experiment.

The foregoing describes a manner of obtaining k and M between the transmitter coil and the receiver coil. The following describes a manner of obtaining k and M between the transmitter coil and the auxiliary coil. When the receive end includes both the receiver coil and the auxiliary coil, the relative location may be obtained by using the coupling parameter between the auxiliary coil and the transmitter coil, or the relative location may be obtained by using the coupling parameter between the receiver coil and the transmitter coil. The coupling parameter includes k or M, that is, k is also used, M is also used, and both k and M may represent the coupling relationship between the transmit end and the receive end. In addition, both k and M have a monotonic relationship with the horizontal relative location.

FIG. 10 is a schematic diagram of a wireless charging system according to an embodiment of this application.

An electronic device includes a receiver coil L2, an auxiliary coil L3, a first rectifier 21a, and a second rectifier 21b. A first end of L2 is connected to a positive input of the first rectifier 21a through C2, and a second end of L2 is connected to a negative input of the first rectifier 21a. An output of the first rectifier 21a is configured to connect to a rear-stage charging circuit. The rear-stage charging circuit is configured to charge a battery in the electronic device. In essence, L2 and C2 are connected in series to the input of the first rectifier 21a.

The auxiliary coil L3 and a capacitor C3 are connected in series to an input of the second rectifier 21b.

The controller controls a full bridge inverter circuit of a transmit end to be in an inverter working state, controls a receive end to be in a no load state, obtains a direct current output voltage of the auxiliary coil and a current of the transmitter coil, and obtains a coupling coefficient in at least one parameter based on the current of the transmitter coil, the direct current output voltage of the auxiliary coil, working frequency, a self-inductance of the transmitter coil, and a self-inductance of the auxiliary coil. The coupling coefficient between the transmitter coil and the auxiliary coil may be obtained by using the following calculation formula (4): $k = \frac{{V}_{ac 3}}{ω \sqrt{L 1 ⋅ L 3} {I}_{1}}$ (4)

V_{ac3} is the direct current output voltage of the auxiliary coil, I₁ is the current of the transmitter coil, ω is the known working frequency, L1 is the self-inductance of the transmitter coil, and L3 is the self-inductance of the auxiliary coil.

After obtaining the coupling coefficient between the transmitter coil and the auxiliary coil, the controller 200 obtains coil mutual inductance in the at least one parameter based on the current of the transmitter coil, the direct current output voltage of the auxiliary coil, and the working frequency that correspond to the receive end in the no load state. The coil mutual inductance M₂ between the transmitter coil and the auxiliary coil may be obtained by using the following calculation formula (5): ${M}_{2} = \frac{{V}_{ac 3}}{ωI 1}$ (5)

V_{ac3} is the direct current output voltage of the auxiliary coil, I1 is the current of the transmitter coil, and ω is the known working frequency.

In the calculation formula of the coupling coefficient between the transmitter coil and the auxiliary coil, β may be measured through the experiment. A person skilled in the art may further correct a value of β to further improve accuracy of detecting the coupling coefficient.

Because the current of the transmitter coil needs to be used when k and M are obtained, the following describes a manner of obtaining the current of the transmitter coil.

It may be understood that the inverter circuit at the transmit end in FIG. 6 is described by using the full bridge inverter circuit as an example.

To obtain the current of the transmitter coil more accurately when the inverter circuit is the full bridge circuit, an embodiment of this application provides a circuit detection circuit.

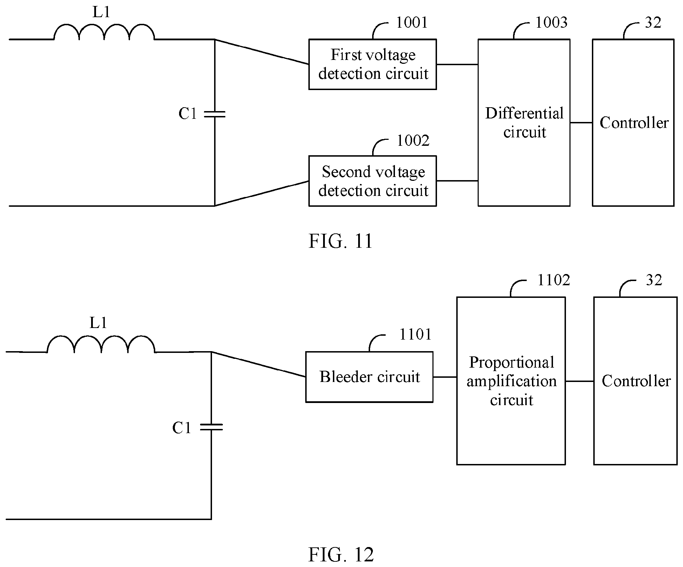

FIG. 11 is a schematic diagram of the current detection circuit of the transmitter coil according to an embodiment of this application.

The wireless charging device provided in this embodiment further includes the current detection circuit of the transmitter coil.

The current detection circuit is configured to detect a voltage difference between two ends of the resonant capacitor, for example, detect a voltage at a first end and a voltage at a second end of the resonant circuit, to obtain a difference between the voltage at the first end and the voltage at the second end, that is, the voltage difference.

The controller is configured to obtain the current of the transmitter coil based on the voltage difference. For the resonant capacitor, a current of the resonant capacitor is: i = cdu / dt. Therefore, obtaining the voltage difference between the two ends of the resonant capacitor, and then performing differential calculation on the voltage difference to obtain the current more complies with a physical principle.

Specifically, the current detection circuit includes: a first voltage detection circuit 1001, a second voltage detection circuit 1002, and a differential circuit 1003.

The first voltage detection circuit 1001 is configured to detect a first voltage at a first end of a resonant capacitor C1, divide the first voltage, and send a divided first voltage to a first input of the differential circuit 1003.

The second voltage detection circuit 1002 is configured to detect a second voltage at a second end of the resonant capacitor C1, divide the second voltage, and send a divided second voltage to a second input of the differential circuit 1003.

The differential circuit 1003 is configured to obtain a differential result of a voltage input at the first input and the voltage input at the second input.

The controller 32 is configured to obtain the current of the transmitter coil L1 based on the differential result.

Because L1 and C1 are connected in series, a current flowing through L1 is equal to a current flowing through C1.

In addition, during actual implementation, the inverter circuit may also be implemented by using a half bridge circuit. The following describes a process of obtaining the current of the transmitter coil corresponding to the half bridge circuit.

FIG. 12 is a schematic diagram of another current detection circuit of the transmitter coil according to an embodiment of this application.

The current detection circuit of the transmitter coil corresponding to the half bridge inverter circuit provided in this embodiment includes a bleeder circuit 1101 and a proportional amplification circuit 1102.

The bleeder circuit 1101 detects a voltage at one end of the resonant capacitor C1, divides the voltage, and sends the voltage to an input of the proportional amplification circuit 1102.

The proportional amplification circuit 1102 is configured to perform proportional amplification on the input voltage and send the input voltage to the controller 32.

Because the inverter circuit corresponding to FIG. 12 is the half bridge circuit, the voltage at one end of the resonant capacitor C1 may be detected, and the voltages at both ends do not need to be detected for difference.

It may be understood that the controller 32 in FIG. 11 and FIG. 12 may have an analog-to-digital conversion function, that is, a voltage of an analog signal is directly input to a pin of the controller 32. When the controller 32 does not have the analog-to-digital conversion function, an analog-to-digital converter may be further connected before the pin of the controller 32. After converting the analog signal into a digital signal, the analog-to-digital converter sends the digital signal to the pin of the controller 32.

The following describes a process of performing Ploss foreign object detection by using alternating current impedance.

### Ploss method:

A power loss is a power difference between transmit power and receive power, and may be calculated by using the following formula: ${P}_{loss} = {P}_{tx} - {P}_{rx}$ (6)

*Pₗₒₛₛ* is a power loss. *Pₜₓ* is the transmit power, and the transmit power is magnetic field energy emitted by the transmit end. *Pᵣₓ* is the receive power, and the receive power is magnetic field energy received by the receive end of the electronic device.

The transmit power *Pₜₓ* may be calculated by using the following formula (6): ${P}_{tx} = {P}_{in} - {P}_{tx loss}$ (7)

*Pᵢₙ* is input power at the transmit end, and *P_{tx loss}* is a power loss at the transmit end, including a loss of a circuit at the transmit end and a loss of the transmitter coil.

The receive power *Pᵣₓ* may be calculated by using the following formula: ${P}_{rx} = {P}_{out} + {P}_{rx loss}$ (8)

*Pₒᵤₜ* is output power at the receive end, and *P_{rx loss}* is a power loss at the receive end, including a loss of a circuit at the receive end and a loss of the receiver coil.

In a manner provided in this embodiment of this application, the alternating current impedance determined based on the foregoing fitted deviation relationship is introduced into calculation of *P_{tx loss}* and *P_{rx loss}*, so that a result of calculation of *Pₜₓ* and *Pᵣₓ* is more accurate, and *Pₗₒₛₛ* is more accurate. This improves precision of Ploss foreign object detection, and supports wireless charging with higher power.

The power loss of the wireless charging device may be expressed in the following formula (9): ${P}_{tx loss} = f \left(Vin\right) + f \left(TxACR, I1\right)$ (9)

Vin is a bus voltage of the inverter circuit.

TxACR refers to an alternating current impedance ACR of a transmitter coil corresponding to the transmitter coil and the receiver coil at a relative location.

I1 is the current of the transmitter coil. $f \left(TxACR,I1\right) = \left(a+TxACR\right) ∗ I {1}^{2} + b ∗ I 1 + c$ (10)

Alternatively, further: $f \left(TxACR, I1\right) = \left(a+TxACR∗d\right) ∗ {I 1}^{2} + b ∗ I 1 + c$ (11)

It can be learned that the foregoing formulas (10) and (11) are unary quadratic functions, where coefficients a, b, c, and d may be obtained in advance for the transmit end through testing, that is, known values.

The foregoing formulas (10) and (11) are manners of obtaining the power loss of the transmit end. It may be understood that the power loss *P_{rx loss}* of the receive end may also be obtained with reference to the foregoing formulas corresponding to the transmit end. For example, in actual obtaining, the receive end may be controlled to work in a state of the transmit end, and each corresponding coefficient in the foregoing formula is obtained through testing in advance.

In addition, to make foreign object detection more accurate, this embodiment of this application further provides another manner of performing Ploss foreign object detection. Specifically, foreign object detection is performed by using k and the alternating current impedance TxACR. The following provides detailed descriptions.

When the wireless charging device can obtain the coupling coefficient k through online testing, the wireless charging device may further perform Ploss foreign object detection based on the alternating current impedance and the coupling coefficient k through online testing. ${P}_{tx loss} = f \left(Vin\right) + f \left(TxACR, k, I1\right)$ (12)

k is the coupling coefficient between the transmitter coil and the receiver coil. $f \left(TxACR, k, I1\right) = \left(a+TxACR∗f\left(k\right)\right) ∗ {I 1}^{2} + b ∗ I 1 + c$ (13)

For the transmit end, the coefficients a, b, and c may be obtained in advance through experiments.

Further, *f*(*k*) may be a unary primary function about the coupling coefficient k, or may be a unary quadratic function about the coupling coefficient k. Coefficients of the unary primary function and the unary quadratic function may be obtained in advance through experiments.

In actual application, after the coupling coefficient k is obtained, a coefficient d corresponding to the current coupling coefficient k may be accurately calculated online, thereby further improving calculation precision of *P_{tx loss}* and *P_{rx loss}.* Higher precision may correspond to higher applicable wireless charging power. Therefore, wireless charging with higher power may be supported.

Calculation of *P_{rx loss}* at the receive end is similar to that at the transmit end. In an actual application, the receive end may be controlled to work in a state of the transmit end, and each coefficient in the foregoing formula is obtained by measurement in advance.

Generally, power consumption of the transmit end accounts for a main proportion in power consumption of the wireless charging system. Therefore, in an actual product, preceding accurate algorithm can be used to calculate *P_{tx loss}* only for the power consumption of the transmit end, and the receive end may not need to use the foregoing precise algorithm to calculate *P_{rx loss}.* It should be understood that the accurate algorithm for the power consumption of the receive end is similar to the accurate algorithm for the power consumption of the transmit end, and details are as follows: ${P}_{rx loss} = f \left(Vout\right) + f \left(RxACR, I2\right)$ (14) ${P}_{rx loss} = f \left(Vout\right) + f \left(RxACR, k, I2\right)$ (15)
Vout is a bus voltage of the rectifier circuit;
RxACR is the alternating current impedance ACR of the receiver coil when the transmitter coil and the receiver coil are at the relative location.

I2 is the current of the receiver coil.

The coupling coefficient k is the coupling coefficient between the transmitter coil and the receiver coil.

The receive end may use the following simple formula: ${P}_{rx loss} = f \left(Vout\right) + f \left(RxACR, I2 in an uncoupled state\right)$ (16)

RxACR in an uncoupled state is ACR of the receiver coil when the receiver coil is separately placed and is far enough from the transmitter coil, that is, ACR of a corresponding receiver coil when the transmitter coil and the receiver coil are not coupled. $f \left(RxACR,I2 in an uncoupled state\right) = \left(a+RxACR in an uncoupled state\right) ∗ I {2}^{2} + b ∗ I 2 + c$

For the receive end, the foregoing coefficients a, b, and c may be obtained in advance through experiments.

It can be learned from the foregoing analysis that, in the Ploss foreign object detection method provided in this embodiment of this application, in addition to the alternating current impedance, the coupling coefficient k is further added. To be specific, during foreign object detection, the power loss is obtained by using a function of the alternating current impedance and the coupling coefficient. After the coupling coefficient is added, the calculated power loss can be more accurate, so that the method is applicable to foreign object detection in wireless charging with higher power. The foregoing various manners of obtaining the coupling parameter are applicable to various types of wireless charging devices. In addition, foreign object detection performed by using the alternating current impedance and the coupling parameter obtained through online testing is also applicable to various types of wireless charging devices. For example, this is applicable to a wireless charging device that has an automatic alignment function, a wireless charging device that has a mechanical latching function, and a wireless charging device that has a magnetic attachment alignment function.

The technical solutions provided in the foregoing embodiments are applicable to the wireless charging device that has the automatic alignment function, or is applicable to a wireless charging device that does not have the automatic alignment function. The following describes the wireless charging device that has an alignment function. The wireless charging device that has the alignment function may be wireless charging device that has the automatic alignment function. To be specific, the controller of the wireless charging device may control movement of the transmitter coil by using the horizontal relative location, so that the transmitter coil and the receiver coil are automatically aligned. Alternatively, the wireless charging device may not have the automatic alignment function, that is, alignment may be implemented by mechanical latching or magnetic attachment alignment.

The following first describes a principle in which the wireless charging device has the automatic alignment function, the controller may control an alignment process of the transmitter coil, and after alignment, the deviation relationship is used to obtain an Q value threshold and an alternating current impedance after alignment to perform foreign object detection.

Embodiment 3 of the wireless charging device:

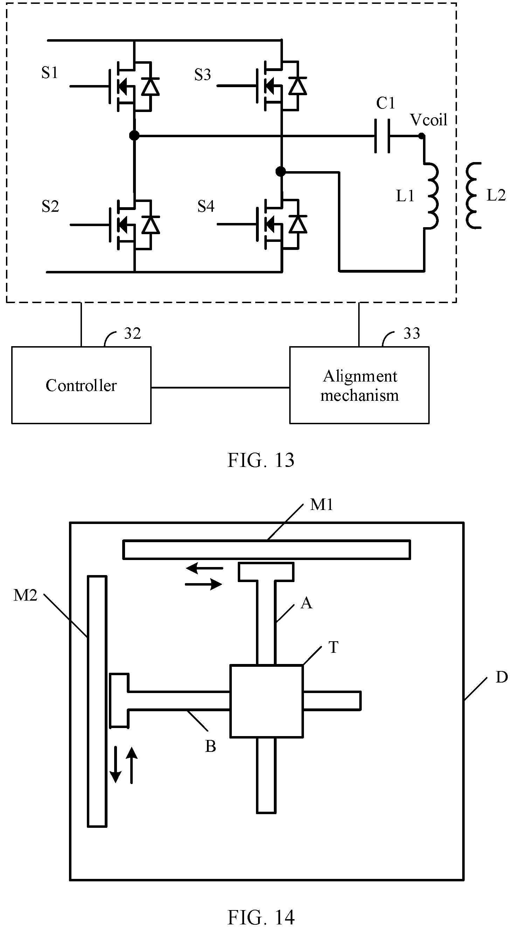

FIG. 13 is a schematic diagram of another wireless charging device according to an embodiment of this application.

The wireless charging device provided in this embodiment further includes an alignment mechanism 33.

The controller 32 controls, based on a movement direction of the transmitter coil, the alignment mechanism 33 to drive the transmitter coil to move along the movement direction.

An implementation of the alignment mechanism is that the alignment mechanism includes at least: a first motor, a second motor, a first rail, and a second rail.

The first rail is perpendicular to the second rail.

The first motor is configured to drive the transmitter coil to move along the first rail.

The second motor is configured to drive the transmitter coil to move along the second rail.

The controller is configured to control the first motor and the second motor, so that the transmitter coil moves in the movement direction.

FIG. 14 is a schematic diagram of an alignment mechanism according to an embodiment of this application.

In FIG. 14, x and y respectively represent two perpendicular directions on a horizontal plane. For example, if x represents a horizontal direction, y represents a direction perpendicular to the horizontal direction and both units are millimeter mm.

When the transmitter coil and the receiver coil are located in a non-communicable area, only the self-inductance L1 of the transmitter coil can be used to determine the relative location between the transmitter coil and the receiver coil.

As shown in FIG. 14, as the relative location between the wireless charging device and the electronic device changes, the self-inductance L1 of the transmitter coil changes accordingly, and is generally presented on a same horizontal plane. The self-inductance L 1 of the transmitter coil tends to decrease as a location deviation increases. For example, when coordinates of x and y are both 0, corresponding L1 is 7.8 µH, and when coordinates of x and y are both 5 mm, corresponding L1 is 7.65 µH. To be specific, a larger location deviation indicates a smaller L1, that is, L1 is in a negative correlation with the location deviation.

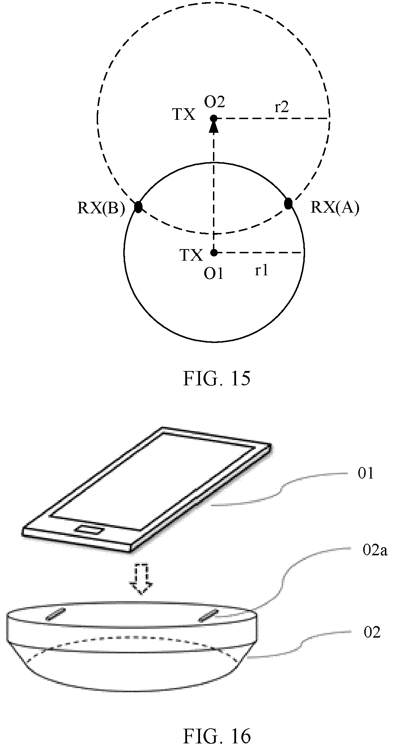

FIG. 15 is a schematic diagram of an alignment principle of a transmitter coil according to an embodiment of this application.

The controller in the wireless charging device provided in this embodiment is further configured to: obtain self-inductances of the transmitter coils at two different locations and at least one of the following coupling parameters, where the coupling parameter includes a coupling coefficient and a mutual inductance; determine a horizontal relative location and a vertical relative location between the transmitter coil and the receiver coil based on the self-inductance of the transmitter coil and the at least one coupling parameter; and move the transmitter coil based on the horizontal relative location, so that the transmitter coil is aligned with the receiver coil.

There is a first monotonic relationship between the self-inductance of the transmitter coil and the vertical relative location. There is a second monotonic relationship between the at least one coupling parameter and the horizontal relative location. For details, refer to FIG. 7, FIG. 8, and FIG. 9.

For ease of description, the following uses an example in which the self-inductance of the transmitter coil and a coupling coefficient k between the transmitter coil and the receiver coil are measured for description. Similarly, the coupling coefficient between the transmitter coil and the auxiliary coil may also be measured. Coupling coefficients may be replaced with mutual inductance M.

In the alignment manner provided in this embodiment of this application, a location of the receiver coil may be determined by measuring the self-inductance L1 and the coupling coefficient k of the transmitter coils at the two different locations. The following provides description with reference to FIG. 15.

The two locations measured are divided into O1 and O2. That is, a center of the transmitter coil is O1 and then moved to O2.

First, at O1, the self-inductance L1 and the coupling coefficient k of the transmitter coil are obtained, and the horizontal relative location and the vertical relative location between the transmitter coil and the receiver coil are obtained based on L1 and k measured at O1. A radial distance r1 between the transmitter coil at O1 and the transmitter coil is obtained based on the horizontal relative location.

Second, the center of the transmitter coil is moved to O2. After L1 and k are measured at O2, the vertical relative location and the horizontal relative location between the transmitter coil and the receiver coil are obtained based on L1 and k measured at O2. A radial distance r2 between the transmitter coil at O2 and the receiver coil is obtained based on the horizontal relative location.

As shown in FIG. 15, one of two points at which O1 is a circumference of a circle whose center r1 is a radius and O2 is a circumference of a circle whose center r2 is a radius intersects is a center of the receiver coil, that is, RX (A) or RX (B).

The controller of the wireless charging device is specifically configured to: obtain a first circumference and a second circumference whose radiuses are respectively two horizontal relative locations (r1 and r2) corresponding to the two different locations (O1 and O2); obtain an intersection point of the first circumference and the second circumference, that is, RX (A) or RX (B), and control the transmitter coil to align with intersection point.

Because the center of the receiver coil may be located at RX (A), or may be located at RX (B), the controller needs to control the transmitter coil to move again. In a movement process, the coupling coefficient may be obtained. For example, whether the center of the receiver coil corresponds to RX (A) or RX (B) is determined based on a change trend of the coupling coefficient. The controller is further configured to: move the transmitter coil to a third location, where the third location is different from the two different locations (that is, the third location may be different from O1 and O2); obtain at least one of the following parameters in the movement process; and determine, based on a change trend of the at least one parameter, that the transmitter coil is aligned with the intersection point. The at least one parameter includes the coupling parameter, charging efficiency, the self-inductance of the transmitter coil, the current of the transmitter coil, and an output voltage of a receive end. Because there is a monotonic relationship between the at least one parameter and the horizontal relative location, a change trend of any one or more of the foregoing parameters may be obtained in the movement process. Whether the center of the receiver coil is RX (A) or RX (B) is determined based on the change trend and the monotonic relationship.

It may be understood that, for simplicity, convenience, and ease of implementation, the foregoing parameters may be measured while moving, or may be measured after moving to a fixed location. This is not specifically limited in this embodiment of this application. A smaller quantity of measured locations and fewer parameters indicate simpler control and calculation and easier implementation. A simplest method is to measure parameters of three different locations to determine a central location of the receiver coil. After obtaining the central location of the receiver coil, the controller may control the transmitter coil to move, so that the transmitter coil is aligned with the receiver coil.

It should be noted that, in another special case, when r1 and r2 are equal, a moving location may further make two circumferences corresponding to r1 and r2 tangent, that is, there is only one intersection point between the two circumferences. In this case, a tangent point is the center of the receiver coil.

In actual application, due to a horizontal alignment deviation caused by an actual measurement error, movement precision of a mechanical structure such as a motor, and the like, especially different vertical heights caused by different mobile phone models and mobile phone shells, a location deviation may continue to exist between the transmitter coil and the receiver coil after alignment. Therefore, L1 and k after alignment further need to be measured again, and the horizontal relative location and the vertical relative location between the transmitter coil and the receiver coil after alignment are obtained based on L1 and k. The Q value threshold and the alternating current impedance are obtained based on the horizontal relative location and the vertical relative location by using a fitted deviation relationship. Then Q value foreign object detection is performed by using the Q value threshold. Ploss foreign object detection is performed by using the alternating current impedance.

It should be noted that for a specific process of obtaining L1 and k, refer to the description in Embodiment 2 of the wireless charging device. This process is similar to a manner of obtaining L1 and k without alignment, and details are not described herein again.

In a possible implementation, after the transmitter coil is aligned with the receiver coil, when the horizontal relative locations of the transmitter coil and the receiver coil are relatively small, the horizontal deviation may be ignored, and the corresponding Q value threshold and the alternating current impedance are obtained only based on a fitted vertical relationship.

According to the wireless charging device provided in this embodiment of this application, after detecting that the electronic device is removed, the controller may control the transmitter coil to move back to an initial location. To control the transmitter coil to move back to the initial location, when controlling the transmitter coil to align with the receiver coil, the controller needs to record a movement track of the transmitter coil or record final location coordinates of the transmitter coil, and move the transmitter coil back to the initial location based on the movement track or the final location coordinates of the transmitter coil. The initial location of the transmitter coil is a known parameter.

In addition, in a possible implementation, the controller is configured to: control the transmitter coil to move to a fourth location, where the fourth location is not in a same straight line as the first location and the second location, in other words, the three points are not in the same straight line; obtain the self-inductance and the coupling parameter of the transmitter coil corresponding to the fourth location; determine the horizontal relative location and the vertical relative location based on the self-inductance and the coupling parameter of the transmitter coil corresponding to the fourth location; determining a third circumference based on the horizontal relative location; and control the transmitter coil to move to a common point between the third circumference and the intersection point.

The foregoing has described specific implementations in which the wireless charging device has the alignment mechanism. The following separately describes specific implementations in which the wireless charging device has mechanical latching and magnetic attachment alignment with reference to the accompanying drawings.

FIG. 16 is a schematic diagram of a wireless charging device with mechanical latching according to an embodiment of this application.

A latching 02a is disposed on a wireless charging device 02. It should be understood that a specific implementation form of the latching 02a is not specifically limited in this embodiment of this application, and the latching 02a mainly performs a limiting function. The latching 02a may be a protrusion, or may be a groove, provided that an electronic device 01 can be fastened. When the electronic device 01 is placed on the wireless charging device 02 for charging, the latching 02a fastens the electronic device 02, to prevent the electronic device 02 from moving relative to the wireless charging device 02, thereby ensuring a relative location between the electronic device 01 and the wireless charging device 02, and implementing efficient charging.

In another implementation, the wireless charging device may have a magnetic attachment alignment function.

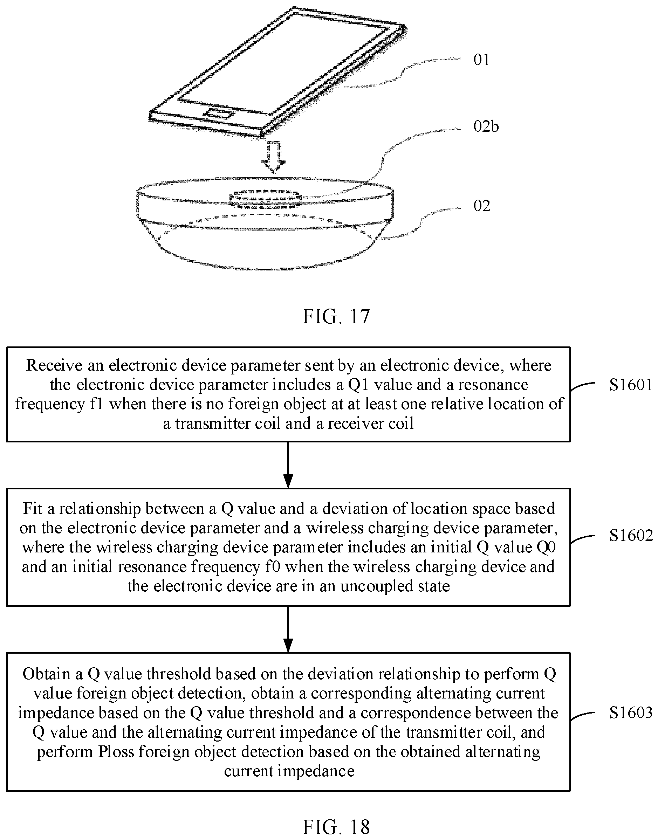

FIG. 17 is a schematic diagram of a wireless charging device with magnetic attachment alignment according to an embodiment of this application.

A magnet 02b is disposed on a wireless charging device 02. A specific location of the magnet 02b is not specifically limited in this embodiment of this application. Provided that an electronic device 01 is placed on the wireless charging device 02 for charging, the magnet 02b may effectively absorb a magnet in the electronic device 01, so that the electronic device 01 can be attached at a proper location of the wireless charging device 02, to help align the wireless charging device 02 with the electronic device 01, thereby improving wireless charging efficiency.

It should be understood that for the wireless charging devices corresponding to FIG. 16 and FIG. 17, a controller does not need to automatically control movement of a transmitter coil, but can detect alignment between the transmitter coil and a receiver coil.

It should be noted that after any one of the foregoing transmitter coils is aligned with the receiver coil, the controller is further configured to: obtain a Q value threshold and an alternating current impedance based on a deviation relationship obtained through fitting based on a self-inductance of the transmitter coil; and perform Q value foreign object detection based on the Q value threshold, and perform Ploss foreign object detection based on the alternating current impedance and a coupling parameter. After alignment, there is no horizontal deviation, and there is only a vertical deviation. Alternatively, only the fitted vertical relationship may be used to obtain the Q value threshold and the alternating current impedance.

Embodiment 1 of a wireless charging cradle:
Based on the wireless charging device, method, and system provided in the foregoing embodiments, an embodiment of this application further provides a wireless charging cradle, configured to wirelessly charge an electronic device. For example, the electronic device is a mobile phone or a wearable device. When the electronic device is a mobile phone and the wireless charging cradle charges the mobile phone, the wireless charging cradle is horizontally placed on a desktop, and the mobile phone is horizontally placed on the wireless charging cradle. Because the wireless charging cradle is provided with a transmitter coil and the mobile phone is provided with a receiver coil, the transmitter coil may be coupled to the receiver coil by using an electromagnetic field, to transfer energy and wirelessly charge the mobile phone.

The wireless charging cradle provided in this embodiment is configured to wirelessly charge the electronic device, and includes: a power interface, a resonant network, an inverter circuit, a controller, a transmitter coil chassis, and an alignment rail.

Still refer to FIG. 1. The wireless charging cradle is 02, the power interface of the wireless charging cradle 02 is connected to an adapter 40, and the adapter 40 converts mains into a direct current and provides the direct current to the wireless charging cradle 02.

The power interface is configured to connect a direct current transmitted by the adapter.

The adapter is configured to: convert alternating current mains into a direct current, and supply the direct current to the power interface, for example, convert the alternating current mains 220 V into a direct current.

The resonant network includes a resonant capacitor and a transmitter coil.

The transmitter coil chassis is configured to place the transmitter coil.

An input of the inverter circuit is configured to connect to the power interface, and an output of the inverter circuit is configured to connect to the resonant network.

The controller is configured to: receive an electronic device parameter sent by the electronic device, and fit a deviation relationship between a Q value of the wireless charging device and a location space based on a wireless charging device parameter and the electronic device parameter. The location space is location space between the transmitter coil and the receiver coil of the electronic device. The electronic device parameter includes a Q1 value of the wireless charging device and a resonance frequency f1 of the resonant network when there is no foreign object at at least one relative location between the transmitter coil and the receiver coil. The wireless charging device parameter includes an initial Q value Q0 of the wireless charging device and an initial resonance frequency f0 of the resonant network when the wireless charging device and the electronic device are in an uncoupled state.

The controller is further configured to perform foreign object detection based on the deviation relationship.

The wireless charging cradle provided in this embodiment fits the deviation relationship between the Q value and the entire location space based on a limited quantity of wireless charging device parameters and electronic device parameters, that is, fits a correspondence that is similar to a correspondence represented in FIG. 5 and that is between the Q value and the horizontal relative location and the vertical relative location. Therefore, the wireless charging device does not need to store all data of the Q value and the horizontal relative location and the Q value and the vertical relative location in the entire location space, thereby greatly reducing storage space. To be specific, the controller 32 obtains the deviation relationship between the Q value and the entire location space based on the Q1 value and the resonance frequency f1 when there is no foreign object at the at least one relative location of the transmitter coil and the receiver coil, the initial Q value Q0 in the uncoupled state, and the initial resonance frequency f0. After obtaining the deviation relationship between the Q value and the entire location space, the controller 32 may obtain the Q value corresponding to a current location by using the deviation relationship, to perform foreign object detection based on the Q value. Because a conversion relationship exists between the Q value and the alternating current impedance of the transmitter coil, the corresponding alternating current impedance may be obtained based on the Q value. In other words, the deviation relationship between the alternating current impedance and the entire location space may be omitted, and the alternating current impedance may be obtained through conversion based on the Q value, to perform Ploss foreign object detection based on the alternating current impedance.

All manners of fitting the deviation relationship described in the foregoing embodiments of the wireless charging device are applicable to the wireless charging cradle. Details are not described herein again. The following lists only a part of the manners. Advantages and effects of the foregoing embodiments are all applicable to the wireless charging cradle.

The electronic device parameter may include the Q1 value and f1 of the at least one relative location of the transmitter coil and the receiver coil, or may include the Q1 values and f1 of at least two relative locations. It may be understood that more relative locations indicate more corresponding parameters, and more parameters participate in fitting, so that the deviation relationship obtained through fitting is more accurate. An example in which the electronic device parameter includes the at least two relative locations is used below for description. If the electronic device parameter includes the relative location, refer to the description of the wireless charging device in the foregoing embodiments.

The electronic device parameters include the following Q1 values and f1 at the at least two relative locations between the transmitter coil and the receiver coil: Q11 and f11 at a first location, and Q12 and f12 at a second location.

In an implementation, the deviation relationship includes a radial horizontal relationship between the transmitter coil and the receiver coil and a vertical relationship between a plane on which the transmitter coil is located and a plane on which the receiver coil is located.

The electronic device parameter further includes a prestored coupling parameter when there is no foreign object at the at least one relative location between the transmitter coil and the receiver coil. The prestored coupling parameter includes at least one of the following: a coupling coefficient and a mutual inductance.

The controller fits the vertical relationship based on f0, Q0, and the Q1 value and f1 at the at least one relative location; fits the horizontal relationship based on the prestored coupling parameter and the Q1 value at the at least one relative location; and obtains the Q value threshold and the alternating current impedance by using the vertical relationship and the horizontal relationship.

When the electronic device parameter includes the Q1 value and the f1 value that correspond to the two locations, a specific implementation of a fitting deviation relationship is that the deviation relationship includes the vertical relationship and the horizontal relationship.

The electronic device parameter further includes a prestored coupling parameter at the first location and a prestored coupling parameter at the second location. The prestored coupling parameter includes at least one of the following: a coupling coefficient and a mutual inductance.

The controller is specifically configured to: fit the horizontal relationship based on Q11, Q12, the prestored coupling parameter at the first location, and the prestored coupling parameter at the second location;
fit the vertical relationship based on f0, Q0, Q11, and f11;
fit the vertical relationship based on f0, Q0, Q12, and f12; or
fit the vertical relationship based on Q0, f0, and Q and f corresponding to at least one point in the horizontal relationship; and
obtain the Q value threshold and the alternating current impedance by using the vertical relationship and the horizontal relationship.

Because a fitted horizontal relationship uses the prestored coupling parameter, when the deviation relationship is subsequently used, a coupling parameter detected online may be used to obtain the corresponding horizontal relative location by using the deviation relationship, that is, the coupling parameter and the horizontal relationship are monotonic. For example, a coupling coefficient k tested online is used to obtain the corresponding horizontal relative location by using the deviation relationship. In addition, because the horizontal relative location and the Q value are monotonic, the corresponding Q value threshold may be obtained. In addition, the Q value threshold may also be obtained directly based on the monotonicity between k and the horizontal relationship. Therefore, the fitted horizontal relationship is the horizontal monotonic relationship between the Q value and the space.

When foreign object detection is performed, the foregoing fitted vertical relationship may be used. Because both the resonance frequency and the transmitter coil have a monotonic relationship with the vertical relative location, the controller may obtain the Q value threshold and the alternating current impedance based on the resonance frequency of the wireless charging device and the electronic device at a current location or the self-inductance of the transmitter coil by using the vertical relationship. In other words, the Q value threshold and the alternating current impedance for foreign object detection are obtained by using the resonance frequency f or the self-inductance L1 of the transmitter coil and by using the fitted vertical relationship. Because conversion may be performed between f and L1, and a conversion relationship exists, f may also be used, and L1 may also be used.

To make a result of foreign object detection more accurate, the controller may perform Ploss foreign object detection based on the alternating current impedance and the coupling parameter in the coupled state obtained through online testing. There is a monotonic relationship between the coupling parameter and the horizontal relative location. Therefore, a corresponding alternating current impedance can be accurately obtained by using the coupling parameter and the horizontal relationship, thereby improving accuracy of calculating a power loss.

In addition, the wireless charging cradle may further include an alignment mechanism. The controller may control the alignment mechanism to drive the transmitter coil to align with the receiver coil. For a specific schematic diagram and implementation, refer to the wireless charging device embodiments. Details are not described herein again. In addition, when the wireless charging device does not have an automatic alignment function, the wireless charging device may include a mechanical latching to implement alignment. In addition, the wireless charging device may also include magnetic attachment alignment to implement alignment. For both mechanical latching and magnetic attachment alignment, refer to the descriptions in the foregoing embodiments of the wireless charging device.

The alignment mechanism includes at least an alignment rail. The alignment rail includes at least a first guide rail and a second guide rail whose projections on a horizontal plane are perpendicular to each other. The alignment rail further includes an electric drive component. The electric drive component is configured to drive the transmitter coil to move along the first guide rail and the second guide rail. The controller is further configured to control the electric drive component. The electric drive component drives the transmitter coil to align with the receiver coil.

The wireless charging cradle may further have an automatic alignment function, that is, the controller, is further configured to: obtain self-inductances of the transmitter coils at two different locations and at least one of the following coupling parameters, where the coupling parameter includes a coupling coefficient and a mutual inductance; determine a horizontal relative location and a vertical relative location between the transmitter coil and the receiver coil based on the self-inductance of the transmitter coil and the at least one coupling parameter; and move the transmitter coil based on the horizontal relative location, so that the transmitter coil is aligned with the receiver coil.

There is a first monotonic relationship between the self-inductance of the transmitter coil and the vertical relative location. There is a second monotonic relationship between the at least one coupling parameter and the horizontal relative location.

For details, refer to content of the transmitter coil alignment described in Embodiment 3 of the wireless charging device. Details are not described herein again. The wireless charging cradle may include the alignment mechanism corresponding to FIG. 13 and FIG. 14. The controller controls the alignment mechanism to align the transmitter coil with the receiver coil.

Based on the wireless charging device and the wireless charging cradle provided in the foregoing embodiments, an embodiment of this application further provides a foreign object detection method for wireless charging. The following provides detailed descriptions with reference to the accompanying drawings.

Embodiment 1 of the foreign object detection method:

FIG. 18 is a flowchart of the foreign object detection method for wireless charging according to an embodiment of this application.

The foreign object detection method for wireless charging provided in this embodiment is applied to a wireless charging device. The wireless charging device includes a resonant network and an inverter circuit. The resonant network includes a resonant capacitor and a transmitter coil. An input of the inverter circuit is configured to connect to a direct current power supply, and an output of the inverter circuit is configured to connect to the resonant network.

The method includes the following steps.

S1601: Receive an electronic device parameter sent by an electronic device, where the electronic device parameter includes a Q1 value and a resonance frequency f1 when there is no foreign object at at least one relative location between the transmitter coil and the receiver coil.

The electronic device parameter is an initial parameter prestored in the electronic device. For example, if the electronic device is a mobile phone, the electronic device parameter may be a parameter prestored when the mobile phone is delivered from a factory. The electronic device parameters include the Q1 value and the resonance frequency f1 when there is no foreign object ata the at least one relative location. The at least one relative location is a relative location between the wireless charging device and the electronic device, and is generally subject to a relative location between the transmitter coil and the receiver coil. For example, the at least one relative location may be a corresponding parameter in one relative location, or may be a corresponding parameter in two locations, or may be a corresponding parameter in a plurality of locations. It may be understood that more relative locations correspond to more parameters, and a fitted deviation relationship is more accurate. For example, a Q1 value when there is no foreign object in the two relative locations refers to a Q1 value measured by the mobile phone when the mobile phone is at two different locations relative to the wireless charger, and a resonance frequency f1 when there is no foreign object in the two locations refers to a resonance frequency f1 of the resonant network of the wireless charger when the mobile phone is at the two different locations relative to the wireless charger.

A wireless charging device parameter is a parameter prestored in the wireless charging device, for example, a parameter prestored in the wireless charger. The wireless charging device parameter includes the initial Q value Q0 and the initial resonance frequency f0 that are of the wireless charging device and the electronic device in the uncoupled state. The uncoupled state is that the wireless charging device is far away from the electronic device, and electromagnetic coupling has not been performed. In other words, for the wireless charger, the wireless charging device parameter includes Q0 and f0 of the wireless charger when the mobile phone cannot be detected.

S1602: Fit a deviation relationship between a Q value and a location space based on the electronic device parameter and a wireless charging device parameter, where the wireless charging device parameter includes an initial Q value Q0 and an initial resonance frequency f0 when the wireless charging device and the electronic device are in an uncoupled state.

It should be noted that the deviation relationship may be a primary function or a higher-order function. A fitting manner is not specifically limited in this embodiment of this application. A deviation relationship between the Q value and the space may be fitted based on a plurality of known parameters.

S1603: Obtain a Q value threshold based on the deviation relationship to perform Q value foreign object detection, obtain a corresponding alternating current impedance based on the Q value threshold and a correspondence between the Q value and the alternating current impedance of the transmitter coil, and perform Ploss foreign object detection based on the obtained alternating current impedance.

The controller 32 of the wireless charging device provided in this embodiment of this application fits the deviation relationship between the Q value and the entire location space based on a limited quantity of wireless charging device parameters and electronic device parameters, that is, fits a correspondence that is similar to a correspondence represented in FIG. 5 and that is between the Q value and the horizontal relative location and the vertical relative location. Therefore, the wireless charging device does not need to store all data of the Q value and the horizontal relative location and the Q value and the vertical relative location in the entire location space, thereby greatly reducing storage space. To be specific, the controller 32 obtains the deviation relationship between the Q value and the entire location space based on the Q1 value and the resonance frequency f1 when there is no foreign object at the at least one relative location, the initial Q value Q0 in the uncoupled state, and the initial resonance frequency f0. After obtaining the deviation relationship between the Q value and the entire location space, the controller 32 may obtain the Q value corresponding to a current location by using the deviation relationship, to perform foreign object detection based on the Q value. Because the relationship shown in the formula (1) exists between the Q value and the alternating current impedance of the transmitter coil, the corresponding alternating current impedance may be obtained based on the Q value. In other words, the deviation relationship between the alternating current impedance and the entire location space may be omitted, and fitting does not need to be performed. The alternating current impedance may be obtained by using the Q value, to perform Ploss foreign object detection in a wireless charging process based on the alternating current impedance.

Embodiment 2 of the foreign object detection method:
The deviation relationship fitted in this embodiment of this application includes a radial horizontal relationship between the transmitter coil and the receiver coil and a vertical relationship between a plane on which the transmitter coil is located and a plane on which the receiver coil is located.

The fitting a deviation relationship between a Q value and a location space based on the electronic device parameter and a wireless charging device parameter specifically includes:
fitting the horizontal relationship based on Q1 and f1 in the electronic device parameter; and
fitting the vertical relationship based on f0, Q0, and the Q1 value and f1 in the electronic device parameter.

In addition, in a possible implementation, when the location deviation between the transmitter coil and the receiver coil is relatively small and can be ignored, the fitted deviation relationship may include only the vertical relationship. When the transmitter coil in the wireless charging device can move, the transmitter coil may be controlled to move and align with the receiver coil. However, when locations of the electronic device and the wireless charging device are fixed, the vertical deviation cannot be changed.

The following describes several methods for fitting the deviation relationship.

### Manner 1:

The electronic device parameters include the following Q1 values and f1 at the at least two relative locations between the transmitter coil and the receiver coil: Q11 and f11 at a first location, and Q12 and f12 at a second location.

The deviation relationship includes a radial horizontal relationship between the transmitter coil and the receiver coil and a vertical relationship between a plane on which the transmitter coil is located and a plane on which the receiver coil is located.

The fitting a deviation relationship between a Q value and a location space based on a wireless charging device parameter and the electronic device parameter specifically includes:
fitting the horizontal relationship based on Q11, f11, Q12, and f12;
fitting the vertical relationship based on f0, Q0, Q11, and f11;
fitting the vertical relationship based on f0, Q0, Q12, and f12 or
fitting the vertical relationship based on Q0, f0, and Q and f corresponding to at least one point in the horizontal relationship; and
after obtaining the horizontal relationship and the vertical relationship, obtaining the Q value threshold and the alternating current impedance by using the horizontal relationship and the vertical relationship.

### Manner 2:

The deviation relationship includes a radial horizontal relationship between the transmitter coil and the receiver coil and a vertical relationship between a plane on which the transmitter coil is located and a plane on which the receiver coil is located.

The electronic device parameter further includes a prestored coupling parameter when there is no foreign object at the at least one position. The prestored coupling parameter includes at least one of the following: a coupling coefficient and a mutual inductance.

The fitting a deviation relationship between a Q value and a location space based on a wireless charging device parameter and the electronic device parameter specifically includes:
fitting the vertical relationship based on f0, Q0, and the Q1 value and f1 of the at least one relative location; and fitting the horizontal relationship based on the prestored coupling parameter and the Q1 value of the at least one relative location.

The obtaining a Q value threshold and the alternating current impedance based on the deviation relationship specifically includes:
after obtaining the horizontal relationship and the vertical relationship, obtaining the Q value threshold based on the vertical relationship and the horizontal relationship, and obtaining the corresponding alternating current impedance based on the Q value threshold and the correspondence between the Q value and the alternating current impedance of the transmitter coil.

### Manner 3:

The electronic device parameters include the following Q1 values and f1 at the at least two relative locations between the transmitter coil and the receiver coil: Q11 and f11 at a first location, and Q12 and f12 at a second location. The deviation relationship includes a radial horizontal relationship between the transmitter coil and the receiver coil and a vertical relationship between a plane on which the transmitter coil is located and a plane on which the receiver coil is located.

The electronic device parameter further includes a prestored coupling parameter at the first location and a prestored coupling parameter at the second location. The prestored coupling parameter includes at least one of the following: a coupling coefficient and a mutual inductance between the transmitter coil and the receiver coil.

The fitting a deviation relationship between a Q value and a location space based on a wireless charging device parameter and the electronic device parameter specifically includes:
fitting the horizontal relationship based on Q11, Q12, the prestored coupling parameter at the first location, and the prestored coupling parameter at the second location;
fitting the vertical relationship based on f0, Q0, Q11, and f11;
fitting the vertical relationship based on f0, Q0, Q12, and f12 or
fitting the vertical relationship based on Q0, f0, and Q and f corresponding to at least one point in the horizontal relationship.

The obtaining a Q value threshold and the alternating current impedance based on the deviation relationship specifically includes:
after obtaining the horizontal relationship and the vertical relationship, obtaining the Q value threshold based on the vertical relationship and the horizontal relationship, and obtaining the corresponding alternating current impedance based on the Q value threshold and the correspondence between the Q value and the alternating current impedance of the transmitter coil.

Because a fitted horizontal relationship in manner 2 and manner 3 uses the prestored coupling parameter, when the deviation relationship is subsequently used, a coupling parameter detected online may be used to obtain the corresponding horizontal relative location by using the deviation relationship, that is, the coupling parameter and the horizontal relationship are monotonic. For example, a coupling coefficient k tested online is used to obtain the corresponding horizontal relative location by using the deviation relationship. In addition, because the horizontal relative location and the Q value are monotonic, the corresponding Q value threshold may be obtained. In addition, the Q value threshold may also be obtained directly based on the monotonicity between k and the horizontal relationship. Therefore, the fitted horizontal relationship is the horizontal monotonic relationship between the Q value and the space.

### Manner 4:

The deviation relationship includes the vertical relationship. The fitting a deviation relationship between a Q value and a location space based on a wireless charging device parameter and the electronic device parameter specifically includes:
fitting the vertical relationship based on f0, Q0, and the Q1 value and f1 in the electronic device parameter; obtaining a Q value threshold by using the vertical relationship; and obtaining a corresponding alternating current impedance based on the Q value threshold and a correspondence between the Q value and the alternating current impedance of the transmitter coil.

Manner 4 is applicable only to a case in which there is no deviation between the transmitter coil and the receiver coil in a horizontal direction, or the deviation is very small and can be ignored, and only the vertical deviation needs to be fitted. When there is the horizontal deviation, if the transmitter coil of the wireless charging device can be aligned, a foreign object may be determined after the transmitter coil of the wireless charging device is aligned.

When the electronic device parameter includes only one location, a relationship between the Q value and the vertical direction can be accurately fitted. This method is especially applicable to a case in which the wireless charging device has an automatic alignment function. To be specific, the wireless charging device controls movement of the transmitter coil to implement alignment with the receiver coil, so that the horizontal deviation between the transmitter coil and the receiver coil is relatively small or ignored, and only the vertical deviation needs to be considered. Therefore, the Q value and the Ploss are detected by using the fitted vertical relationship, and accuracy of a foreign object detection result can also be ensured.

When foreign object detection is performed, the foregoing four fitted vertical relationships may be used. To be specific, the controller is specifically configured to obtain the Q value threshold and the alternating current impedance by using the vertical relationship based on the resonance frequency of the wireless charging device and the electronic device at the current location or the self-inductance of the transmitter coil. In other words, the Q value threshold and the alternating current impedance for foreign object detection are obtained based on f or L1 and the fitted vertical relationship. Because conversion may be performed between f and L1, and a conversion relationship exists, f may also be used, and L1 may also be used. The following describes specific implementation steps of the foregoing fitting manners with reference to a flowchart.

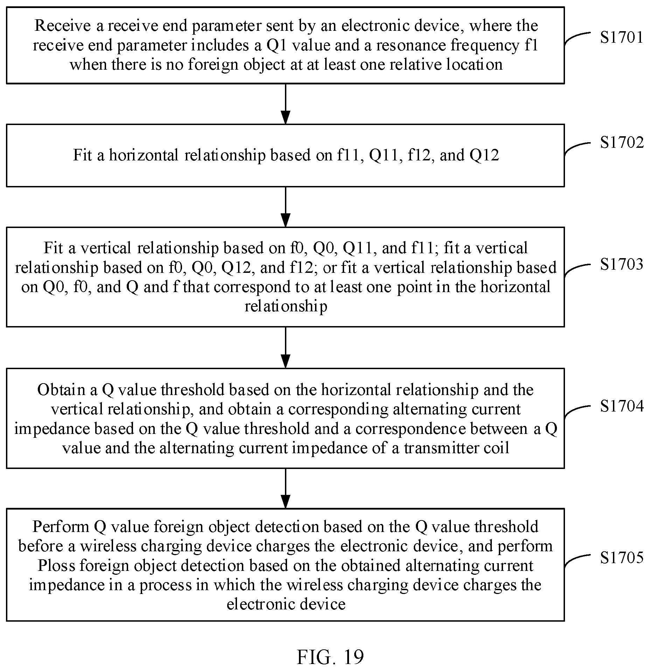

FIG. 19 is a flowchart of another foreign object detection method for wireless charging according to an embodiment of this application.

In the method corresponding to FIG. 19, an electronic device parameter includes the following Q1 values and f1 at at least two relative locations of the transmitter coil and the receiver coil: Q11 and f11 at a first location, and Q12 and f12 at a second location. The electronic device parameter further includes a self-inductance L2 of the receiver coil in a coupled state.

Therefore, a corresponding foreign object detection method includes the following steps.

S1701: Receive Q11 and f11 at the first location and Q12 and f12 at the second location that are sent by an electronic device.

S1702: Fit a horizontal relationship based on f11, Q11, f12, and Q12.

S1703: Fit a vertical relationship based on f0, Q0, Q11, and f11; fit a vertical relationship based on f0, Q0, Q12, and f12; or fit a vertical relationship based on Q0, f0, and Q and f that correspond to at least one point in the horizontal relationship.

To be specific, when the vertical relationship is fitted, there may be three manners provided in S1703, and any one of the manners may be selected. However, when the last manner is selected, based on the Q value and f corresponding to the at least one point in the horizontal relationship, the horizontal relationship needs to be obtained first, and then the vertical relationship is obtained. When the vertical relationship is fitted in the first two manners, the horizontal relationship does not need to be obtained first, that is, a sequence of obtaining the horizontal relationship and the vertical relationship is not limited.

Because there is a conversion relationship between the Q value and the alternating current impedance, the horizontal relationship and the vertical relationship between the Q value and the location space are obtained, so that the horizontal relationship and the vertical relationship between the alternating current impedance and the location space can be obtained.

S1704: Obtain a Q value threshold based on the horizontal relationship and the vertical relationship, and obtain a corresponding alternating current impedance based on the Q value threshold and a correspondence between the Q value and the alternating current impedance of the transmitter coil.

S1705: Perform Q value foreign object detection based on the Q value threshold before a wireless charging device charges the electronic device, and perform Ploss foreign object detection based on the obtained alternating current impedance in a process in which the wireless charging device charges the electronic device.

According to the method provided in this embodiment, the electronic device may not need to obtain the self-inductance L2 of the receiver coil in the coupled state, but only need to obtain a self-inductance L20 of the receiver coil in the uncoupled state, and send L20 to the wireless charging device or a wireless charging cradle, so that the wireless charging device obtains L2 based on L20.

According to the method described above, the electronic device parameter includes the self-inductance of the receiver coil. When the electronic device includes an auxiliary coil, the electronic device parameter may include a self-inductance of the auxiliary coil. The following describes, with reference to the accompanying drawings, a process of fitting a deviation relationship based on the self-inductance of the auxiliary coil.

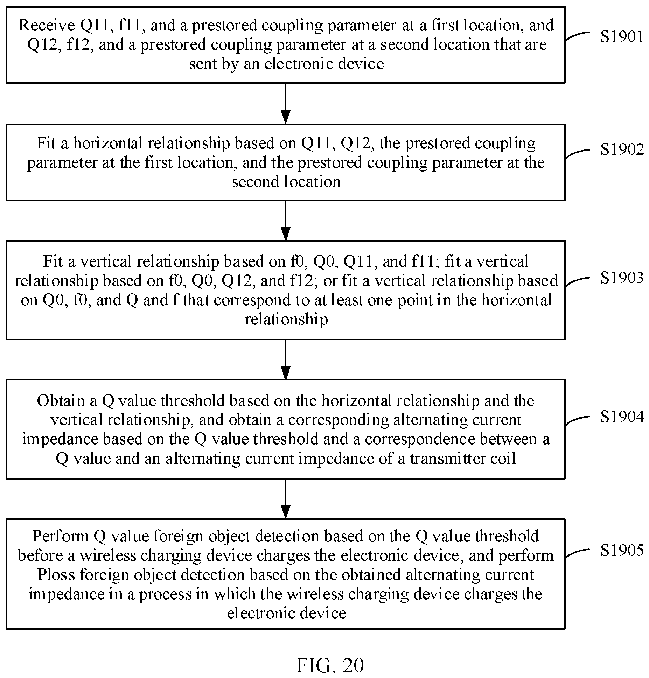

FIG. 20 is a flowchart of still another foreign object detection method for wireless charging according to an embodiment of this application.

According to the method corresponding to FIG. 20, the electronic device parameters include Q1 values and f1 at at least two relative locations between a transmitter coil and a receiver coil: Q11 and f11 at a first location, and Q12 and f12 at a second location. The deviation relationship includes a vertical relationship and a horizontal relationship. The electronic device parameter further includes a prestored coupling parameter at the first location and a prestored coupling parameter at the second location. The prestored coupling parameter includes at least one of the following: a coupling coefficient and a mutual inductance.

S1901: Receive Q11 and f11 at the first location and Q12 and f12 at the second location that are sent by an electronic device.

S1902: Fit the horizontal relationship based on Q11, Q12, the prestored coupling parameter at the first location, and the prestored coupling parameter at the second location. For example, the prestored coupling parameter is a coupling coefficient k.

S1903: Fit the vertical relationship based on f0, Q0, Q11, and f11; fit the vertical relationship based on f0, Q0, Q12, and f12; or fit the vertical relationship based on Q0, f0, and Q and f corresponding to at least one point in the horizontal relationship.

It should be noted that when the vertical relationship is fitted in the first two manners in S1903, there is no sequence between S1902 and S1903, and S1902 and S1903 may be performed simultaneously or sequentially. This is not specifically limited in this embodiment of this application. However, when the vertical relationship is fitted in the last manner of S1903, the horizontal relationship needs to be first obtained through fitting, and then the vertical relationship is fitted based on a result of the horizontal relationship.

S1904: Obtain a Q value threshold based on the horizontal relationship and the vertical relationship, and obtain a corresponding alternating current impedance based on the Q value threshold and a correspondence between the Q value and the alternating current impedance of the transmitter coil.

S1905: Perform Q value foreign object detection based on the Q value threshold before a wireless charging device charges the electronic device, and perform Ploss foreign object detection based on the obtained alternating current impedance in a process in which the wireless charging device charges the electronic device.

The foregoing describes that the electronic device parameter includes Q1 and f1 of at least two relative locations. The following describes a case in which the electronic device parameter includes at least one location. In this case, the electronic device parameter may further include a coupling parameter when there is no foreign object at the at least one relative location. The coupling parameter includes at least one of the following: a coupling coefficient and a mutual inductance between the transmitter coil and the receiver coil.

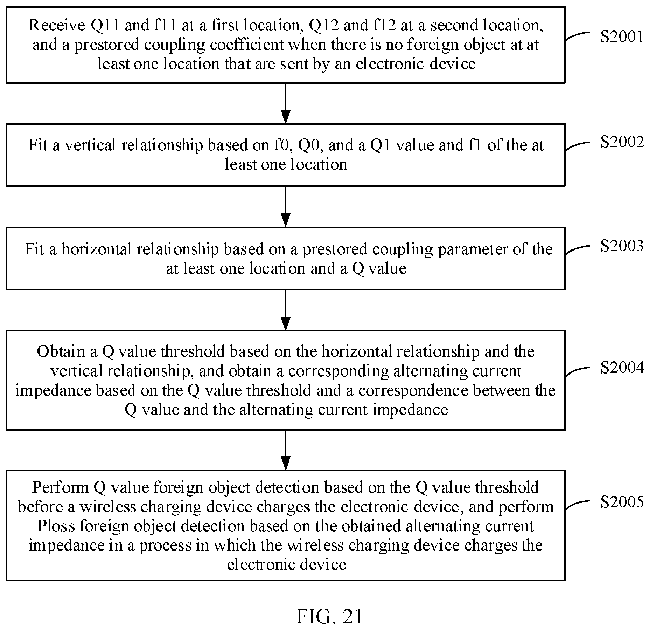

FIG. 21 is a flowchart of yet another foreign object detection method for wireless charging according to an embodiment of this application.

S2001: Receive Q11 and f11 at a first location, Q12 and f12 at a second location, and a prestored coupling coefficient when there is no foreign object at at least one location that are sent by an electronic device.

S2002: Fit a vertical relationship based on f0, Q0, and a Q1 value and f1 of the at least one location.

S2003: Fit a horizontal relationship based on a prestored coupling parameter at the at least one location and a Q value.

To be specific, the coupling parameter included in an electronic device parameter participates in fitting of the horizontal relationship. This is because there is a monotonic relationship between the coupling parameter and the horizontal relative location.

S2004: Obtain a Q value threshold based on the horizontal relationship and the vertical relationship, and obtain a corresponding alternating current impedance based on the Q value threshold and a correspondence between the Q value and the alternating current impedance of the transmitter coil.

S2005: Perform Q value foreign object detection based on the Q value threshold before a wireless charging device charges the electronic device, and perform Ploss foreign object detection based on the obtained alternating current impedance in a process in which the wireless charging device charges the electronic device.

According to the method provided in this embodiment, the electronic device parameter may include a parameter at only one location. However, because the electronic device parameter includes the prestored coupling parameter, the horizontal relationship can also be accurately fitted by using the parameter at the one location. Because there is a monotonic relationship between the prestored coupling parameter and the horizontal relative location, the horizontal relationship can be accurately fitted by using the monotonic relationship in this embodiment.

Embodiment 3 of the foreign object detection method:

When the deviation relationship includes only the vertical relationship, the controller may obtain the Q value threshold and the alternating current impedance by using the vertical relationship based on the resonance frequency of the wireless charging device and the electronic device at the current location or the self-inductance of the transmitter coil, perform Q value foreign object detection by using the Q value threshold, and perform Ploss foreign object detection by using the alternating current impedance. The foregoing manners of fitting deviation relationships are applicable to various types of wireless charging devices, for example, a wireless charging device that has an automatic alignment function, a wireless charging device that has a mechanical latching function, and a wireless charging device that has a magnetic attachment alignment function.

The following describes a foreign object detection method when the transmitter coil and the receiver coil are not aligned.

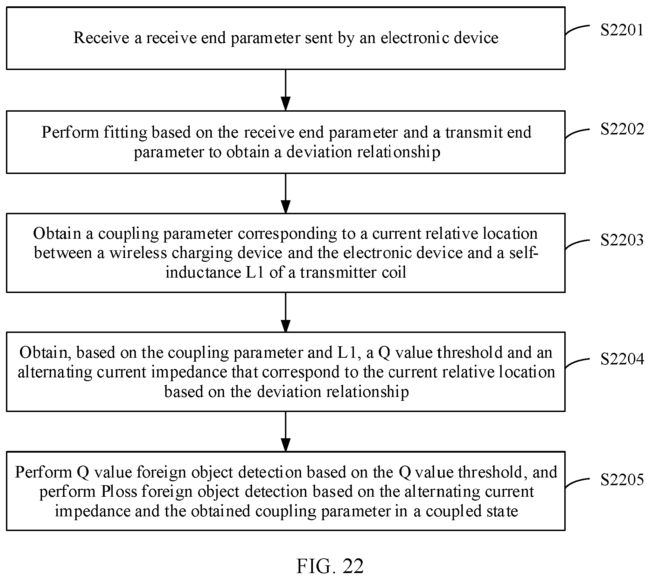

FIG. 22 is a flowchart of a foreign object detection method according to an embodiment of this application.

S2201: Receive an electronic device parameter sent by an electronic device.

The electronic device parameter may be various cases described in the foregoing method Embodiment 2, and details are not described herein again.

S2202: Perform fitting based on the electronic device parameter and a wireless charging device parameter to obtain a deviation relationship.

For the electronic device parameter, refer to the case described in the method Embodiment 2. For a specific fitting manner of the deviation relationship, refer to the description in the method Embodiment 2. Details are not described herein again.

S2203: Obtain a coupling parameter in a coupled state corresponding to a current relative location between a wireless charging device and the electronic device and a self-inductance L1 of a transmitter coil.

The coupling parameter may include a coupling coefficient k or a mutual inductance M. There is a monotonic relationship between the coupling parameter and a horizontal relationship, and there is a monotonic relationship between L1 and a vertical relationship.

The following describes a manner of obtaining the coupling parameter. The coupling parameter is obtained by the wireless charging device through online testing, and is not in an electronic device parameter received from the electronic device, that is, is not a coupling parameter prestored in the electronic device.

### Manner 1:

The coupling parameter is between the transmitter coil and a receiver coil. A controller is further configured to: receive a self-inductance L2 that is of the receiver coil in a coupled state that is sent by the electronic device, and obtain the coupling parameter based on a current of the transmitter coil, a self-inductance L1 of the transmitter coil in the coupled state, L2, and a rectified voltage corresponding to the receiver coil.

### Manner 2:

The coupling parameter is between the transmitter coil and a receiver coil. A controller is further configured to: receive a self-inductance L20 that is of the receiver coil in an uncoupled state and that is sent by the electronic device; obtain a self-inductance L2 of the receiver coil in a coupled state based on a self-inductance L1 of the transmitter coil in the coupled state, a self-inductance L10 of the transmitter coil in the uncoupled state, and L20; and obtain the coupling parameter based on L1, L2, and a rectified voltage corresponding to the receiver coil.

### Manner 3:

The coupling parameter is between the transmitter coil and an auxiliary coil. The controller is further configured to: receive a self-inductance L3 of the auxiliary coil in a coupled state that is sent by the electronic device; and obtain the coupling parameter based on a current of the transmitter coil, a self-inductance L1 of the transmitter coil in the coupled state, L3, and a rectified voltage corresponding to the auxiliary coil.

### Manner 4:

The coupling parameter is between the transmitter coil and an auxiliary coil. The controller is further configured to: receive a self-inductance L30 that is of the auxiliary coil in an uncoupled state and that is sent by the electronic device; obtain a self-inductance L3 of the auxiliary coil in a coupled state based on a self-inductance L1 of the transmitter coil in the coupled state, a self-inductance L10 of the transmitter coil in the uncoupled state, and L30; and obtain the coupling parameter based on L1, L3, and a rectified voltage corresponding to the auxiliary coil.

According to the foregoing four manners of obtaining the coupling parameter, both manner 1 and manner 2 are between the transmitter coil and the receiver coil. Specifically, the electronic device parameter further includes the self-inductance of the receiver coil in the coupled state or the self-inductance of the receiver coil in the uncoupled state. Both manner 3 and manner 4 are between the transmitter coil and the auxiliary coil. Specifically, the electronic device parameter further includes the self-inductance of the auxiliary coil in the coupled state or the self-inductance of the auxiliary coil in the uncoupled state.

For obtaining of the current of the transmitter coil used when the coupling parameter is obtained, refer to the manners described in FIG. 11 and FIG. 12. Details are not described herein again.

S2204: Obtain, based on the coupling parameter and L1, the Q value threshold and the alternating current impedance that correspond to the current relative location based on the deviation relationship.

For example, the current horizontal relative location is obtained based on the coupling coefficient. The current vertical relative location is obtained based on L1. The corresponding Q value threshold and the alternating current impedance may be obtained based on the current horizontal relative location and the current vertical relative location by using the deviation relationship. The deviation relationship may be a primary function or a higher-order function, that is, the deviation relationship is a function expression of the location deviation and the Q value. Therefore, when the location deviation is known, the corresponding Q value may be obtained based on the known function expression.

S2205: Perform Q value foreign object detection based on the Q value threshold, and perform Ploss foreign object detection based on the alternating current impedance and the foregoing obtained coupling parameter in the coupled state.

For a specific implementation in which the wireless charging device uses the alternating current impedance and the coupling parameter when performing Ploss foreign object detection, refer to the description in the embodiment of the wireless charging device. Details are not described herein again.

The foreign object detection method provided in this embodiment of this application is applicable to a wireless charging device that does not have an automatic alignment function. Because the wireless charging device obtains the deviation relationship of the entire location space through fitting, even if there is a space location deviation between the transmitter coil and the receiver coil, the corresponding Q value threshold and the alternating current impedance under the deviation can be obtained, and then foreign object detection is performed. Accuracy of a foreign object detection result can also be ensured.

Embodiment 4 of the foreign object detection method:

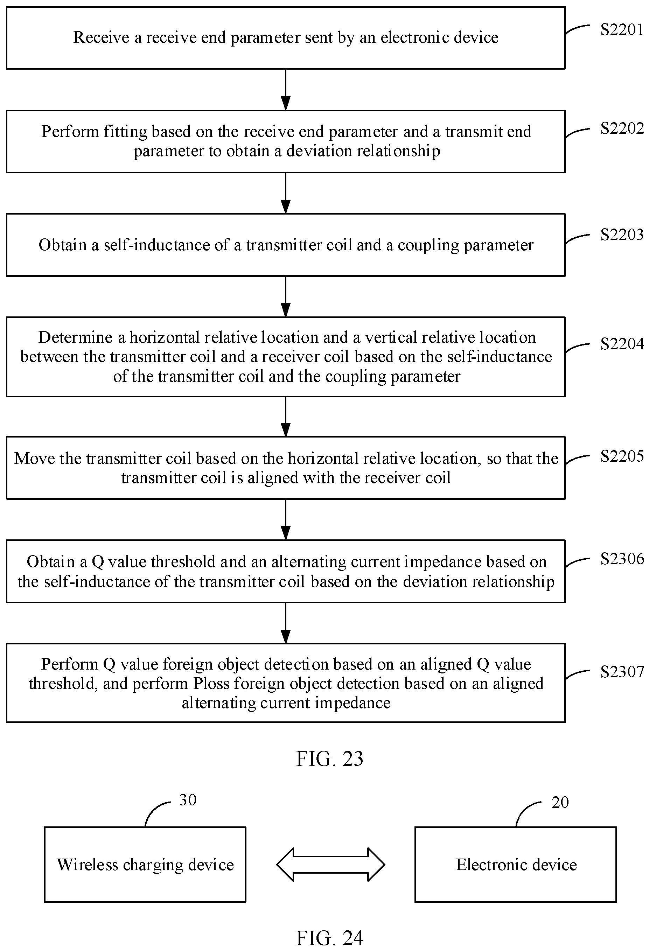

FIG. 23 is a flowchart of a foreign object detection method with alignment according to an embodiment of this application.

This embodiment describes a foreign object detection process when a wireless charging device has an automatic alignment function.

S2301: Receive an electronic device parameter sent by an electronic device.

The electronic device parameter may be various cases described in the foregoing method Embodiment 2, and details are not described herein again.

S2302: Perform fitting based on the electronic device parameter and a wireless charging device parameter to obtain a deviation relationship.

For the electronic device parameter, refer to the case described in the method Embodiment 2. For a specific fitting manner of the deviation relationship, refer to the description in the method Embodiment 2. Details are not described herein again.

S2303: Obtain a self-inductance of a transmitter coil and a coupling parameter in a coupled state, where the coupling parameter includes a coupling coefficient and a mutual inductance.

In an implementation, the coupling parameter is between the transmitter coil and a receiver coil, and the coupling parameter is obtained based on a current of the transmitter coil, a self-inductance of the transmitter coil, a self-inductance of the receiver coil, and a rectified voltage corresponding to the receiver coil.

In another implementation, the coupling parameter is between the transmitter coil and an auxiliary coil, and the coupling parameter is obtained based on a current of the transmitter coil, a self-inductance of the transmitter coil, a self-inductance of the auxiliary coil, and a rectified voltage corresponding to the auxiliary coil.

S2304: Determine a horizontal relative location and a vertical relative location between the transmitter coil and the receiver coil based on the self-inductance of the transmitter coil and the coupling parameter.

S2305: Move the transmitter coil based on the horizontal relative location, so that the transmitter coil is aligned with the receiver coil.

The moving the transmitter coil based on the horizontal relative location, so that the transmitter coil is aligned with the receiver coil specifically includes:
obtaining a first circumference and a second circumference of two horizontal relative locations corresponding to two different locations that are respectively radiuses;
obtaining an intersection point of the first circumference and the second circumference, and controlling the transmitter coil to align with the intersection point;
moving the transmitter coil to a third location, where the third location is different from the two different locations; and
obtaining at least one of the following parameters in a movement process, and determining, based on a change trend of the at least one parameter, that the transmitter coil is aligned with the intersection point, where the at least one parameter includes the coupling parameter, charging efficiency, the self-inductance of the transmitter coil, the current of the transmitter coil, and an output voltage of a receive end.

There is a first monotonic relationship between the self-inductance of the transmitter coil and the vertical relative location. There is a second monotonic relationship between the at least one coupling parameter and the horizontal relative location.

S2306: Obtain a Q value threshold based on the self-inductance of the transmitter coil by using the deviation relationship, and obtain a corresponding alternating current impedance based on the Q value threshold and a correspondence between a Q value and an alternating current impedance of the transmitter coil.

S2307: Perform Q value foreign object detection based on an aligned Q value threshold before a wireless charging device charges the electronic device, and perform Ploss foreign object detection based on an aligned alternating current impedance value in a process in which the wireless charging device charges the electronic device.

According to the foreign object detection method provided in this embodiment of this application, fitting of the deviation relationship in the entire space can be implemented, linearization of the Q value can be implemented, and normalization of different electronic devices can be implemented. In addition, the wireless charging device has the automatic alignment function. After automatic alignment, there may be a slight deviation. Therefore, the corresponding Q value threshold and the corresponding alternating current impedance after alignment may be obtained based on the aligned relative position by using the deviation relationship, and then Q value foreign object detection and Ploss foreign object detection are performed, thereby further ensuring accuracy of a foreign object detection result.

In addition, after the transmitter coil is aligned, when the horizontal deviation between the transmitter coil and the receiver coil is very small and can be ignored, impact of the horizontal deviation may not be considered, and only impact of the vertical deviation needs to be considered. To be specific, in another implementation, the coupling parameter after alignment is obtained, and when it is determined, based on the coupling parameter, that the horizontal relative location after alignment is within a preset deviation range, the vertical relative location after alignment is obtained based on the self-inductance of the transmitter coil after alignment. To be specific, after the transmitter coil is aligned with the receiver coil, the method further includes: obtaining the Q value threshold and the alternating current impedance based on the self-inductance of the transmitter coil by using the deviation relationship; and performing Q value foreign object detection based on the Q value threshold, and performing Ploss foreign object detection based on the alternating current impedance and the coupling parameter.

Based on the wireless charging device, the wireless charging cradle, and the wireless charging foreign object detection method provided in the foregoing embodiments, an embodiment of this application further provides a wireless charging system. The following provides detailed descriptions with reference to the accompanying drawings.

Embodiment 1 of the wireless charging system:
FIG. 24 is a schematic diagram of a wireless charging system according to an embodiment of this application.

The wireless charging system provided in this embodiment of this application includes the wireless charging device 30 described in the foregoing embodiment, and further includes an electronic device 20.

The electronic device 20 includes a receiver coil and a rectifier circuit. For a structure of the electronic device, refer to FIG. 3.

The wireless charging device 30 is configured to wirelessly charge the electronic device 20.

The wireless charging device 30 may be a wireless charging cradle. The electronic device 20 may be a mobile phone or a wearable device. The wearable device may be, for example, a watch.

According to the wireless charging system provided in this embodiment of this application, the wireless charging device prestores the wireless charging device parameter. The electronic device prestores the electronic device parameter. The electronic device sends the prestored electronic device parameter to the wireless charging device. The wireless charging device fits the deviation relationship of the Q value in the entire space based on the wireless charging device parameter and the electronic device parameter, to implement linearization between the Q value and the entire space and normalization of different electronic devices, so that the Q value threshold and the alternating current impedance can be obtained based on an actual relative location by using the deviation relationship. The wireless charging device performs Q value foreign object detection based on the Q value threshold, and performs Ploss foreign object detection based on the alternating current impedance. The wireless charging device does not need to store the correspondence between the Q value and the entire location space, and similarly, does not need to store the correspondence between the alternating current impedance of the transmitter coil and the entire location space. The wireless charging device may obtain, through fitting, the correspondence between the Q value and the entire location space based on only a limited quantity of parameters, thereby reducing requirements for hardware performance and storage space.

It should be understood that in this application, "at least one (item)" refers to one or more and "a plurality of" refers to two or more. The term "and/or" is used for describing an association relationship between associated objects, and represents that three relationships may exist. For example, "A and/or B" may represent the following three cases: Only A exists, only B exists, and both A and B exist, where A and B may be singular or plural. The character "/" generally indicates an "or" relationship between the associated objects. "At least one of the following items (pieces)" or a similar expression thereof refers to any combination of these items, including any combination of singular items (pieces) or plural items (pieces). For example, at least one of a, b, or c may indicate a, b, c, a and b, a and c, b and c, or a, b, and c, where a, b, and c may be singular or plural.

The foregoing descriptions are merely example embodiments of this application, but are not intended to limit this application in any form. Although the example embodiments of this application are disclosed above, embodiments are not intended to limit this application. By using the method and the technical content disclosed above, any person of ordinary skill in the art can make a plurality of possible changes and modifications on the technical solutions of this application, or amend the technical solutions thereof to be embodiments with equal effects through equivalent variations without departing from the protection scope of the technical solutions of this application. Therefore, any simple amendment, equivalent variation, and modification made on the above embodiments according to the technical essence of this application without departing from the content of the technical solutions of this application shall fall within the protection scope of the technical solutions of this application.

## Claims

1. A wireless charging device, wherein the wireless charging device is configured to wirelessly charge an electronic device, and the wireless charging device comprises a resonant network, an inverter circuit (31), and a controller (32);
the resonant network comprises a resonant capacitor (C1) and a transmitter coil (L1);
an input of the inverter circuit (31) is configured to connect to a direct current power supply, and an output of the inverter circuit (31) is configured to connect to the resonant network;
the controller (32) is configured to: receive an electronic device parameter sent by the electronic device, and fit a deviation relationship between a Q value of the wireless charging device and a location space based on a wireless charging device parameter and the electronic device parameter, wherein the location space is location space between the transmitter coil (L1) and a receiver coil of the electronic device, the electronic device parameter comprises a Q1 value of the wireless charging device and a resonance frequency f1 of the resonant network when there is no foreign object at at least one relative location between the transmitter coil (L1) and the receiver coil, and the wireless charging device parameter comprises an initial Q value Q0 of the wireless charging device and an initial resonance frequency f0 of the resonant network when the wireless charging device and the electronic device are in an uncoupled state, wherein the relative location between the transmitter coil (L1) and the receiver coil is the location deviation between the center of the transmitter coil and the center of the receiver coil, and the deviation relationship is a correspondence between the Q value and the horizontal relative location and the vertical relative location between the transmitter coil (L1) and the receiver coil; and
the controller (32) is further configured to perform foreign object detection based on the deviation relationship,
wherein the controller (32) is further configured to: obtain the Q value threshold based on the deviation relationship, obtain a corresponding alternating current impedance based on the Q value threshold and a correspondence between the Q value and the alternating current impedance of the transmitter coil (L1), and perform Ploss foreign object detection based on the obtained alternating current impedance in a process in which the wireless charging device charges the electronic device, and
wherein either (a):
the electronic device parameter comprises the following Q1 values and f1 at at least two relative locations between the transmitter coil (L1) and the receiver coil: Q11 and f11 at a first location, and Q12 and f12 at a second location, and the deviation relationship comprises a radial horizontal relationship between the transmitter coil (L1) and the receiver coil and a vertical relationship between a plane on which the transmitter coil (L1) is located and a plane on which the receiver coil is located;
the controller (32) is further configured to: fit the horizontal relationship between the Q value and the location space based on Q11, f11, Q12, and f12; and fit the vertical relationship between the Q value and the location space in any one of the following manners: fitting the vertical relationship between the Q value and the location space based on f0, Q0, Q11, and f11; fitting the vertical relationship between the Q value and the location space based on f0, Q0, Q12, and f12; or fitting the vertical relationship between the Q value and the location space based on Q0, f0, and Q and f that correspond to at least one point in the horizontal relationship; and
obtain the Q value threshold based on the horizontal relationship and the vertical relationship, and obtain the corresponding alternating current impedance based on the Q value threshold and the correspondence between the Q value and the alternating current impedance of the transmitter coil (L1),
or wherein (b):
the deviation relationship comprises a radial horizontal relationship between the transmitter coil (L1) and the receiver coil and a vertical relationship between a plane on which the transmitter coil (L1) is located and a plane on which the receiver coil is located;
the electronic device parameter further comprises a prestored coupling parameter when there is no foreign object at the at least one relative location between the transmitter coil (L1) and the receiver coil, and the prestored coupling parameter comprises at least one of the following: a coupling coefficient and a mutual inductance between the transmitter coil (L1) and the receiver coil; and
the controller (32) is further configured to: fit the vertical relationship between the Q value and the location space based on f0, Q0, and the Q value and f at the at least one relative location between the transmitter coil (L1) and the receiver coil; fit the horizontal relationship between the Q value and the location space based on the prestored coupling parameter and the Q value at the at least one relative location between the transmitter coil (L1) and the receiver coil; and obtain the Q value threshold based on the vertical relationship and the horizontal relationship, and obtain the corresponding alternating current impedance based on the Q value threshold and the correspondence between the Q value and the alternating current impedance of the transmitter coil (L1),
or wherein (c):
the electronic device parameter comprises the following Q1 values and f1 at at least two relative locations between the transmitter coil (L1) and the receiver coil: Q11 and f11 at a first location, and Q12 and f12 at a second location;
the deviation relationship comprises a radial horizontal relationship between the transmitter coil (L1) and the receiver coil and a vertical relationship between a plane on which the transmitter coil (L1) is located and a plane on which the receiver coil is located;
the electronic device parameter further comprises a prestored coupling parameter at the first location and a prestored coupling parameter at the second location, and the prestored coupling parameter comprises at least one of the following: a coupling coefficient and a mutual inductance between the transmitter coil (L1) and the receiver coil; and
the controller (32) is further configured to: fit the horizontal relationship between the Q value and the location space based on Q11, Q12, the prestored coupling parameter at the first location, and the prestored coupling parameter at the second location;
fit the vertical relationship between the Q value and the location space in any one of the following manners: fitting the vertical relationship between the Q value and the location space based on f0, Q0, Q11, and f11; fitting the vertical relationship between the Q value and the location space based on f0, Q0, Q12, and f12; or fitting the vertical relationship between the Q value and the location space based on Q0, f0, and Q and f that correspond to at least one point in the horizontal relationship; and
obtain the Q value threshold based on the vertical relationship and the horizontal relationship, and obtain the corresponding alternating current impedance based on the Q value threshold and the correspondence between the Q value and the alternating current impedance of the transmitter coil (L1).

2. The wireless charging device according to claim 1, wherein the controller (32) is further configured to: obtain a Q value threshold based on the deviation relationship, and perform Q value foreign object detection based on the Q value threshold before the wireless charging device charges the electronic device.

3. The wireless charging device according to claim 1 or 2, wherein the controller (32) is further configured to: obtain the Q value threshold based on the vertical relationship and a resonance frequency of the resonant network or a self-inductance of the transmitter coil (L1) at a current relative location between the wireless charging device and the electronic device, and obtain the corresponding alternating current impedance based on the Q value threshold and the correspondence between the Q value and the alternating current impedance of the transmitter coil (L1).

4. The wireless charging device according to claim 1, wherein the controller (32) is further configured to: obtain a coupling parameter and a self-inductance L1 of the transmitter coil (L1) when the wireless charging device and the electronic device are in a coupled state, wherein the coupling parameter in the coupled state comprises at least one of the following: the coupling coefficient and the mutual inductance between the transmitter coil (L1) and the receiver coil; and
obtain the Q value threshold based on the coupling parameter in the coupled state, L1, and the deviation relationship, and obtain the corresponding alternating current impedance based on the Q value threshold and the correspondence between the Q value and the alternating current impedance of the transmitter coil (L1), wherein there is a monotonic relationship between the coupling parameter in the coupled state and the horizontal relationship, and there is a monotonic relationship between L1 and the vertical relationship.

5. The wireless charging device according to claim 4, wherein the controller (32) is further configured to: receive a self-inductance L2 that is of the receiver coil when the wireless charging device and the electronic device are in the coupled state and that is sent by the electronic device, and obtain the coupling parameter in the coupled state based on a current of the transmitter coil (L1), the self-inductance L1 of the transmitter coil (L1) in the coupled state, L2, and a rectified voltage corresponding to the receiver coil.

6. The wireless charging device according to claim 4, wherein the controller (32) is further configured to: receive a self-inductance L20 that is of the receiver coil when the wireless charging device and the electronic device are in the uncoupled state and that is sent by the electronic device, obtain the self-inductance L2 of the receiver coil in the coupled state based on the self-inductance L1 of the transmitter coil (L1) in the coupled state, a self-inductance L10 of the transmitter coil (L1) in the uncoupled state, and L20, and obtain the coupling parameter in the coupled state based on L1, L2, and a rectified voltage corresponding to the receiver coil.

7. The wireless charging device according to claim 4, wherein the controller (32) is further configured to: receive a self-inductance L3 that is of an auxiliary coil when the wireless charging device and the electronic device are in the coupled state and that is sent by the electronic device, and obtain the coupling parameter in the coupled state based on a current of the transmitter coil (L1), the self-inductance L1 of the transmitter coil (L1) in the coupled state, L3, and a rectified voltage corresponding to the auxiliary coil.

8. The wireless charging device according to claim 4, wherein the controller (32) is further configured to: receive a self-inductance L30 that is of an auxiliary coil when the wireless charging device and the electronic device are in the uncoupled state and that is sent by the electronic device, obtain a self-inductance L3 of the auxiliary coil in the coupled state based on the self-inductance L1 of the transmitter coil (L1) in the coupled state, a self-inductance L10 of the transmitter coil (L1) in the uncoupled state, and L30, and obtain the coupling parameter in the coupled state based on L1, L3, and a rectified voltage corresponding to the auxiliary coil.

9. The wireless charging device according to any one of claims 1 to 8, wherein the controller is further configured to obtain the coupling parameter obtained when the wireless charging device and the electronic device are in the coupled state, and is further configured to perform Ploss foreign object detection based on the alternating current impedance and the coupling parameter in the coupled state.

10. The wireless charging device according to any one of claims 1 to 8, further comprising a current detection circuit of the transmitter coil;
the current detection circuit is configured to detect a voltage difference between two ends of the resonant capacitor; and
the controller is configured to obtain the current of the transmitter coil based on the voltage difference.

11. The wireless charging device according to claim 10, wherein the current detection circuit comprises a first voltage detection circuit, a second voltage detection circuit, and a differential circuit;
the first voltage detection circuit is configured to detect a first voltage at a first end of the resonant capacitor, divide the first voltage, and send a divided first voltage to a first input of the differential circuit;
the second voltage detection circuit is configured to detect a second voltage at a second end of the resonant capacitor, divide the second voltage, and send a divided second voltage to a second input of the differential circuit;
the differential circuit is configured to obtain a differential result of the voltage input at the first input and the voltage input at the second input; and
the controller is configured to obtain the current of the transmitter coil based on the differential result.

12. The wireless charging device according to any one of claims 4 to 10, wherein the controller is further configured to: determine the horizontal relative location and the vertical relative location between the transmitter coil and the receiver coil based on the self-inductance of the transmitter coil and the coupling parameter, and move the transmitter coil based on the horizontal relative location, so that the transmitter coil is aligned with the receiver coil; and
there is a monotonic relationship between the self-inductance of the transmitter coil and the vertical relative location, and there is a monotonic relationship between the coupling parameter and the horizontal relative location.

13. The wireless charging device according to claim 12, wherein the controller is further configured to: obtain two horizontal relative locations corresponding to two different relative locations between the wireless charging device and the electronic device, obtain a first circumference and a second circumference that respectively use the two horizontal relative locations as radiuses, obtain an intersection point of the first circumference and the second circumference, and control the transmitter coil to be aligned with the intersection point.

14. A wireless charging cradle, configured to wirelessly charge an electronic device, and comprising a power interface, a resonant network, an inverter circuit, a controller, and a transmitter coil chassis;
the power interface is configured to connect a direct current transmitted by an adapter;
the resonant network comprises a resonant capacitor and a transmitter coil;
the transmitter coil chassis is configured to place the transmitter coil;
an input of the inverter circuit is configured to connect to the power interface, and an output of the inverter circuit is configured to connect to the resonant network;
the controller is configured to: receive an electronic device parameter sent by the electronic device, and fit a deviation relationship between a Q value of the wireless charging device and a location space based on a wireless charging device parameter and the electronic device parameter, wherein the location space is location space between the transmitter coil and a receiver coil of the electronic device, the electronic device parameter comprises a Q1 value of the wireless charging device and a resonance frequency f1 of the resonant network when there is no foreign object at at least one relative location between the transmitter coil and the receiver coil, and the wireless charging device parameter comprises an initial Q value Q0 of the wireless charging device and an initial resonance frequency f0 of the resonant network when the wireless charging device and the electronic device are in an uncoupled state, wherein the relative location between the transmitter coil and the receiver coil is the location deviation between the center of the transmitter coil and the center of the receiver coil, and the deviation relationship is a correspondence between the Q value and the horizontal relative location and the vertical relative location between the transmitter coil and the receiver coil; and
the controller is further configured to perform foreign object detection based on the deviation relationship,
wherein the controller is further configured to: obtain the Q value threshold based on the deviation relationship, obtain a corresponding alternating current impedance based on the Q value threshold and a correspondence between the Q value and the alternating current impedance of the transmitter coil, and perform Ploss foreign object detection based on the obtained alternating current impedance in a process in which the wireless charging device charges the electronic device, and
wherein either (a):
the electronic device parameter comprises the following Q1 values and f1 at at least two relative locations between the transmitter coil and the receiver coil: Q11 and f11 at a first location, and Q12 and f12 at a second location, and the deviation relationship comprises a radial horizontal relationship between the transmitter coil and the receiver coil and a vertical relationship between a plane on which the transmitter coil is located and a plane on which the receiver coil is located;
the controller is further configured to: fit the horizontal relationship between the Q value and the location space based on Q11, f11, Q12, and f12; and fit the vertical relationship between the Q value and the location space in any one of the following manners: fitting the vertical relationship between the Q value and the location space based on f0, Q0, Q11, and f11; fitting the vertical relationship between the Q value and the location space based on f0, Q0, Q12, and f12; or fitting the vertical relationship between the Q value and the location space based on Q0, f0, and Q and f that correspond to at least one point in the horizontal relationship; and
obtain the Q value threshold based on the horizontal relationship and the vertical relationship, and obtain the corresponding alternating current impedance based on the Q value threshold and the correspondence between the Q value and the alternating current impedance of the transmitter coil,
or wherein (b):
the deviation relationship comprises a radial horizontal relationship between the transmitter coil and the receiver coil and a vertical relationship between a plane on which the transmitter coil is located and a plane on which the receiver coil is located;
the electronic device parameter further comprises a prestored coupling parameter when there is no foreign object at the at least one relative location between the transmitter coil and the receiver coil, and the prestored coupling parameter comprises at least one of the following: a coupling coefficient and a mutual inductance between the transmitter coil and the receiver coil; and
the controller is further configured to: fit the vertical relationship between the Q value and the location space based on f0, Q0, and the Q value and f at the at least one relative location between the transmitter coil and the receiver coil; fit the horizontal relationship between the Q value and the location space based on the prestored coupling parameter and the Q value at the at least one relative location between the transmitter coil and the receiver coil; and obtain the Q value threshold based on the vertical relationship and the horizontal relationship, and obtain the corresponding alternating current impedance based on the Q value threshold and the correspondence between the Q value and the alternating current impedance of the transmitter coil,
or wherein (c):
the electronic device parameter comprises the following Q1 values and f1 at at least two relative locations between the transmitter coil and the receiver coil: Q11 and f11 at a first location, and Q12 and f12 at a second location;
the deviation relationship comprises a radial horizontal relationship between the transmitter coil and the receiver coil and a vertical relationship between a plane on which the transmitter coil is located and a plane on which the receiver coil is located;
the electronic device parameter further comprises a prestored coupling parameter at the first location and a prestored coupling parameter at the second location, and the prestored coupling parameter comprises at least one of the following: a coupling coefficient and a mutual inductance between the transmitter coil and the receiver coil; and
the controller is further configured to: fit the horizontal relationship between the Q value and the location space based on Q11, Q12, the prestored coupling parameter at the first location, and the prestored coupling parameter at the second location;
fit the vertical relationship between the Q value and the location space in any one of the following manners: fitting the vertical relationship between the Q value and the location space based on f0, Q0, Q11, and f11; fitting the vertical relationship between the Q value and the location space based on f0, Q0, Q12, and f12; or fitting the vertical relationship between the Q value and the location space based on Q0, f0, and Q and f that correspond to at least one point in the horizontal relationship; and
obtain the Q value threshold based on the vertical relationship and the horizontal relationship, and obtain the corresponding alternating current impedance based on the Q value threshold and the correspondence between the Q value and the alternating current impedance of the transmitter coil.

15. A foreign object detection method for wireless charging, applied to a wireless charging device, wherein the wireless charging device comprises a resonant network and an inverter circuit, the resonant network comprises a resonant capacitor and a transmitter coil, an input of the inverter circuit is configured to connect to a direct current power supply, and an output of the inverter circuit is configured to connect to the resonant network; and
the method comprises:
receiving an electronic device parameter sent by the electronic device (S1601);
fitting a deviation relationship between a Q value of the wireless charging device and a location space based on a wireless charging device parameter and the electronic device parameter (S1602), wherein the location space is location space between the transmitter coil and a receiver coil of the electronic device, the electronic device parameter comprises a Q1 value of the wireless charging device and a resonance frequency f1 of the resonant network when there is no foreign object at at least one relative location between the transmitter coil and the receiver coil, and the wireless charging device parameter is comprises an initial Q value Q0 of the wireless charging device and an initial resonance frequency f0 of the resonant network when the wireless charging device and the electronic device are in an uncoupled state, wherein the relative location between the transmitter coil and the receiver coil is the location deviation between the center of the transmitter coil and the center of the receiver coil, and the deviation relationship is a correspondence between the Q value and the horizontal relative location and the vertical relative location between the transmitter coil and the receiver coil; and
performing foreign object detection based on the deviation relationship (S1603),
wherein the performing foreign object detection based on the deviation relationship comprises:
obtaining the Q value threshold based on the deviation relationship;
obtaining a corresponding alternating current impedance based on the Q value threshold and a correspondence between the Q value and the alternating current impedance of the transmitter coil; and
performing Ploss foreign object detection based on the obtained alternating current impedance in a process in which the wireless charging device charges the electronic device, and
wherein either (a):
the electronic device parameter comprises the following Q1 values and f1 at at least two relative locations between the transmitter coil and the receiver coil: Q11 and f11 at a first location, and Q12 and f12 at a second location, and the deviation relationship comprises a radial horizontal relationship between the transmitter coil and the receiver coil and a vertical relationship between a plane on which the transmitter coil is located and a plane on which the receiver coil is located;
the fitting a deviation relationship between a Q value of the wireless charging device and a location space based on a wireless charging device parameter and the electronic device parameter comprises:
fitting the horizontal relationship between the Q value and the location space based on Q11, f11, Q12, and f12; and fitting the vertical relationship between the Q value and the location space in any one of the following manners: fitting the vertical relationship between the Q value and the location space based on f0, Q0, Q11, and f11; fitting the vertical relationship between the Q value and the location space based on f0, Q0, Q12, and f12; or fitting the vertical relationship between the Q value and the location space based on Q0, f0, and Q and f that correspond to at least one point in the horizontal relationship; and
the obtaining the Q value threshold based on the deviation relationship comprises:
obtaining the Q value threshold based on the horizontal relationship and the vertical relationship,
or wherein (b):
the deviation relationship comprises a radial horizontal relationship between the transmitter coil and the receiver coil and a vertical relationship between a plane on which the transmitter coil is located and a plane on which the receiver coil is located, the electronic device parameter further comprises a prestored coupling parameter when there is no foreign object at the at least one relative location between the transmitter coil and the receiver coil, and the prestored coupling parameter comprises at least one of the following: a coupling coefficient and a mutual inductance between the transmitter coil and the receiver coil;
the fitting a deviation relationship between a Q value of the wireless charging device and a location space based on a wireless charging device parameter and the electronic device parameter comprises:
fitting the vertical relationship between the Q value and the location space based on f0, Q0, and the Q value and f at the at least one relative location between the transmitter coil and the receiver coil, and fitting the horizontal relationship between the Q value and the location space based on the prestored coupling parameter and the Q value at the at least one relative location between the transmitter coil and the receiver coil; and
the obtaining the Q value threshold based on the deviation relationship comprises:
obtaining the Q value threshold based on the vertical relationship and the horizontal relationship,
or wherein (c):
the electronic device parameter comprises the following Q1 values and f1 at at least two relative locations between the transmitter coil and the receiver coil: Q11 and f11 at a first location, and Q12 and f12 at a second location, the deviation relationship comprises a radial horizontal relationship between the transmitter coil and the receiver coil and a vertical relationship between a plane on which the transmitter coil is located and a plane on which the receiver coil is located, the electronic device parameter further comprises a prestored coupling parameter at the first location and a prestored coupling parameter at the second location, and the prestored coupling parameter comprises at least one of the following: a coupling coefficient and a mutual inductance between the transmitter coil and the receiver coil; and
the fitting a deviation relationship between a Q value of the wireless charging device and a location space based on a wireless charging device parameter and the electronic device parameter comprises:
fitting the horizontal relationship between the Q value and the location space based on Q11, Q12, the prestored coupling parameter at the first location, and the prestored coupling parameter at the second location; and fitting the vertical relationship between the Q value and the location space in any one of the following manners: fitting the vertical relationship between the Q value and the location space based on f0, Q0, Q11, and f11; fitting the vertical relationship between the Q value and the location space based on f0, Q0, Q12, and f12; or fitting the vertical relationship between the Q value and the location space based on Q0, f0, and Q and f that correspond to at least one point in the horizontal relationship; and
the obtaining the Q value threshold based on the deviation relationship comprises:
obtaining the Q value threshold based on the vertical relationship and the horizontal relationship.

## Patentansprüche

1. Drahtlosladevorrichtung, wobei die Drahtlosladevorrichtung konfiguriert ist, um eine elektronische Vorrichtung drahtlos aufzuladen, und die Drahtlosladevorrichtung ein Resonanznetzwerk, eine Umrichterschaltung (31) und eine Steuerung (32) umfasst; das Resonanznetzwerk einen Resonanzkondensator (C1) und eine Senderspule (L1) umfasst;
ein Eingang der Umrichterschaltung (31) konfiguriert ist, um mit einer Gleichstrom-Leistungsversorgung verbunden zu werden, und ein Ausgang der Umrichterschaltung (31) konfiguriert ist, um mit dem Resonanznetzwerk verbunden zu werden;
die Steuerung (32) konfiguriert ist zum: Empfangen eines von der elektronischen Vorrichtung übermittelten Parameters der elektronischen Vorrichtung und Anpassen einer Abweichungsbeziehung zwischen einem Q-Wert der Drahtlosladevorrichtung und einem Positionsraum basierend auf einem Parameter der Drahtlosladevorrichtung und dem Parameter der elektronischen Vorrichtung, wobei der Positionsraum ein Positionsraum zwischen der Senderspule (L1) und einer Empfängerspule der elektronischen Vorrichtung ist, der Parameter der elektronischen Vorrichtung einen Q1-Wert der Drahtlosladevorrichtung und eine Resonanzfrequenz f1 des Resonanznetzwerks umfasst, wenn kein Fremdobjekt an mindestens einer relativen Position zwischen der Senderspule (L1) und der Empfängerspule vorliegt, und der Parameter der Drahtlosladevorrichtung einen anfänglichen Q-Wert Q0 der Drahtlosladevorrichtung und eine anfängliche Resonanzfrequenz f0 des Resonanznetzwerks umfasst, wenn die Drahtlosladevorrichtung und die elektronische Vorrichtung in einem entkoppelten Zustand sind, wobei die relative Position zwischen der Senderspule (L1) und der Empfängerspule die Positionsabweichung zwischen der Mitte der Senderspule und der Mitte der Empfängerspule ist, und die Abweichungsbeziehung eine Entsprechung zwischen dem Q-Wert und der horizontalen relativen Position und der vertikalen relativen Position zwischen der Senderspule (L1) und der Empfängerspule ist; und
die Steuerung (32) ferner konfiguriert ist, um basierend auf der Abweichungsbeziehung eine Fremdobjekterfassung durchzuführen, wobei die Steuerung (32) ferner konfiguriert ist zum: Erhalten des Q-Wert-Schwellenwerts basierend auf der Abweichungsbeziehung, Erhalten einer entsprechenden Wechselstromimpedanz basierend auf dem Q-Wert-Schwellenwert und einer Entsprechung zwischen dem Q-Wert und der Wechselstromimpedanz der Senderspule (L1), und Durchführen einer Ploss-Fremdobjekterfassung basierend auf der erhaltenen Wechselstromimpedanz in einem Prozess, in dem die Drahtlosladevorrichtung die elektronische Vorrichtung auflädt, und wobei entweder (a): der Parameter der elektronischen Vorrichtung die folgenden Q1-Werte und f1 an mindestens zwei relativen Positionen zwischen der Senderspule (L1) und der Empfängerspule umfasst: Q11 und f11 an einer ersten Position, und Q12 und f12 an einer zweiten Position, und die Abweichungsbeziehung eine radiale horizontale Beziehung zwischen der Senderspule (L1) und der Empfängerspule und eine vertikale Beziehung zwischen einer Ebene, auf der sich die Senderspule (L1) befindet, und einer Ebene, auf der sich die Empfängerspule befindet, umfasst;
die Steuerung (32) ferner konfiguriert ist zum: Anpassen der horizontalen Beziehung zwischen dem Q-Wert und dem Positionsraum basierend auf Q11, f11, Q12 und f12;
und Anpassen der vertikalen Beziehung zwischen dem Q-Wert und dem Positionsraum auf eine beliebige der folgenden Weisen: Anpassen der vertikalen Beziehung zwischen dem Q-Wert und dem Positionsraum basierend auf f0, Q0, Q11 und f11; Anpassen der vertikalen Beziehung zwischen dem Q-Wert und dem Positionsraum basierend auf f0, Q0, Q12 und f12; oder Anpassen der vertikalen Beziehung zwischen dem Q-Wert und dem Positionsraum basierend auf Q0, f0 und Q und f, die mindestens einem Punkt in der horizontalen Beziehung entsprechen; und Erhalten des Q-Wert-Schwellenwerts basierend auf der horizontalen Beziehung und der vertikalen Beziehung, und Erhalten der entsprechenden Wechselstromimpedanz basierend auf dem Q-Wert-Schwellenwert und der Entsprechung zwischen dem Q-Wert und der Wechselstromimpedanz der Senderspule (L1), oder wobei (b):
die Abweichungsbeziehung eine radiale horizontale Beziehung zwischen der Senderspule (L1) und der Empfängerspule und eine vertikale Beziehung zwischen einer Ebene, auf der sich die Senderspule (L1) befindet, und einer Ebene, auf der sich die Empfängerspule befindet, umfasst;
der Parameter der elektronischen Vorrichtung ferner einen vorgespeicherten Kopplungsparameter umfasst, wenn kein Fremdobjekt an der mindestens einen relativen Position zwischen der Senderspule (L1) und der Empfängerspule vorliegt, und der vorgespeicherte Kopplungsparameter mindestens eines der Folgenden umfasst: einen Kopplungskoeffizienten und eine Gegeninduktivität zwischen der Senderspule (L1) und der Empfängerspule; und
die Steuerung (32) ferner konfiguriert ist zum: Anpassen der vertikalen Beziehung zwischen dem Q-Wert und dem Positionsraum basierend auf f0, Q0 und dem Q-Wert und f an der mindestens einen relativen Position zwischen der Senderspule (L1) und der Empfängerspule: Anpassen der horizontalen Beziehung zwischen dem Q-Wert und dem Positionsraum basierend auf dem vorgespeicherten Kopplungsparameter und dem Q-Wert an der mindestens einen relativen Position zwischen der Senderspule (L1) und der Empfängerspule; und Erhalten des Q-Wert-Schwellenwerts basierend auf der vertikalen Beziehung und der horizontalen Beziehung, und Erhalten der entsprechenden Wechselstromimpedanz basierend auf dem Q-Wert-Schwellenwert und der Entsprechung zwischen dem Q-Wert und der Wechselstromimpedanz der Senderspule (L1), oder wobei (c):
der Parameter der elektronischen Vorrichtung die folgenden Q1-Werte und f1 an mindestens zwei relativen Positionen zwischen der Senderspule (L1) und der Empfängerspule umfasst: Q11 und f11 an einer ersten Position, und Q12 und f12 an einer zweiten Position;
die Abweichungsbeziehung eine radiale horizontale Beziehung zwischen der Senderspule (L1) und der Empfängerspule und eine vertikale Beziehung zwischen einer Ebene, auf der sich die Senderspule (L1) befindet, und einer Ebene, auf der sich die Empfängerspule befindet, umfasst;
der Parameter der elektronischen Vorrichtung ferner einen vorab gespeicherten Kopplungsparameter an der ersten Position und einen vorab gespeicherten Kopplungsparameter an der zweiten Position umfasst, und der vorab gespeicherte Kopplungsparameter mindestens eines der Folgenden umfasst: einen Kopplungskoeffizienten und eine Gegeninduktivität zwischen der Senderspule (L1) und der Empfängerspule; und
die Steuerung (32) ferner konfiguriert ist zum: Anpassen der horizontalen Beziehung zwischen dem Q-Wert und dem Positionsraum basierend auf Q11, Q12, dem vorab gespeicherten Kopplungsparameter an der ersten Position und dem vorab gespeicherten Kopplungsparameter an der zweiten Position;
Anpassen der vertikalen Beziehung zwischen dem Q-Wert und dem Positionsraum auf eine beliebige der folgenden Weisen: Anpassen der vertikalen Beziehung zwischen dem Q-Wert und dem Positionsraum basierend auf f0, Q0, Q11 und f11; Anpassen der vertikalen Beziehung zwischen dem Q-Wert und dem Positionsraum basierend auf f0, Q0, Q12 und f12; oder Anpassen der vertikalen Beziehung zwischen dem Q-Wert und dem Positionsraum basierend auf Q0, f0 und Q und f, die mindestens einem Punkt in der horizontalen Beziehung entsprechen; und
Erhalten des Q-Wert-Schwellenwerts basierend auf der vertikalen Beziehung und der horizontalen Beziehung, und Erhalten der entsprechenden Wechselstromimpedanz basierend auf dem Q-Wert-Schwellenwert und der Entsprechung zwischen dem Q-Wert und der Wechselstromimpedanz der Senderspule (L1).

2. Drahtlosladevorrichtung nach Anspruch 1, wobei die Steuerung (32) ferner konfiguriert ist zum: Erhalten eines Q-Wert-Schwellenwerts basierend auf der Abweichungsbeziehung, und Durchführen einer Q-Wert-Fremdobjekterfassung basierend auf dem Q-Wert-Schwellenwert, bevor die Drahtlosladevorrichtung die elektronische Vorrichtung auflädt.

3. Drahtlosladevorrichtung nach Anspruch 1 oder 2, wobei die Steuerung (32) ferner konfiguriert ist zum: Erhalten des Q-Wert-Schwellenwerts basierend auf der vertikalen Beziehung und einer Resonanzfrequenz des Resonanznetzwerks oder einer Selbstinduktivität der Senderspule (L1) an einer aktuellen relativen Position zwischen der Drahtlosladevorrichtung und der elektronischen Vorrichtung, und Erhalten der entsprechenden Wechselstromimpedanz basierend auf dem Q-Wert-Schwellenwert und der Entsprechung zwischen dem Q-Wert und der Wechselstromimpedanz der Senderspule (L1).

4. Drahtlosladevorrichtung nach Anspruch 1, wobei die Steuerung (32) ferner konfiguriert ist zum: Erhalten eines Kopplungsparameters und einer Selbstinduktivität L1 der Senderspule (L1), wenn die Drahtlosladevorrichtung und die elektronische Vorrichtung in einem gekoppelten Zustand sind, wobei der Kopplungsparameter in dem gekoppelten Zustand mindestens eines der Folgenden umfasst: den Kopplungskoeffizienten und die Gegeninduktivität zwischen der Senderspule (L1) und der Empfängerspule; und
Erhalten des Q-Wert-Schwellenwerts basierend auf dem Kopplungsparameter in dem gekoppelten Zustand, L1, und der Abweichungsbeziehung, und Erhalten der entsprechenden Wechselstromimpedanz basierend auf dem Q-Wert-Schwellenwert und der Entsprechung zwischen dem Q-Wert und der Wechselstromimpedanz der Senderspule (L1), wobei eine monotone Beziehung zwischen dem Kopplungsparameter in dem gekoppelten Zustand und der horizontalen Beziehung vorliegt, und eine monotone Beziehung zwischen L1 und der vertikalen Beziehung vorliegt.

5. Drahtlosladevorrichtung nach Anspruch 4, wobei die Steuerung (32) ferner konfiguriert ist zum: Empfangen einer Selbstinduktivität L2, die von einer Empfängerspule stammt, wenn die Drahtlosladevorrichtung und die elektronische Vorrichtung in dem gekoppelten Zustand sind, und die von der elektronischen Vorrichtung übermittelt wird, und Erhalten des Kopplungsparameters in dem gekoppelten Zustand basierend auf einem Strom der Senderspule (L1), der Selbstinduktivität L1 der Senderspule (L1) in dem gekoppelten Zustand, L2 und einer gleichgerichteten Spannung, die der Empfängerspule entspricht.

6. Drahtlosladevorrichtung nach Anspruch 4, wobei die Steuerung (32) ferner konfiguriert ist zum: Empfangen einer Selbstinduktivität L20, die von der Empfängerspule stammt, wenn die Drahtlosladevorrichtung und die elektronische Vorrichtung in dem entkoppelten Zustand sind, und die von der elektronischen Vorrichtung übermittelt wird, Erhalten der Selbstinduktivität L2 der Empfängerspule in dem gekoppelten Zustand basierend auf der Selbstinduktivität L1 der Senderspule (L1) in dem gekoppelten Zustand, einer Selbstinduktivität L10 der Senderspule (L1) in dem entkoppelten Zustand und L20, und Erhalten des Kopplungsparameters in dem gekoppelten Zustand basierend auf L1, L2 und einer gleichgerichteten Spannung, die der Empfängerspule entspricht.

7. Drahtlosladevorrichtung nach Anspruch 4, wobei die Steuerung (32) ferner konfiguriert ist zum: Empfangen einer Selbstinduktivität L3, die von einer Hilfsspule stammt, wenn die Drahtlosladevorrichtung und die elektronische Vorrichtung in dem gekoppelten Zustand sind, und die von der elektronischen Vorrichtung übermittelt wird, und Erhalten des Kopplungsparameters in dem gekoppelten Zustand basierend auf einem Strom der Senderspule (L1), der Selbstinduktivität L1 der Senderspule (L1) in dem gekoppelten Zustand, L3 und einer gleichgerichteten Spannung, die der Hilfsspule entspricht.

8. Drahtlosladevorrichtung nach Anspruch 4, wobei die Steuerung (32) ferner konfiguriert ist zum: Empfangen einer Selbstinduktivität L30, die von einer Hilfsspule stammt, wenn die Drahtlosladevorrichtung und die elektronische Vorrichtung in dem entkoppelten Zustand sind, und die von der elektronischen Vorrichtung übermittelt wird, Erhalten einer Selbstinduktivität L3 der Hilfsspule in dem gekoppelten Zustand basierend auf der Selbstinduktivität L1 der Senderspule (L1) in dem gekoppelten Zustand, einer Selbstinduktivität L10 der Senderspule (L1) in dem entkoppelten Zustand und L30, und Erhalten des Kopplungsparameters in dem gekoppelten Zustand basierend auf L1, L3 und einer gleichgerichteten Spannung, die der Hilfsspule entspricht.

9. Drahtlosladevorrichtung nach einem der Ansprüche 1 bis 8, wobei die Steuerung ferner konfiguriert ist, um den Kopplungsparameter zu erhalten, der erhalten wird, wenn die Drahtlosladevorrichtung und die elektronische Vorrichtung in dem gekoppelten Zustand sind, und ferner konfiguriert ist, um basierend auf der Wechselstromimpedanz und dem Kopplungsparameter in dem gekoppelten Zustand die Ploss-Fremdobjekterfassung durchzuführen.

10. Drahtlosladevorrichtung nach einem der Ansprüche 1 bis 8, die ferner eine Stromerfassungsschaltung der Senderspule umfasst;
wobei die Stromerfassungsschaltung konfiguriert ist, um eine Spannungsdifferenz zwischen zwei Enden des Resonanzkondensators zu erfassen; und
die Steuerung ist konfiguriert, um den Strom der Senderspule basierend auf der Spannungsdifferenz zu erhalten.

11. Drahtlosladevorrichtung nach Anspruch 10, wobei die Stromerfassungsschaltung eine erste Spannungserfassungsschaltung, eine zweite Spannungserfassungsschaltung und eine Differenzschaltung umfasst;
die erste Spannungserfassungsschaltung konfiguriert ist, um eine erste Spannung an einem ersten Ende des Resonanzkondensators zu erfassen, die erste Spannung zu teilen und eine geteilte erste Spannung an einen ersten Eingang der Differenzschaltung zu übermitteln;
die zweite Spannungserfassungsschaltung konfiguriert ist, um eine zweite Spannung an einem zweiten Ende des Resonanzkondensators zu erfassen, die zweite Spannung zu teilen und eine geteilte zweite Spannung an einen zweiten Eingang der Differenzschaltung zu übermitteln;
die Differenzschaltung konfiguriert ist, um ein Differenzergebnis der am ersten Eingang anliegenden Spannung und der am zweiten Eingang anliegenden Spannung zu erhalten; und
die Steuerung konfiguriert ist, um den Strom der Senderspule basierend auf dem Differenzergebnis zu erhalten.

12. Drahtlosladevorrichtung nach einem der Ansprüche 4 bis 10, wobei die Steuerung ferner konfiguriert ist zum: Bestimmen der horizontalen relativen Position und der vertikalen relativen Position zwischen der Senderspule und der Empfängerspule basierend auf der Selbstinduktivität der Senderspule und dem Kopplungsparameter, und Bewegen der Senderspule basierend auf der horizontalen relativen Position, so dass die Senderspule auf die Empfängerspule ausgerichtet ist; und
eine monotone Beziehung zwischen der Selbstinduktivität der Senderspule und der vertikalen relativen Position vorliegt, und eine monotone Beziehung zwischen dem Kopplungsparameter und der horizontalen relativen Position vorliegt.

13. Drahtlosladevorrichtung nach Anspruch 12, wobei die Steuerung ferner konfiguriert ist zum: Erhalten von zwei horizontalen relativen Positionen, die zwei verschiedenen relativen Positionen zwischen der Drahtlosladevorrichtung und der elektronischen Vorrichtung entsprechen, Erhalten eines ersten Kreisumfangs und eines zweiten Kreisumfangs, die jeweils die zwei horizontalen relativen Positionen als Radien verwenden, Erhalten eines Schnittpunkts des ersten Kreisumfangs und des zweiten Kreisumfangs, und Steuern der Senderspule, um auf den Schnittpunkt ausgerichtet zu sein.

14. Drahtlosladeschale, die konfiguriert ist, um eine elektronische Vorrichtung drahtlos aufzuladen, und die eine Leistungsschnittstelle, ein Resonanznetzwerk, eine Umrichterschaltung, eine Steuerung und ein Senderspulengehäuse umfasst;
die Leistungsschnittstelle konfiguriert ist, um einen Gleichstrom der von einem Adapter gesendet wird, zu verbinden;
das Resonanznetzwerk einen Resonanzkondensator und eine Senderspule umfasst; das Senderspulengehäuse konfiguriert ist, um die Senderspule zu platzieren;
ein Eingang der Umrichterschaltung konfiguriert ist, um mit der Leistungsschnittstelle verbunden zu werden, und ein Ausgang der Umrichterschaltung konfiguriert ist, um mit dem Resonanznetzwerk verbunden zu werden;
die Steuerung konfiguriert ist zum: Empfangen eines von der elektronischen Vorrichtung übermittelten Parameters der elektronischen Vorrichtung und Anpassen einer Abweichungsbeziehung zwischen einem Q-Wert der Drahtlosladevorrichtung und einem Positionsraum basierend auf einem Parameter der Drahtlosladevorrichtung und dem Parameter der elektronischen Vorrichtung, wobei der Positionsraum ein Positionsraum zwischen der Senderspule und einer Empfängerspule der elektronischen Vorrichtung ist, der Parameter der elektronischen Vorrichtung einen Q1-Wert der Drahtlosladevorrichtung und eine Resonanzfrequenz f1 des Resonanznetzwerks umfasst, wenn kein Fremdobjekt an mindestens einer relativen Position zwischen der Senderspule und der Empfängerspule vorliegt, und der Parameter der Drahtlosladevorrichtung einen anfänglichen Q-Wert Q0 der Drahtlosladevorrichtung und eine anfängliche Resonanzfrequenz f0 des Resonanznetzwerks umfasst, wenn die Drahtlosladevorrichtung und die elektronische Vorrichtung in einem entkoppelten Zustand sind, wobei die relative Position zwischen der Senderspule und der Empfängerspule die Positionsabweichung zwischen der Mitte der Senderspule und der Mitte der Empfängerspule ist, und die Abweichungsbeziehung eine Entsprechung zwischen dem Q-Wert und der horizontalen relativen Position und der vertikalen relativen Position zwischen der Senderspule und der Empfängerspule ist; und
die Steuerung ferner konfiguriert ist, um basierend auf der Abweichungsbeziehung die Fremdobjekterfassung durchzuführen,
wobei die Steuerung ferner konfiguriert ist zum: Erhalten des Q-Wert-Schwellenwerts basierend auf der Abweichungsbeziehung, Erhalten einer entsprechenden Wechselstromimpedanz basierend auf dem Q-Wert-Schwellenwert und einer Entsprechung zwischen dem Q-Wert und der Wechselstromimpedanz der Senderspule, und Durchführen der Ploss-Fremdobjekterfassung basierend auf der erhaltenen Wechselstromimpedanz in einem Prozess, in dem die Drahtlosladevorrichtung die elektronische Vorrichtung auflädt, und wobei entweder (a): der Parameter der elektronischen Vorrichtung die folgenden Q1-Werte und f1 an mindestens zwei relativen Positionen zwischen der Senderspule und der Empfängerspule umfasst: Q11 und f11 an einer ersten Position, und Q12 und f12 an einer zweiten Position, und die Abweichungsbeziehung eine radiale horizontale Beziehung zwischen der Senderspule und der Empfängerspule und eine vertikale Beziehung zwischen einer Ebene, auf der sich die Senderspule befindet, und einer Ebene, auf der sich die Empfängerspule befindet, umfasst;
die Steuerung ferner konfiguriert ist zum: Anpassen der horizontalen Beziehung zwischen dem Q-Wert und dem Positionsraum basierend auf Q11, f11, Q12 und f12; und Anpassen der vertikalen Beziehung zwischen dem Q-Wert und dem Positionsraum auf eine beliebige der folgenden Weisen: Anpassen der vertikalen Beziehung zwischen dem Q-Wert und dem Positionsraum basierend auf f0, Q0, Q11 und f11; Anpassen der vertikalen Beziehung zwischen dem Q-Wert und dem Positionsraum basierend auf f0, Q0, Q12 und f12; oder Anpassen der vertikalen Beziehung zwischen dem Q-Wert und dem Positionsraum basierend auf Q0, f0 und Q und f, die mindestens einem Punkt in der horizontalen Beziehung entsprechen; und Erhalten des Q-Wert-Schwellenwerts basierend auf der horizontalen Beziehung und der vertikalen Beziehung, und Erhalten der entsprechenden Wechselstromimpedanz basierend auf dem Q-Wert-Schwellenwert und der Entsprechung zwischen dem Q-Wert und der Wechselstromimpedanz der Senderspule, oder wobei (b):
die Abweichungsbeziehung eine radiale horizontale Beziehung zwischen der Senderspule und der Empfängerspule und eine vertikale Beziehung zwischen einer Ebene, auf der sich die Senderspule befindet, und einer Ebene, auf der sich die Empfängerspule befindet, umfasst;
der Parameter der elektronischen Vorrichtung ferner einen vorgespeicherten Kopplungsparameter umfasst, wenn kein Fremdobjekt an der mindestens einen relativen Position zwischen der Senderspule und der Empfängerspule vorliegt, und der vorgespeicherte Kopplungsparameter mindestens eines der Folgenden umfasst: einen Kopplungskoeffizienten und eine Gegeninduktivität zwischen der Senderspule und der Empfängerspule; und
die Steuerung ferner konfiguriert ist zum: Anpassen der vertikalen Beziehung zwischen dem Q-Wert und dem Positionsraum basierend auf f0, Q0 und dem Q-Wert und f an der mindestens einen relativen Position zwischen der Senderspule und der Empfängerspule; Anpassen der horizontalen Beziehung zwischen dem Q-Wert und dem Positionsraum basierend auf dem vorab gespeicherten Kopplungsparameter und dem Q-Wert an der mindestens einen relativen Position zwischen der Senderspule und der Empfängerspule; und Erhalten des Q-Wert-Schwellenwerts basierend auf der vertikalen Beziehung und der horizontalen Beziehung, und Erhalten der entsprechenden Wechselstromimpedanz basierend auf dem Q-Wert-Schwellenwert und der Entsprechung zwischen dem Q-Wert und der Wechselstromimpedanz der Senderspule, oder wobei (c):
der Parameter der elektronischen Vorrichtung die folgenden Q1-Werte und f1 an mindestens zwei relativen Positionen zwischen der Senderspule und der Empfängerspule umfasst: Q11 und f11 an einer ersten Position, und Q12 und f12 an einer zweiten Position;
die Abweichungsbeziehung eine radiale horizontale Beziehung zwischen der Senderspule und der Empfängerspule und eine vertikale Beziehung zwischen einer Ebene, auf der sich die Senderspule befindet, und einer Ebene, auf der sich die Empfängerspule befindet, umfasst;
der Parameter der elektronischen Vorrichtung ferner einen vorab gespeicherten Kopplungsparameter an der ersten Position und einen vorab gespeicherten Kopplungsparameter an der zweiten Position umfasst, und der vorab gespeicherte Kopplungsparameter mindestens eines der Folgenden umfasst: einen Kopplungskoeffizienten und eine Gegeninduktivität zwischen der Senderspule und der Empfängerspule; und
die Steuerung ferner konfiguriert ist zum: Anpassen der horizontalen Beziehung zwischen dem Q-Wert und dem Positionsraum basierend auf Q11, Q12, dem vorab gespeicherten Kopplungsparameter an der ersten Position und dem vorab gespeicherten Kopplungsparameter an der zweiten Position;
Anpassen der vertikalen Beziehung zwischen dem Q-Wert und dem Positionsraum auf eine beliebige der folgenden Weisen: Anpassen der vertikalen Beziehung zwischen dem Q-Wert und dem Positionsraum basierend auf f0, Q0, Q11 und f11; Anpassen der vertikalen Beziehung zwischen dem Q-Wert und dem Positionsraum basierend auf f0, Q0, Q12 und f12; oder Anpassen der vertikalen Beziehung zwischen dem Q-Wert und dem Positionsraum basierend auf Q0, f0 und Q und f, die mindestens einem Punkt in der horizontalen Beziehung entsprechen; und
Erhalten des Q-Wert-Schwellenwerts basierend auf der vertikalen Beziehung und der horizontalen Beziehung, und Erhalten der entsprechenden Wechselstromimpedanz basierend auf dem Q-Wert-Schwellenwert und der Entsprechung zwischen dem Q-Wert und der Wechselstromimpedanz der Senderspule.

15. Verfahren für die Fremdobjekterfassung zum Drahtlosladen, angewendet auf eine Drahtlosladevorrichtung, wobei die Drahtlosladevorrichtung ein Resonanznetzwerk und eine Umrichterschaltung umfasst, das Resonanznetzwerk einen Resonanzkondensator und eine Senderspule umfasst, ein Eingang der Umrichterschaltung konfiguriert ist, um mit einer Gleichstrom-Leistungsversorgung verbunden zu werden, und ein Ausgang der Umrichterschaltung konfiguriert ist, um mit dem Resonanznetzwerk verbunden zu werden; und
das Verfahren umfasst:
Empfangen eines von der elektronischen Vorrichtung übermittelten Parameters der elektronischen Vorrichtung (S1601);
Anpassen einer Abweichungsbeziehung zwischen einem Q-Wert der Drahtlosladevorrichtung und einem Positionsraum basierend auf einem Parameter der Drahtlosladevorrichtung und dem Parameter der elektronischen Vorrichtung (S1602), wobei der Positionsraum ein Positionsraum zwischen der Senderspule und einer Empfängerspule der elektronischen Vorrichtung ist, der Parameter der elektronischen Vorrichtung einen Q1-Wert der Drahtlosladevorrichtung und eine Resonanzfrequenz f1 des Resonanznetzwerks umfasst, wenn kein Fremdobjekt an mindestens einer relativen Position zwischen der Senderspule und der Empfängerspule vorliegt, und der Parameter der Drahtlosladevorrichtung einen anfänglichen Q-Wert Q0 der Drahtlosladevorrichtung und eine anfängliche Resonanzfrequenz f0 des Resonanznetzwerks umfasst, wenn die Drahtlosladevorrichtung und die elektronische Vorrichtung in einem entkoppelten Zustand sindf, wobei die relative Position zwischen der Senderspule und der Empfängerspule die Positionsabweichung zwischen der Mitte der Senderspule und der Mitte der Empfängerspule ist, und die Abweichungsbeziehung eine Entsprechung zwischen dem Q-Wert und der horizontalen relativen Position und der vertikalen relativen Position zwischen der Senderspule und der Empfängerspule ist; und
Durchführen der Fremdobjekterfassung basierend auf der Abweichungsbeziehung (S1603),
wobei das Durchführen der Fremdobjekterfassung basierend auf der Abweichungsbeziehung umfasst:
Erhalten des Q-Wert-Schwellenwerts basierend auf der Abweichungsbeziehung; Erhalten einer entsprechenden Wechselstromimpedanz basierend auf dem Q-Wert-Schwellenwert und einer Entsprechung zwischen dem Q-Wert und der Wechselstromimpedanz der Senderspule; und
Durchführen der Ploss-Fremdobjekterfassung basierend auf der erhaltenen Wechselstromimpedanz in einem Prozess, in dem die Drahtlosladevorrichtung die elektronische Vorrichtung auflädt, und wobei entweder (a):
der Parameter der elektronischen Vorrichtung die folgenden Q1-Werte und f1 an mindestens zwei relativen Positionen zwischen der Senderspule und der Empfängerspule umfasst: Q11 und f11 an einer ersten Position, und Q12 und f12 an einer zweiten Position, und die Abweichungsbeziehung eine radiale horizontale Beziehung zwischen der Senderspule und der Empfängerspule und eine vertikale Beziehung zwischen einer Ebene, auf der sich die Senderspule befindet, und einer Ebene, auf der sich die Empfängerspule befindet, umfasst;
das Anpassen einer Abweichungsbeziehung zwischen einem Q-Wert der Drahtlosladevorrichtung und einem Positionsraum basierend auf einem Parameter der Drahtlosladevorrichtung und dem Parameter der elektronischen Vorrichtung umfasst:
Anpassen der horizontalen Beziehung zwischen dem Q-Wert und dem Positionsraum basierend auf Q11, f11, Q12 und f12; und Anpassen der vertikalen Beziehung zwischen dem Q-Wert und dem Positionsraum auf eine beliebige der folgenden Weisen: Anpassen der vertikalen Beziehung zwischen dem Q-Wert und dem Positionsraum basierend auf f0, Q0, Q11 und f11; Anpassen der vertikalen Beziehung zwischen dem Q-Wert und dem Positionsraum basierend auf f0, Q0, Q12 und f12; oder Anpassen der vertikalen Beziehung zwischen dem Q-Wert und dem Positionsraum basierend auf Q0, f0 und Q und f, die mindestens einem Punkt in der horizontalen Beziehung entsprechen; und
das Erhalten des Q-Wert-Schwellenwerts basierend auf der Abweichungsbeziehung umfasst:
Erhalten des Q-Wert-Schwellenwerts basierend auf der horizontalen Beziehung und der vertikalen Beziehung, oder wobei (b):
die Abweichungsbeziehung eine radiale horizontale Beziehung zwischen der Senderspule und der Empfängerspule und eine vertikale Beziehung zwischen einer Ebene, auf der sich die Senderspule befindet, und einer Ebene, auf der sich die Empfängerspule befindet, umfasst, der Parameter der elektronischen Vorrichtung ferner einen vorab gespeicherten Kopplungsparameter umfasst, wenn kein Fremdobjekt an der mindestens einen relativen Position zwischen der Senderspule und der Empfängerspule vorliegt, und der vorab gespeicherte Kopplungsparameter mindestens eines der Folgenden umfasst: einen Kopplungskoeffizienten und eine Gegeninduktivität zwischen der Senderspule und der Empfängerspule;
das Anpassen einer Abweichungsbeziehung zwischen einem Q-Wert der Drahtlosladevorrichtung und einem Positionsraum basierend auf einem Parameter der Drahtlosladevorrichtung und dem Parameter der elektronischen Vorrichtung umfasst: Anpassen der vertikalen Beziehung zwischen dem Q-Wert und dem Positionsraum basierend auf f0, Q0 und dem Q-Wert und f an der mindestens einen relativen Position zwischen der Senderspule und der Empfängerspule, und Anpassen der horizontalen Beziehung zwischen dem Q-Wert und dem Positionsraum basierend auf dem vorgespeicherten Kopplungsparameter und dem Q-Wert an der mindestens einen relativen Position zwischen der Senderspule und der Empfängerspule; und
das Erhalten des Q-Wert-Schwellenwerts basierend auf der Abweichungsbeziehung umfasst:
Erhalten des Q-Wert-Schwellenwerts basierend auf der vertikalen Beziehung und der horizontalen Beziehung, oder wobei (c):
der Parameter der elektronischen Vorrichtung die folgenden Q1-Werte und f1 an mindestens zwei relativen Positionen zwischen der Senderspule und der Empfängerspule umfasst: Q11 und f11 an einer ersten Position und Q12 und f12 an einer zweiten Position, die Abweichungsbeziehung eine radiale horizontale Beziehung zwischen der Senderspule und der Empfängerspule und eine vertikale Beziehung zwischen einer Ebene, auf der sich die Senderspule befindet, und einer Ebene, auf der sich die Empfängerspule befindet, umfasst, der Parameter der elektronischen Vorrichtung ferner einen vorab gespeicherten Kopplungsparameter an der ersten Position und einen vorab gespeicherten Kopplungsparameter an der zweiten Position umfasst, und der vorab gespeicherte Kopplungsparameter mindestens eines der Folgenden umfasst: einen Kopplungskoeffizienten und eine Gegeninduktivität zwischen der Senderspule und der Empfängerspule; und
das Anpassen einer Abweichungsbeziehung zwischen einem Q-Wert der Drahtlosladevorrichtung und einem Positionsraum basierend auf einem Parameter der Drahtlosladevorrichtung und dem Parameter der elektronischen Vorrichtung umfasst: Anpassen der horizontalen Beziehung zwischen dem Q-Wert und dem Positionsraum basierend auf Q11, Q12, dem vorab gespeicherten Kopplungsparameter an der ersten Position und dem vorab gespeicherten Kopplungsparameter an der zweiten Position; und Anpassen der vertikalen Beziehung zwischen dem Q-Wert und dem Positionsraum auf eine beliebige der folgenden Weisen: Anpassen der vertikalen Beziehung zwischen dem Q-Wert und dem Positionsraum basierend auf f0, Q0, Q11 und f11; Anpassen der vertikalen Beziehung zwischen dem Q-Wert und dem Positionsraum basierend auf f0, Q0, Q12 und f12; oder Anpassen der vertikalen Beziehung zwischen dem Q-Wert und dem Positionsraum basierend auf Q0, f0 und Q und f, die mindestens einem Punkt in der horizontalen Beziehung entsprechen; und das Erhalten des Q-Wert-Schwellenwerts basierend auf der Abweichungsbeziehung umfasst:
Erhalten des Q-Wert-Schwellenwerts basierend auf der vertikalen Beziehung und der horizontalen Beziehung.

## Revendications

1. Dispositif de charge sans fil, dans lequel le dispositif de charge sans fil est configuré pour charger sans fil un dispositif électronique, et le dispositif de charge sans fil comprend un réseau résonant, un circuit onduleur (31) et un dispositif de commande (32) ;
le réseau résonant comprend un condensateur résonant (C1) et une bobine émettrice (L1) ;
une entrée du circuit onduleur (31) est configurée pour être connectée à une alimentation électrique en courant continu, et une sortie du circuit onduleur (31) est configurée pour être connectée au réseau résonant ;
le dispositif de commande (32) est configuré pour : recevoir un paramètre de dispositif électronique envoyé par le dispositif électronique et adapter une relation d'écart entre une valeur Q du dispositif de charge sans fil et un espace d'emplacement sur la base d'un paramètre de dispositif de charge sans fil et du paramètre de dispositif électronique, dans lequel l'espace d'emplacement est un espace d'emplacement entre la bobine émettrice (L1) et une bobine réceptrice du dispositif électronique, le paramètre de dispositif électronique comprend une valeur Q1 du dispositif de charge sans fil et une fréquence de résonance f1 du réseau résonant lorsqu'aucun objet étranger n'est présent au niveau d'au moins un emplacement relatif entre la bobine émettrice (L1) et la bobine réceptrice, et le paramètre de dispositif de charge sans fil comprend une valeur Q initiale Q0 du dispositif de charge sans fil et une fréquence de résonance initiale f0 du réseau résonant lorsque le dispositif de charge sans fil et le dispositif électronique sont dans un état découplé, dans lequel l'emplacement relatif entre la bobine émettrice (L1) et la bobine réceptrice est l'écart d'emplacement entre le centre de la bobine émettrice et le centre de la bobine réceptrice, et la relation d'écart est une correspondance entre la valeur Q et l'emplacement relatif horizontal et l'emplacement relatif vertical entre la bobine émettrice (L1) et la bobine réceptrice ; et le dispositif de commande (32) est en outre configuré pour réaliser une détection d'objet étranger sur la base de la relation d'écart,
dans lequel le dispositif de commande (32) est en outre configuré pour : obtenir le seuil de valeur Q sur la base de la relation d'écart, obtenir une impédance de courant alternatif correspondante sur la base du seuil de valeur Q et d'une correspondance entre la valeur Q et l'impédance de courant alternatif de la bobine émettrice (L1), et réaliser une détection d'objet étranger par Ploss sur la base de l'impédance de courant alternatif obtenue dans un processus dans lequel le dispositif de charge sans fil charge le dispositif électronique, et dans lequel soit (a) :
le paramètre de dispositif électronique comprend les valeurs Q1 et f1 suivantes au niveau d'au moins deux emplacements relatifs entre la bobine émettrice (L1) et la bobine réceptrice : Q11 et f11 au niveau d'un premier emplacement et Q12 et f12 au niveau d'un second emplacement, et la relation d'écart comprend une relation horizontale radiale entre la bobine émettrice (L1) et la bobine réceptrice et une relation verticale entre un plan sur lequel la bobine émettrice (L1) est située et un plan sur lequel la bobine réceptrice est située ;
le dispositif de commande (32) est en outre configuré pour : adapter la relation horizontale entre la valeur Q et l'espace d'emplacement sur la base de Q11, f11, Q12 et f12 ; et adapter la relation verticale entre la valeur Q et l'espace d'emplacement de l'une quelconque des manières suivantes : en adaptant la relation verticale entre la valeur Q et l'espace d'emplacement sur la base de f0, Q0, Q11 et f11 ; en adaptant la relation verticale entre la valeur Q et l'espace d'emplacement sur la base de f0, Q0, Q12 et f12 ; ou en adaptant la relation verticale entre la valeur Q et l'espace d'emplacement sur la base de Q0, f0, et de Q et f qui correspondent à au moins un point dans la relation horizontale ; et
obtenir le seuil de valeur Q sur la base de la relation horizontale et de la relation verticale, et obtenir l'impédance de courant alternatif correspondante sur la base du seuil de valeur Q et de la correspondance entre la valeur Q et l'impédance de courant alternatif de la bobine émettrice (L1), soit dans lequel (b) :
la relation d'écart comprend une relation horizontale radiale entre la bobine émettrice (L1) et la bobine réceptrice et une relation verticale entre un plan sur lequel la bobine émettrice (L1) est située et un plan sur lequel la bobine réceptrice est située ; le paramètre de dispositif électronique comprend en outre un paramètre de couplage pré-enregistré lorsqu'aucun objet étranger n'est présent au niveau de l'au moins un emplacement relatif entre la bobine émettrice (L1) et la bobine réceptrice, et le paramètre de couplage pré-enregistré comprend au moins l'un parmi les éléments suivants : un coefficient de couplage et une inductance mutuelle entre la bobine émettrice (L1) et la bobine réceptrice ; et
le dispositif de commande (32) est en outre configuré pour : adapter la relation verticale entre la valeur Q et l'espace d'emplacement sur la base de f0, Q0 et de la valeur Q et f au niveau de l'au moins un emplacement relatif entre la bobine émettrice (L1) et la bobine réceptrice ; adapter la relation horizontale entre la valeur Q et l'espace d'emplacement sur la base du paramètre de couplage pré-enregistré et de la valeur Q au niveau de l'au moins un emplacement relatif entre la bobine émettrice (L1) et la bobine réceptrice ; et obtenir le seuil de valeur Q sur la base de la relation verticale et de la relation horizontale, et obtenir l'impédance de courant alternatif correspondante sur la base du seuil de valeur Q et de la correspondance entre la valeur Q et l'impédance de courant alternatif de la bobine émettrice (L1), soit dans lequel (c) :
le paramètre de dispositif électronique comprend les valeurs Q1 et f1 suivantes au niveau d'au moins deux emplacements relatifs entre la bobine émettrice (L1) et la bobine réceptrice : Q11 et f11 au niveau d'un premier emplacement et Q12 et f12 au niveau d'un second emplacement ;
la relation d'écart comprend une relation horizontale radiale entre la bobine émettrice (L1) et la bobine réceptrice et une relation verticale entre un plan sur lequel la bobine émettrice (L1) est située et un plan sur lequel la bobine réceptrice est située ; le paramètre de dispositif électronique comprend en outre un paramètre de couplage pré-enregistré au niveau du premier emplacement et un paramètre de couplage pré-enregistré au niveau du second emplacement, et le paramètre de couplage pré-enregistré comprend au moins l'un parmi les éléments suivants : un coefficient de couplage et une inductance mutuelle entre la bobine émettrice (L1) et la bobine réceptrice ; et
le dispositif de commande (32) est en outre configuré pour : adapter la relation horizontale entre la valeur Q et l'espace d'emplacement sur la base de Q11, Q12, du paramètre de couplage pré-enregistré au niveau du premier emplacement et du paramètre de couplage pré-enregistré au niveau du second emplacement ;
adapter la relation verticale entre la valeur Q et l'espace d'emplacement de l'une quelconque des manières suivantes : en adaptant la relation verticale entre la valeur Q et l'espace d'emplacement sur la base de f0, Q0, Q11 et f11 ; en adaptant la relation verticale entre la valeur Q et l'espace d'emplacement sur la base de f0, Q0, Q12 et f12 ; ou en adaptant la relation verticale entre la valeur Q et l'espace d'emplacement sur la base de Q0, f0, et de Q et f qui correspondent à au moins un point dans la relation horizontale ; et
obtenir le seuil de valeur Q sur la base de la relation verticale et de la relation horizontale, et obtenir l'impédance de courant alternatif correspondante sur la base du seuil de valeur Q et de la correspondance entre la valeur Q et l'impédance de courant alternatif de la bobine émettrice (L1).

2. Dispositif de charge sans fil selon la revendication 1, dans lequel le dispositif de commande (32) est en outre configuré pour : obtenir un seuil de valeur Q sur la base de la relation d'écart et réaliser une détection d'objet étranger par valeur Q sur la base du seuil de valeur Q avant que le dispositif de charge sans fil ne charge le dispositif électronique.

3. Dispositif de charge sans fil selon la revendication 1 ou 2, dans lequel le dispositif de commande (32) est en outre configuré pour : obtenir le seuil de valeur Q sur la base de la relation verticale et d'une fréquence de résonance du réseau résonant ou d'une auto-inductance de la bobine émettrice (L1) au niveau d'un emplacement relatif actuel entre le dispositif de charge sans fil et le dispositif électronique, et obtenir l'impédance de courant alternatif correspondante sur la base du seuil de valeur Q et de la correspondance entre la valeur Q et l'impédance de courant alternatif de la bobine émettrice (L1).

4. Dispositif de charge sans fil selon la revendication 1, dans lequel le dispositif de commande (32) est en outre configuré pour : obtenir un paramètre de couplage et une auto-inductance L1 de la bobine émettrice (L1) lorsque le dispositif de charge sans fil et le dispositif électronique sont dans un état couplé, dans lequel le paramètre de couplage à l'état couplé comprend au moins l'un parmi les éléments suivants : le coefficient de couplage et l'inductance mutuelle entre la bobine émettrice (L1) et la bobine réceptrice ; et
obtenir le seuil de valeur Q sur la base du paramètre de couplage à l'état couplé, de L1 et de la relation d'écart, et obtenir l'impédance de courant alternatif correspondante sur la base du seuil de valeur Q et de la correspondance entre la valeur Q et l'impédance de courant alternatif de la bobine émettrice (L1), dans lequel une relation monotone existe entre le paramètre de couplage à l'état couplé et la relation horizontale, et une relation monotone existe entre L1 et la relation verticale.

5. Dispositif de charge sans fil selon la revendication 4, dans lequel le dispositif de commande (32) est en outre configuré pour : recevoir une auto-inductance L2 qui appartient à la bobine réceptrice lorsque le dispositif de charge sans fil et le dispositif électronique sont à l'état couplé et qui est envoyée par le dispositif électronique, et obtenir le paramètre de couplage à l'état couplé sur la base d'un courant de la bobine émettrice (L1), de l'auto-inductance L1 de la bobine émettrice (L1) à l'état couplé, de L2 et d'une tension redressée correspondant à la bobine réceptrice.

6. Dispositif de charge sans fil selon la revendication 4, dans lequel le dispositif de commande (32) est en outre configuré pour : recevoir une auto-inductance L20 qui appartient à la bobine réceptrice lorsque le dispositif de charge sans fil et le dispositif électronique sont à l'état découplé et qui est envoyée par le dispositif électronique, obtenir l'auto-inductance L2 de la bobine réceptrice à l'état couplé sur la base de l'auto-inductance L1 de la bobine émettrice (L1) à l'état couplé, d'une auto-inductance L10 de la bobine émettrice (L1) à l'état découplé et de L20, et obtenir le paramètre de couplage à l'état couplé sur la base de L1, L2 et d'une tension redressée correspondant à la bobine réceptrice.

7. Dispositif de charge sans fil selon la revendication 4, dans lequel le dispositif de commande (32) est en outre configuré pour : recevoir une auto-inductance L3 qui appartient à une bobine auxiliaire lorsque le dispositif de charge sans fil et le dispositif électronique sont à l'état couplé et qui est envoyée par le dispositif électronique, et obtenir le paramètre de couplage à l'état couplé sur la base d'un courant de la bobine émettrice (L1), de l'auto-inductance L1 de la bobine émettrice (L1) à l'état couplé, de L3 et d'une tension redressée correspondant à la bobine auxiliaire.

8. Dispositif de charge sans fil selon la revendication 4, dans lequel le dispositif de commande (32) est en outre configuré pour : recevoir une auto-inductance L30 qui appartient à une bobine auxiliaire lorsque le dispositif de charge sans fil et le dispositif électronique sont à l'état découplé et qui est envoyée par le dispositif électronique, obtenir une auto-inductance L3 de la bobine auxiliaire à l'état couplé sur la base de l'auto-inductance L1 de la bobine émettrice (L1) à l'état couplé, d'une auto-inductance L10 de la bobine émettrice (L1) à l'état découplé et de L30, et obtenir le paramètre de couplage à l'état couplé sur la base de L1, L3 et d'une tension redressée correspondant à la bobine auxiliaire.

9. Dispositif de charge sans fil selon l'une quelconque des revendications 1 à 8, dans lequel le dispositif de commande est en outre configuré pour obtenir le paramètre de couplage obtenu lorsque le dispositif de charge sans fil et le dispositif électronique sont à l'état couplé, et est en outre configuré pour réaliser une détection d'objet étranger par Ploss sur la base de l'impédance de courant alternatif et du paramètre de couplage à l'état couplé.

10. Dispositif de charge sans fil selon l'une quelconque des revendications 1 à 8, comprenant en outre un circuit de détection de courant de la bobine émettrice ;
le circuit de détection de courant est configuré pour détecter une différence de tension entre deux extrémités du condensateur résonant ; et
le dispositif de commande est configuré pour obtenir le courant de la bobine émettrice sur la base de la différence de tension.

11. Dispositif de charge sans fil selon la revendication 10, dans lequel le circuit de détection de courant comprend un premier circuit de détection de tension, un second circuit de détection de tension et un circuit différentiel ;
le premier circuit de détection de tension est configuré pour détecter une première tension au niveau d'une première extrémité du condensateur résonant, diviser la première tension et envoyer une première tension divisée à une première entrée du circuit différentiel ;
le second circuit de détection de tension est configuré pour détecter une seconde tension au niveau d'une seconde extrémité du condensateur résonant, diviser la seconde tension et envoyer une seconde tension divisée à une seconde entrée du circuit différentiel ;
le circuit différentiel est configuré pour obtenir un résultat différentiel de l'entrée de tension au niveau de la première entrée et de l'entrée de tension au niveau de la seconde entrée ; et
le dispositif de commande est configuré pour obtenir le courant de la bobine émettrice sur la base du résultat différentiel.

12. Dispositif de charge sans fil selon l'une quelconque des revendications 4 à 10, dans lequel le dispositif de commande est en outre configuré pour : déterminer l'emplacement relatif horizontal et l'emplacement relatif vertical entre la bobine émettrice et la bobine réceptrice sur la base de l'auto-inductance de la bobine émettrice et du paramètre de couplage, et déplacer la bobine émettrice sur la base de l'emplacement relatif horizontal de sorte que la bobine émettrice est alignée sur la bobine réceptrice ; et
une relation monotone existe entre l'auto-inductance de la bobine émettrice et
l'emplacement relatif vertical, et une relation monotone existe entre le paramètre de couplage et l'emplacement relatif horizontal.

13. Dispositif de charge sans fil selon la revendication 12, dans lequel le dispositif de commande est en outre configuré pour : obtenir deux emplacements relatifs horizontaux correspondant à deux emplacements relatifs différents entre le dispositif de charge sans fil et le dispositif électronique, obtenir une première circonférence et une seconde circonférence qui utilisent respectivement les deux emplacements relatifs horizontaux comme rayons, obtenir un point d'intersection de la première circonférence et de la seconde circonférence, et commander la bobine émettrice pour l'aligner sur le point d'intersection.

14. Socle de charge sans fil, configuré pour charger sans fil un dispositif électronique, et comprenant une interface de puissance, un réseau résonant, un circuit onduleur, un dispositif de commande et un châssis de bobine émettrice ;
l'interface de puissance est configurée pour établir la connexion d'un courant continu transmis par un adaptateur ;
le réseau résonant comprend un condensateur résonant et une bobine émettrice ; le châssis de bobine émettrice est conçu pour placer la bobine émettrice ;
une entrée du circuit onduleur est configurée pour être connectée à l'interface de puissance, et une sortie du circuit onduleur est configurée pour être connectée au réseau résonant ;
le dispositif de commande est configuré pour : recevoir un paramètre de dispositif électronique envoyé par le dispositif électronique et adapter une relation d'écart entre une valeur Q du dispositif de charge sans fil et un espace d'emplacement sur la base d'un paramètre de dispositif de charge sans fil et du paramètre de dispositif électronique, dans lequel l'espace d'emplacement est un espace d'emplacement entre la bobine émettrice et une bobine réceptrice du dispositif électronique, le paramètre de dispositif électronique comprend une valeur Q1 du dispositif de charge sans fil et une fréquence de résonance f1 du réseau résonant lorsqu'aucun objet étranger n'est présent au niveau d'au moins un emplacement relatif entre la bobine émettrice et la bobine réceptrice, et le paramètre de dispositif de charge sans fil comprend une valeur Q initiale Q0 du dispositif de charge sans fil et une fréquence de résonance initiale f0 du réseau résonant lorsque le dispositif de charge sans fil et le dispositif électronique sont dans un état découplé, dans lequel l'emplacement relatif entre la bobine émettrice et la bobine réceptrice est l'écart d'emplacement entre le centre de la bobine émettrice et le centre de la bobine réceptrice, et la relation d'écart est une correspondance entre la valeur Q et l'emplacement relatif horizontal et l'emplacement relatif vertical entre la bobine émettrice et la bobine réceptrice ; et
le dispositif de commande est en outre configuré pour réaliser une détection d'objet étranger sur la base de la relation d'écart,
dans lequel le dispositif de commande est en outre configuré pour : obtenir le seuil de valeur Q sur la base de la relation d'écart, obtenir une impédance de courant alternatif correspondante sur la base du seuil de valeur Q et d'une correspondance entre la valeur Q et l'impédance de courant alternatif de la bobine émettrice, et réaliser une détection d'objet étranger par Ploss sur la base de l'impédance de courant alternatif obtenue dans un processus dans lequel le dispositif de charge sans fil charge le dispositif électronique, et dans lequel soit (a) :
le paramètre de dispositif électronique comprend les valeurs Q1 et f1 suivantes au niveau d'au moins deux emplacements relatifs entre la bobine émettrice et la bobine réceptrice : Q11 et f11 au niveau d'un premier emplacement et Q12 et f12 au niveau d'un second emplacement, et la relation d'écart comprend une relation horizontale radiale entre la bobine émettrice et la bobine réceptrice et une relation verticale entre un plan sur lequel la bobine émettrice est située et un plan sur lequel la bobine réceptrice est située ;
le dispositif de commande est en outre configuré pour : adapter la relation horizontale entre la valeur Q et l'espace d'emplacement sur la base de Q11, f11, Q12 et f12 ; et adapter la relation verticale entre la valeur Q et l'espace d'emplacement de l'une quelconque des manières suivantes : en adaptant la relation verticale entre la valeur Q et l'espace d'emplacement sur la base de f0, Q0, Q11 et f11 ; en adaptant la relation verticale entre la valeur Q et l'espace d'emplacement sur la base de f0, Q0, Q12 et f12 ; ou en adaptant la relation verticale entre la valeur Q et l'espace d'emplacement sur la base de Q0, f0, et de Q et f qui correspondent à au moins un point dans la relation horizontale ; et
obtenir le seuil de valeur Q sur la base de la relation horizontale et de la relation verticale, et obtenir l'impédance de courant alternatif correspondante sur la base du seuil de valeur Q et de la correspondance entre la valeur Q et l'impédance de courant alternatif de la bobine émettrice, soit dans lequel (b) :
la relation d'écart comprend une relation horizontale radiale entre la bobine émettrice et la bobine réceptrice et une relation verticale entre un plan sur lequel la bobine émettrice est située et un plan sur lequel la bobine réceptrice est située ;
le paramètre de dispositif électronique comprend en outre un paramètre de couplage pré-enregistré lorsqu'aucun objet étranger n'est présent au niveau de l'au moins un emplacement relatif entre la bobine émettrice et la bobine réceptrice, et le paramètre de couplage pré-enregistré comprend au moins l'un parmi les éléments suivants : un coefficient de couplage et une inductance mutuelle entre la bobine émettrice et la bobine réceptrice ; et
le dispositif de commande est en outre configuré pour : adapter la relation verticale entre la valeur Q et l'espace d'emplacement sur la base de f0, Q0 et de la valeur Q et f au niveau de l'au moins un emplacement relatif entre la bobine émettrice et la bobine réceptrice ; adapter la relation horizontale entre la valeur Q et l'espace d'emplacement sur la base du paramètre de couplage pré-enregistré et de la valeur Q au niveau de l'au moins un emplacement relatif entre la bobine émettrice et la bobine réceptrice ; et obtenir le seuil de valeur Q sur la base de la relation verticale et de la relation horizontale, et obtenir l'impédance de courant alternatif correspondante sur la base du seuil de valeur Q et de la correspondance entre la valeur Q et l'impédance de courant alternatif de la bobine émettrice, soit dans lequel (c) :
le paramètre de dispositif électronique comprend les valeurs Q1 et f1 suivantes au niveau d'au moins deux emplacements relatifs entre la bobine émettrice et la bobine réceptrice : Q11 et f11 au niveau d'un premier emplacement et Q12 et f12 au niveau d'un second emplacement ;
la relation d'écart comprend une relation horizontale radiale entre la bobine émettrice et la bobine réceptrice et une relation verticale entre un plan sur lequel la bobine émettrice est située et un plan sur lequel la bobine réceptrice est située ;
le paramètre de dispositif électronique comprend en outre un paramètre de couplage pré-enregistré au niveau du premier emplacement et un paramètre de couplage pré-enregistré au niveau du second emplacement, et le paramètre de couplage pré-enregistré comprend au moins l'un parmi les éléments suivants : un coefficient de couplage et une inductance mutuelle entre la bobine émettrice et la bobine réceptrice ; et
le dispositif de commande est en outre configuré pour : adapter la relation horizontale entre la valeur Q et l'espace d'emplacement sur la base de Q11, Q12, du paramètre de couplage pré-enregistré au niveau du premier emplacement et du paramètre de couplage pré-enregistré au niveau du second emplacement ;
adapter la relation verticale entre la valeur Q et l'espace d'emplacement de l'une quelconque des manières suivantes : en adaptant la relation verticale entre la valeur Q et l'espace d'emplacement sur la base de f0, Q0, Q11 et f11 ; en adaptant la relation verticale entre la valeur Q et l'espace d'emplacement sur la base de f0, Q0, Q12 et f12 ; ou en adaptant la relation verticale entre la valeur Q et l'espace d'emplacement sur la base de Q0, f0, et de Q et f qui correspondent à au moins un point dans la relation horizontale ; et
obtenir le seuil de valeur Q sur la base de la relation verticale et de la relation horizontale, et obtenir l'impédance de courant alternatif correspondante sur la base du seuil de valeur Q et de la correspondance entre la valeur Q et l'impédance de courant alternatif de la bobine émettrice.

15. Procédé de détection d'objet étranger pour une charge sans fil, appliqué à un dispositif de charge sans fil, dans lequel le dispositif de charge sans fil comprend un réseau résonant et un circuit onduleur, le réseau résonant comprend un condensateur résonant et une bobine émettrice, une entrée du circuit onduleur est configurée pour être connectée à une alimentation électrique en courant continu, et une sortie du circuit onduleur est configurée pour être connectée au réseau résonant ; et
le procédé comprend :
la réception d'un paramètre de dispositif électronique envoyé par le dispositif électronique (S1601) ;
l'adaptation d'une relation d'écart entre une valeur Q du dispositif de charge sans fil et un espace d'emplacement sur la base d'un paramètre de dispositif de charge sans fil et du paramètre de dispositif électronique (S1602), dans lequel l'espace d'emplacement est un espace d'emplacement entre la bobine émettrice et une bobine réceptrice du dispositif électronique, le paramètre de dispositif électronique comprend une valeur Q1 du dispositif de charge sans fil et une fréquence de résonance f1 du réseau résonant lorsqu'aucun objet étranger n'est présent au niveau d'au moins un emplacement relatif entre la bobine émettrice et la bobine réceptrice, et le paramètre de dispositif de charge sans fil comprend une valeur Q initiale Q0 du dispositif de charge sans fil et une fréquence de résonance initiale f0 du réseau résonant lorsque le dispositif de charge sans fil et le dispositif électronique sont dans un état découplé, dans lequel l'emplacement relatif entre la bobine émettrice et la bobine réceptrice est l'écart d'emplacement entre le centre de la bobine émettrice et le centre de la bobine réceptrice, et la relation d'écart est une correspondance entre la valeur Q et l'emplacement relatif horizontal et l'emplacement relatif vertical entre la bobine émettrice et la bobine réceptrice ; et
la réalisation d'une détection d'objet étranger sur la base de la relation d'écart (S1603),
dans lequel la réalisation d'une détection d'objet étranger sur la base de la relation d'écart comprend :
l'obtention du seuil de valeur Q sur la base de la relation d'écart ;
l'obtention d'une impédance de courant alternatif correspondante sur la base du seuil de valeur Q et d'une correspondance entre la valeur Q et l'impédance de courant alternatif de la bobine émettrice ; et
la réalisation d'une détection d'objet étranger par Ploss sur la base de l'impédance de courant alternatif obtenue dans un processus dans lequel le dispositif de charge sans fil charge le dispositif électronique, et dans lequel soit (a) :
le paramètre de dispositif électronique comprend les valeurs Q1 et f1 suivantes au niveau d'au moins deux emplacements relatifs entre la bobine émettrice et la bobine réceptrice : Q11 et f11 au niveau d'un premier emplacement et Q12 et f12 au niveau d'un second emplacement, et la relation d'écart comprend une relation horizontale radiale entre la bobine émettrice et la bobine réceptrice et une relation verticale entre un plan sur lequel la bobine émettrice est située et un plan sur lequel la bobine réceptrice est située ;
l'adaptation d'une relation d'écart entre une valeur Q du dispositif de charge sans fil et un espace d'emplacement sur la base d'un paramètre de dispositif de charge sans fil et du paramètre de dispositif électronique comprend :
l'adaptation de la relation horizontale entre la valeur Q et l'espace d'emplacement sur la base de Q11, f11, Q12 et f12 ; et l'adaptation de la relation verticale entre la valeur Q et l'espace d'emplacement de l'une quelconque des manières suivantes : en adaptant la relation verticale entre la valeur Q et l'espace d'emplacement sur la base de f0, Q0, Q11 et f11 ; en adaptant la relation verticale entre la valeur Q et l'espace d'emplacement sur la base de f0, Q0, Q12 et f12 ; ou en adaptant la relation verticale entre la valeur Q et l'espace d'emplacement sur la base de Q0, f0, et de Q et f qui correspondent à au moins un point dans la relation horizontale ; et
l'obtention du seuil de valeur Q sur la base de la relation d'écart comprend :
l'obtention du seuil de valeur Q sur la base de la relation horizontale et de la relation verticale, soit dans lequel (b) :
la relation d'écart comprend une relation horizontale radiale entre la bobine émettrice et la bobine réceptrice et une relation verticale entre un plan sur lequel la bobine émettrice est située et un plan sur lequel la bobine réceptrice est située, le paramètre de dispositif électronique comprend en outre un paramètre de couplage pré-enregistré lorsqu'aucun objet étranger n'est présent au niveau de l'au moins un emplacement relatif entre la bobine émettrice et la bobine réceptrice, et le paramètre de couplage pré-enregistré comprend au moins l'un parmi les éléments suivants : un coefficient de couplage et une inductance mutuelle entre la bobine émettrice et la bobine réceptrice ; l'adaptation d'une relation d'écart entre une valeur Q du dispositif de charge sans fil et un espace d'emplacement sur la base d'un paramètre de dispositif de charge sans fil et du paramètre de dispositif électronique comprend :
l'adaptation de la relation verticale entre la valeur Q et l'espace d'emplacement sur la base de f0, Q0 et de la valeur Q et f au niveau de l'au moins un emplacement relatif entre la bobine émettrice et la bobine réceptrice, et l'adaptation de la relation horizontale entre la valeur Q et l'espace d'emplacement sur la base du paramètre de couplage pré-enregistré et de la valeur Q au niveau de l'au moins un emplacement relatif entre la bobine émettrice et la bobine réceptrice ; et
l'obtention du seuil de valeur Q sur la base de la relation d'écart comprend :
l'obtention du seuil de valeur Q sur la base de la relation verticale et de la relation horizontale, soit dans lequel (c) :
le paramètre de dispositif électronique comprend les valeurs Q1 et f1 suivantes au niveau d'au moins deux emplacements relatifs entre la bobine émettrice et la bobine réceptrice : Q11 et f11 au niveau d'un premier emplacement et Q12 et f12 au niveau d'un second emplacement, la relation d'écart comprend une relation horizontale radiale entre la bobine émettrice et la bobine réceptrice et une relation verticale entre un plan sur lequel la bobine émettrice est située et un plan sur lequel la bobine réceptrice est située, le paramètre de dispositif électronique comprend en outre un paramètre de couplage pré-enregistré au niveau du premier emplacement et un paramètre de couplage pré-enregistré au niveau du second emplacement, et le paramètre de couplage pré-enregistré comprend au moins l'un parmi les éléments suivants : un coefficient de couplage et une inductance mutuelle entre la bobine émettrice et la bobine réceptrice ; et
l'adaptation d'une relation d'écart entre une valeur Q du dispositif de charge sans fil et un espace d'emplacement sur la base d'un paramètre de dispositif de charge sans fil et du paramètre de dispositif électronique comprend :
l'adaptation de la relation horizontale entre la valeur Q et l'espace d'emplacement sur la base de Q11, Q12, du paramètre de couplage pré-enregistré au niveau du premier emplacement et du paramètre de couplage pré-enregistré au niveau du second emplacement ; et l'adaptation de la relation verticale entre la valeur Q et l'espace d'emplacement de l'une quelconque des manières suivantes : en adaptant la relation verticale entre la valeur Q et l'espace d'emplacement sur la base de f0, Q0, Q11 et f11 ; en adaptant la relation verticale entre la valeur Q et l'espace d'emplacement sur la base de f0, Q0, Q12 et f12 ; ou en adaptant la relation verticale entre la valeur Q et l'espace d'emplacement sur la base de Q0, f0, et de Q et f qui correspondent à au moins un point dans la relation horizontale ; et
l'obtention du seuil de valeur Q sur la base de la relation d'écart comprend :
l'obtention du seuil de valeur Q sur la base de la relation verticale et de la relation horizontale.
